(19) Europäisches Patentamt
European Patent Office
Office européen des brevets

(11) EP 3 522 242 A1

(12) EUROPEAN PATENT APPLICATION
published in accordance with Art. 153(4) EPC

(43) Date of publication:
07.08.2019 Bulletin 2019/32

(21) Application number: 17855776.5

(22) Date of filing: 15.09.2017

(51) Int Cl.:
*H01L 51/30 (2006.01)* *H01L 29/786 (2006.01)*
*H01L 51/05 (2006.01)*

(86) International application number:
PCT/JP2017/033408

(87) International publication number:
WO 2018/061820 (05.04.2018 Gazette 2018/14)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 29.09.2016 JP 2016191914

(71) Applicant: FUJIFILM Corporation
Tokyo 106-8620 (JP)

(72) Inventors:
- GOTO, Takashi
Ashigarakami-gun
Kanagawa 258-8577 (JP)
- FUKUZAKI, Eiji
Ashigarakami-gun
Kanagawa 258-8577 (JP)
- WATANABE, Tetsuya
Ashigarakami-gun
Kanagawa 258-8577 (JP)

(74) Representative: Hoffmann Eitle
Patent- und Rechtsanwälte PartmbB
Arabellastraße 30
81925 München (DE)

# (54) BOTTOM GATE-TYPE ORGANIC SEMICONDUCTOR TRANSISTOR

(57) An object is to provide a bottom gate type organic semiconductor transistor in which a sufficient carrier mobility is exhibited, a variation in performance between elements is small, and power consumption is also suppressed.

Provided is a bottom gate type organic semiconductor transistor including: a gate insulating layer; and an organic semiconductor layer that is disposed adjacent to the gate insulating layer,
in which a surface free energy of a surface of the gate insulating layer on the organic semiconductor layer side is 20 to 50 mN/m,
an arithmetic average roughness Ra of the surface of the gate insulating layer on the organic semiconductor layer side is 2 nm or lower, and
the organic semiconductor layer includes a compound represented by the following Formula (1) that has a molecular weight of 3000 or lower.

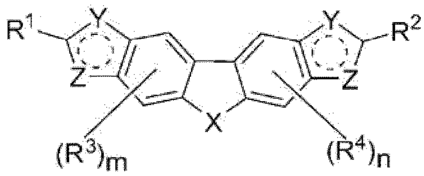

Formula (1)

X, Y, and Z each independently represent a specific ring-constituting atom. $R^1$ and $R^2$ each independently represent a hydrogen atom, an alkyl group, an alkenyl group, an alkynyl group, an aryl group, or a heteroaryl group, and $R^3$ and $R^4$ each independently represent a halogen atom, an alkyl group, an alkenyl group, an alkynyl group, an aryl group, or a heteroaryl group. m and n each independently represent an integer of 0 to 2.

EP 3 522 242 A1

## Description

## BACKGROUND OF THE INVENTION

1. Field of the Invention

The present invention relates to a bottom gate type organic semiconductor transistor.

2. Description of the Related Art

In a display such as a liquid crystal display or an organic electroluminescence display or a logical circuit such as a radio frequency identifier (RFID: RF tag) or a memory, a micro transistor such as a switching element is integrated. An organic semiconductor transistor (field effect transistor) in which a semiconductor layer is formed of an organic semiconductor compound can be reduced in weight, and a printing process can be applied to the manufacturing thereof. Therefore, this organic semiconductor transistor can realize cost reduction and has excellent flexibility. Thus, the organic semiconductor transistor has attracted attention as the next-generation transistor that is an alternative to a transistor including a silicon semiconductor layer, and development thereof has progressed.

In order to improve the performance of the organic semiconductor transistor, the improvement of carrier mobility is an important factor. By increasing the carrier mobility, high-speed switching can be performed with a small electric field, and improvement of processing speed and low power consumption can be realized. In order to realize the improvement of mobility, a chemical structure of an organic semiconductor used for forming an organic semiconductor layer has been investigated. For example, JP2015-195361A and JP2015-195362A describe that a specific aromatic compound that has a fused polycyclic structure including a heteroatom bonded to a ring-constituting atom is used for forming a semiconductor active layer (organic semiconductor layer) of a transistor such that the transistor exhibits excellent carrier mobility.

## SUMMARY OF THE INVENTION

The present inventors prepared an organic semiconductor transistor in which the compound described in each of JP2015-195361A and JP2015-195362A is used for forming an organic semiconductor layer of a transistor, and repeatedly conducted an investigation on the performance of the organic semiconductor transistor. As a result, it has been clarified that the carrier mobility of the obtained organic semiconductor transistor significantly increases as a whole, but the performance is likely to vary between the obtained transistor elements, and has also been clarified that a threshold voltage is high, hysteresis is also large, and power consumption tends to be high. In addition, it has been found that the variation in performance and the high power consumption tend to become more obvious in a bottom gate type transistor in which an organic semiconductor layer is provided on a gate insulating layer.

An object of the present invention is to provide a bottom gate type organic semiconductor transistor including an organic semiconductor layer that is formed using the aromatic compound having the specific structure described in JP2015-195361A or JP2015-195362A, in which a sufficient carrier mobility is exhibited, a variation in performance between elements is small, and power consumption is also suppressed.

The present inventors repeatedly conducted a thorough investigation in consideration of the above-described objects and found that, in a case where an organic semiconductor layer is formed on a gate insulating layer using the aromatic compound having the specific structure represented by JP2015-195361A or JP2015-195362A in the manufacturing of a bottom gate type organic semiconductor transistor, by adjusting a surface free energy of a contact surface between the gate insulating layer and the organic semiconductor layer to be in a specific range and suppressing an average roughness Ra of the contact surface to be at a specific level, a carrier mobility of the obtained bottom gate type organic semiconductor transistor can be sufficiently improved, a variation in performance between elements can be highly suppressed, and a threshold voltage can also be suppressed. The present invention has been completed based on the above findings as a result of repeated investigation.

The object of the present invention is achieved by the following means.

[1] A bottom gate type organic semiconductor transistor comprising:

a gate insulating layer; and
an organic semiconductor layer that is disposed adjacent to the gate insulating layer,
in which a surface free energy of a surface of the gate insulating layer on the organic semiconductor layer side is 20 to 50 mN/m,
an average roughness Ra of the surface of the gate insulating layer on the organic semiconductor layer side is

2 nm or lower, and
the organic semiconductor layer includes a compound represented by the following Formula (1) that has a molecular weight of 3000 or lower,

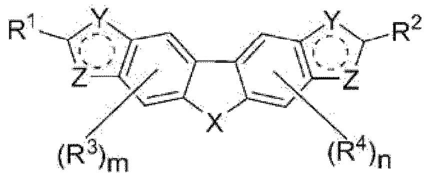

Formula (1)

in Formula (1),

X represents an oxygen atom, a sulfur atom, a selenium atom, a tellurium atom, or $NR^5$,
Y and Z each independently represent $CR^6$, an oxygen atom, a sulfur atom, a selenium atom, a nitrogen atom, or $NR^7$,
a 5-membered ring including Y and Z is an aromatic heterocycle,
$R^1$ and $R^2$ in Formula (1) are bonded to a ring-constituting atom of the 5-membered ring including Y and Z directly or indirectly through a divalent group A,
$R^3$ and $R^4$ in Formula (1) are bonded to a ring-constituting atom of a benzene ring directly or indirectly through the divalent group A,
the divalent group A is a group selected from -O-, -S-, $-NR^8-$, -CO-, -SO-, or $-SO_2-$ or is a group in which two or more selected from -O-, -S-, $-NR^8-$, -CO-, -SO-, or $-SO_2-$ are linked to each other,
$R^1$, $R^2$, $R^5$, $R^6$, $R^7$, and $R^8$ each independently represent a hydrogen atom, an alkyl group, an alkenyl group, an alkynyl group, an aryl group, or a heteroaryl group,
$R^3$ and $R^4$ each independently represent a halogen atom, an alkyl group, an alkenyl group, an alkynyl group, an aryl group, or a heteroaryl group,
m and n each independently represent an integer of 0 to 2, and
a configuration in which X represents an oxygen atom or a sulfur atom and the 5-membered ring including Y and Z is an imidazole ring and a configuration in which X represents a sulfur atom, Y represents CH, Z represents a sulfur atom, both $R^1$ and $R^2$ represent a hydrogen atom, and both m and n represent 0 are excluded from the compound represented by Formula (1).

[2] The bottom gate type organic semiconductor transistor according to [1],
in which the 5-membered ring including Y and Z is a ring selected from a thiophene ring, a furan ring, a selenophene ring, a pyrrole ring, a thiazole ring, or an oxazole ring.
[3] The bottom gate type organic semiconductor transistor according to [1] or [2],
in which the number of carbon atoms in each of $R^1$, $R^2$, $R^3$, and $R^4$ is 30 or less.
[4] The bottom gate type organic semiconductor transistor according to any one of [1] to [3],
in which $R^1$ and $R^2$ each independently represent an alkyl group having 20 or less carbon atoms, an aryl group having 20 or less carbon atoms, or a heteroaryl group having 20 or less carbon atoms.
[5] The bottom gate type organic semiconductor transistor according to any one of [1] to [4],
in which $R^1$ and $R^2$ are the same as each other,
$R^3$ and $R^4$ are the same as each other, and
m and n are the same as each other.
[6] The bottom gate type organic semiconductor transistor according to any one of [1] to [5],
in which both m and n represent 0.
[7] The bottom gate type organic semiconductor transistor according to [1],
in which the compound represented by the following Formula (1) that has a molecular weight of 3000 or lower is represented by the following Formula (2) or (3),

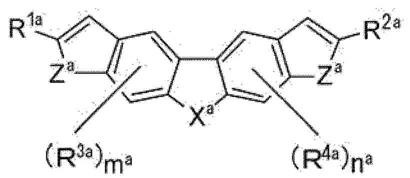

Formula (2)

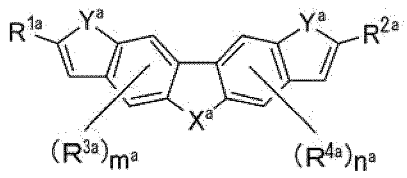

Formula (3)

in Formulae (2) and (3),

$X^a$ represents an oxygen atom, a sulfur atom, or a selenium atom,
$Y^a$ and $Z^a$ each independently represent an oxygen atom, a sulfur atom, a selenium atom, or $NR^{7a}$,
$R^{7a}$ has the same definition as $R^7$ in Formula (1),
$R^{1a}$, $R^{2a}$, $R^{3a}$, $R^{4a}$, $m^a$, and $n^a$ have the same definitions as $R^1$, $R^2$, $R^3$, $R^4$, m, and n in Formula (1), respectively,
binding forms of $R^{1a}$, $R^{2a}$, $R^{3a}$, and $R^{4a}$ to a ring-constituting atom are also the same as binding forms of $R^1$, $R^2$, $R^3$, and $R^4$ in Formula (1) to a ring-constituting atom, respectively, and
a configuration in which $X^a$ represents a sulfur atom, $Z^a$ represents a sulfur atom, both $R^{1a}$ and $R^{2a}$ represent a hydrogen atom, and both $m^a$ and $n^a$ represent 0 is excluded from the compound represented by Formula (2).

[8] The bottom gate type organic semiconductor transistor according to [7],
in which the number of carbon atoms in each of $R^{1a}$, $R^{2a}$, $R^{3a}$, and $R^{4a}$ is 30 or less.
[9] The bottom gate type organic semiconductor transistor according to [7] or [8],
in which $R^{1a}$ and $R^{2a}$ each independently represent an alkyl group having 20 or less carbon atoms, an aryl group having 20 or less carbon atoms, or a heteroaryl group having 20 or less carbon atoms.
[10] The bottom gate type organic semiconductor transistor according to any one of [7] to [9],
in which $R^{1a}$ and $R^{2a}$ are the same as each other,
$R^{3a}$ and $R^{4a}$ are the same as each other, and
$m^a$ and $n^a$ are the same as each other.
[11] The bottom gate type organic semiconductor transistor according to [7],
in which the compound represented by Formula (2) that has a molecular weight of 3000 or lower is represented by the following Formula (4), and
the compound represented by Formula (3) that has a molecular weight of 3000 or lower is represented by the following Formula (5),

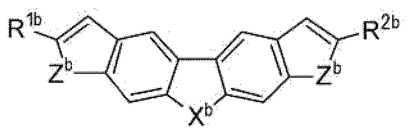

Formula (4)

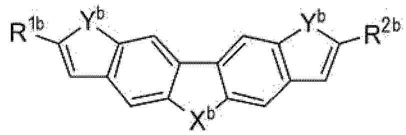

Formula (5)

in Formulae (4) and (5),

$X^b$, $Y^b$, and $Z^b$ each independently represent an oxygen atom, a sulfur atom, or a selenium atom,
$R^{1b}$ and $R^{2b}$ have the same definitions as $R^{1a}$ and $R^{2a}$ in Formula (2), respectively,
binding forms of $R^{1b}$ and $R^{2b}$ to a ring-constituting atom are also the same as binding forms of $R^{1a}$ and $R^{2a}$ in Formula (2) to a ring-constituting atom, respectively, and
a configuration in which $X^b$ represents a sulfur atom, $Z^b$ represents a sulfur atom, and both $R^{1b}$ and $R^{2b}$ represent a hydrogen atom is excluded from the compound represented by Formula (4).

[12] The bottom gate type organic semiconductor transistor according to [11],
in which the number of carbon atoms in each of $R^{1b}$ and $R^{2b}$ is 30 or less.
[13] The bottom gate type organic semiconductor transistor according to [11] or [12],

in which $R^{1b}$ and $R^{2b}$ each independently represent an alkyl group having 20 or less carbon atoms, an aryl group having 20 or less carbon atoms, or a heteroaryl group having 20 or less carbon atoms.

[14] The bottom gate type organic semiconductor transistor according to any one of [11] to [13],
in which $R^{1b}$ and $R^{2b}$ have an aliphatic hydrocarbon group.

[15] The bottom gate type organic semiconductor transistor according to [14],
in which $R^{1b}$ and $R^{2b}$ each independently represent an aryl group having a linear aliphatic hydrocarbon group or a heteroaryl group having a linear aliphatic hydrocarbon group.

[16] The bottom gate type organic semiconductor transistor according to any one of [1] to [15],
in which the gate insulating layer includes an organic component.

[17] The bottom gate type organic semiconductor transistor according to any one of [1] to [16],
in which an elution amount of an organic component having a molecular weight of 1000 or lower in the gate insulating layer is lower than 10 ppm.

In the bottom gate type organic semiconductor transistor according to the present invention, a sufficient carrier mobility is exhibited, a variation in performance between transistor elements is small, a threshold voltage is low, and power consumption is low.

The above-described and other characteristics and advantageous effects of the present invention will be clarified from the following description appropriately with reference to the accompanying drawings.

## BRIEF DESCRIPTION OF THE DRAWINGS

Fig. 1 is a schematic cross-sectional view showing one aspect of a bottom gate-bottom contact type organic semiconductor transistor as an example of an organic semiconductor transistor according to the present invention.

Fig. 2 is a schematic cross-sectional view showing one aspect of a bottom gate-top contact type organic semiconductor transistor as an example of the organic semiconductor transistor according to the present invention.

Fig. 3 is a schematic cross-sectional view showing another aspect of the bottom gate-top contact type organic semiconductor transistor as an example of the organic semiconductor transistor according to the present invention.

Fig. 4 is a schematic cross-sectional view showing another aspect of the bottom gate-bottom contact type organic semiconductor transistor as an example of the organic semiconductor transistor according to the present invention.

## DESCRIPTION OF THE PREFERRED EMBODIMENTS

In this specification, numerical ranges represented by "to" include numerical values before and after "to" as lower limit values and upper limit values.

The meaning of compounds described in this specification includes not only the compounds themselves but also salts and ions thereof. In addition, within a range where a desired effect does not deteriorate, a part of the structure may be changed.

In addition, in a case where it is not clearly described that a compound is substituted or unsubstituted, this compound has any substituent within a range where a desired effect does not deteriorate. The same shall be applied to a substituent, a linking group, a ring structure, or the like (hereinafter, referred to as "substituent or the like").

In this specification, in a case where a plurality of substituents or the like represented by a specific reference numeral are present or a plurality of substituents or the like are simultaneously defined, the respective substituents or the like may be the same as or different from each other unless specified otherwise. The same shall be applied to definition of the number of substituents or the like. In addition, in a case where a plurality of substituents or the like are close to (in particular, adjacent to) each other, the substituents or the like may be linked to each other to form a ring unless specified otherwise.

In addition, in a case where the number of carbon atoms in a group is described, the number of carbon atoms in this group represents the total number of carbon atoms including substituents unless specified otherwise.

In the present invention, in a case where a group can form an acyclic skeleton and a cyclic skeleton, this group includes a group having an acyclic skeleton and a group having a cyclic skeleton unless specified otherwise. For example, an alkyl group includes a linear alkyl group, a branched alkyl group, and a cycloalkyl group. In a case where a group can form a cyclic skeleton, the lower limit of the number of atoms of the group forming a cyclic skeleton is not limited to the lower limit of the number of atoms specifically described regarding this group, and is 3 or more and preferably 5 or more.

In this specification, "ppm" represents "mass ppm".

Hereinafter, a preferred embodiment of the present invention will be described.

[Organic Semiconductor Transistor]

An organic semiconductor transistor according to the embodiment of the present invention is a bottom gate type and has a configuration in which an organic semiconductor layer is laminated on a gate insulating layer as described below. A surface free energy surface of a surface (hereinafter, also referred to as "surface Os") of the gate insulating layer positioned on the organic semiconductor layer side is 20 to 50 mN/m. In addition, an average roughness Ra of the surface Os is 2 nm or lower.

In the organic semiconductor transistor according to the embodiment of the present invention, the organic semiconductor layer includes a compound represented by the following Formula (1) that has a molecular weight of 3000 or lower.

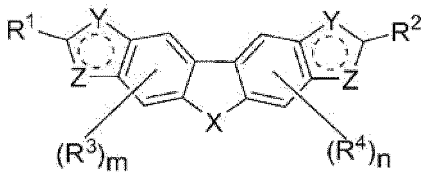

Formula (1)

In Formula (1), X represents an oxygen atom, a sulfur atom, a selenium atom, a tellurium atom, or $NR^5$. From the viewpoint of carrier mobility during application to an organic semiconductor layer of a transistor, it is preferable that X represents an oxygen atom, a sulfur atom, or a selenium atom. The details of $R^5$ will be described below.

Y and Z each independently represent $CR^6$, an oxygen atom, a sulfur atom, a selenium atom, a nitrogen atom, or $NR^7$, and a 5-membered ring including Y and Z is an aromatic heterocycle, The details of $R^6$ and $R^7$ will be described below.

Y represents preferably $CR^6$, an oxygen atom, or a sulfur atom and more preferably $CR^6$ or a sulfur atom. In addition, Z represents preferably $CR^6$, an oxygen atom, a sulfur atom, or $NR^7$, more preferably $CR^6$, an oxygen atom, or a sulfur atom, and still more preferably $CR^6$ or a sulfur atom.

In a case where Y represents $CR^6$, Z represents preferably an oxygen atom, a sulfur atom, a selenium atom, or $NR^7$, more preferably an oxygen atom, a sulfur atom, or a selenium atom, still more preferably an oxygen atom or a sulfur atom, and still more preferably a sulfur atom.

In addition, in a case where Y represents an oxygen atom, Z represents preferably $CR^6$, an oxygen atom, or a sulfur atom, more preferably $CR^6$, or a sulfur atom, and still more preferably $CR^6$.

In a case where Y represents a sulfur atom, Z represents preferably $CR^6$, an oxygen atom, a sulfur atom, or a nitrogen atom, more preferably $CR^6$ or a nitrogen atom, and still more preferably $CR^6$.

In a case where Z represents $CR^6$, Y represents preferably an oxygen atom, a sulfur atom, a selenium atom, or $NR^7$, and more preferably an oxygen atom, a sulfur atom, or a selenium atom.

In Formula (1), the aromatic heterocycle in the 5-membered ring including Y and Z is preferably a ring selected from a thiophene ring, a furan ring, a selenophene ring, a pyrrole ring, a thiazole ring, or an oxazole ring, more preferably a thiophene ring, a furan ring, a selenophene ring, or a pyrrole ring, and still more preferably a thiophene ring or a selenophene ring.

In Formula (1), $R^1$ and $R^2$ each independently represent a hydrogen atom, an alkyl group, an alkenyl group, an alkynyl group, an aryl group, or a heteroaryl group. $R^1$ and $R^2$ each independently represent preferably an alkyl group, an alkenyl group, an alkynyl group, an aryl group, or a heteroaryl group, and more preferably an alkyl group, an aryl group, or a heteroaryl group.

The number of carbon atoms in the alkyl group which may be used as $R^1$ and $R^2$ is preferably 30 or less and more preferably 20 or less. More specifically, the number of carbon atoms in the alkyl group which may be used as $R^1$ and $R^2$ is preferably 1 to 30, more preferably 1 to 20, still more preferably 1 to 15, and still more preferably 3 to 11. By adjusting the number of carbon atoms in the alkyl group to be in the preferable range, the linearity of molecules can be improved, and the carrier mobility can be further improved during application to an organic semiconductor layer of a transistor.

The alkyl group which may be used as $R^1$ and $R^2$ may be linear, branched, or cyclic. From the viewpoint of carrier mobility, a linear alkyl group is preferable.

In a case where $R^1$ or $R^2$ represents an alkyl group having a substituent, the substituent in the alkyl group is not particularly limited, and examples thereof include: a halogen atom (for example, a fluorine atom, a chlorine atom, a bromine atom, or an iodine atom); a cycloalkyl group (a cycloalkyl group preferably having 3 to 20 carbon atoms and more preferably 4 to 15 carbon atoms; the cycloalkyl group is preferably a 5-membered ring or a 6-membered ring); an aryl group (an aryl group having preferably 6 to 20 carbon atoms, more preferably 6 to 18 carbon atoms, and still more

preferably 6 to 15 carbon atoms; for example, a phenyl group, a naphthyl group, a p-pentylphenyl group, a 3,4-dipentylphenyl group, a p-heptoxyphenyl group, or a 3,4-diheptoxyphenyl group); a heterocyclic group (preferably a 3 to 8-membered ring and more preferably a 5- or 6-membered ring; it is preferable that as a ring-constituting atom, an oxygen atom, a sulfur atom, and/or a nitrogen atom is included; for example, a 2-hexylfuranyl group); a cyano group; a hydroxy group; a nitro group; an acyl group (an acyl group having preferably from 2 to 20 carbon atoms, more preferably from 2 to 15 carbon atoms, and still more preferably from 2 to 10 carbon atoms; for example, a hexanoyl group or a benzoyl group); an alkoxy group (an alkoxy group having preferably 1 to 20 carbon atoms, more preferably 1 to 15 carbon atoms, and still more preferably 1 to 10 carbon atoms; for example, a butoxy group); an aryloxy group (an aryloxy group having preferably 6 to 20 carbon atoms, more preferably 6 to 18 carbon atoms, and still more preferably 6 to 15 carbon atoms); a silyloxy group (a silyloxy group having preferably 0 to 18 carbon atoms, more preferably 0 to 15 carbon atoms, and still more preferably 0 to 12 carbon atoms); a heterocyclic oxy group (a heterocyclic oxy group including preferably 3 to 8 rings and more preferably 5 or 6 rings); an acyloxy group (an acyloxy group having preferably 2 to 20 carbon atoms, more preferably 2 to 15 carbon atoms, and still more preferably 2 to 10 carbon atoms); a carbamoyloxy group (a carbamoyloxy group having preferably 1 to 20 carbon atoms, more preferably 1 to 15 carbon atoms, and still more preferably 1 to 10 carbon atoms); an amino group (an amino group having preferably 0 to 20 carbon atoms, more preferably 0 to 15 carbon atoms, and still more preferably 0 to 10 carbon atoms and including an anilino group); an acylamino group (an acylamino group having preferably 2 to 20 carbon atoms, more preferably 2 to 15 carbon atoms, and still more preferably 2 to 10 carbon atoms); an aminocarbonylamino group (an aminocarbonylamino group having preferably 1 to 20 carbon atoms, more preferably 1 to 15 carbon atoms, and still more preferably 1 to 10 carbon atoms); an alkoxycarbonylamino group (an alkoxycarbonylamino group having preferably 2 to 20 carbon atoms, more preferably 2 to 15 carbon atoms, and still more preferably 2 to 10 carbon atoms); an aryloxycarbonylamino group (an aryloxycarbonylamino group having preferably 7 to 20 carbon atoms, more preferably 7 to 18 carbon atoms, and still more preferably 7 to 15 carbon atoms); an alkylsulfonylamino group (an alkylsulfonylamino group having preferably 1 to 20 carbon atoms, more preferably 1 to 15 carbon atoms, and still more preferably 1 to 10 carbon atoms); an arylsulfonylamino group (an arylsulfonylamino group having preferably 6 to 20 carbon atoms, more preferably 6 to 18 carbon atoms, and still more preferably 6 to 15 carbon atoms); a mercapto group; an alkylthio group (an alkylthio group having preferably 1 to 20 carbon atoms, more preferably from 1 to 15 carbon atoms, and still more preferably from 1 to 10 carbon atoms; for example, a methylthio group or an octylthio group); an arylthio group (an arylthio group having preferably 6 to 20 carbon atoms, more preferably 6 to 18 carbon atoms, and still more preferably 6 to 15 carbon atoms); a heterocyclic thio group (a heterocyclic thio group including preferably 3 to 8 rings and more preferably 5 or 6 rings); a sulfamoyl group (a sulfamoyl group having preferably 0 to 20 carbon atoms, more preferably 0 to 15 carbon atoms, and still more preferably 0 to 10 carbon atoms); a sulfo group; an alkylsulfinyl group (an alkylsulfinyl group having preferably 1 to 20 carbon atoms, more preferably 1 to 15 carbon atoms, and still more preferably 1 to 10 carbon atoms); an arylsulfinyl group (an arylsulfinyl group having preferably 6 to 20 carbon atoms, more preferably 6 to 18 carbon atoms, and still more preferably 6 to 15 carbon atoms); an alkylsulfonyl group (an alkylsulfonyl group having preferably 1 to 20 carbon atoms, more preferably 1 to 15 carbon atoms, and still more preferably 1 to 10 carbon atoms); an arylsulfonyl group (an arylsulfonyl group having preferably 6 to 20 carbon atoms, more preferably 6 to 18 carbon atoms, and still more preferably 6 to 15 carbon atoms); an alkyloxycarbonyl group (an alkyloxycarbonyl group having preferably 2 to 20 carbon atoms, more preferably 2 to 15 carbon atoms, and still more preferably 2 to 10 carbon atoms); an aryloxycarbonyl group (an aryloxycarbonyl group having preferably 7 to 20 carbon atoms, more preferably 7 to 18 carbon atoms, and still more preferably 7 to 15 carbon atoms); a carbamoyl group (a carbamoyl group having preferably 1 to 20 carbon atoms, more preferably 1 to 15 carbon atoms, and still more preferably 1 to 10 carbon atoms); an aryl azo group (an aryl azo group having preferably 6 to 20 carbon atoms, more preferably 6 to 18 carbon atoms, and still more preferably 6 to 15 carbon atoms); a heterocyclic azo group (a heterocyclic azo group including preferably 3 to 8 rings and more preferably 5 or 6 rings); a phosphino group; a phosphinyl group; a phosphinyloxy group; a phosphinylamino group; a phosphono group; a silyl group (a silyl group having preferably 0 to 18 carbon atoms, more preferably 0 to 15 carbon atoms, and still more preferably 0 to 12 carbon atoms; for example, a di-trimethylsiloxy methyl butoxy group); a hydrazino group; a ureido group; a boronic acid group ($-B(OH)_2$); a phosphate group ($-OPO(OH)_2$); a sulfate group ($-OSO_3H$); and other well-known substituents. In addition, in a case where the alkyl group which may be used as $R^1$ and $R^2$ is a cycloalkyl group, this cycloalkyl group may include, as a substituent, an alkyl group, an alkenyl group, or an alkynyl group which may be included in the aryl group used as $R^1$ and $R^2$.

In particular, it is preferable that $R^1$ or $R^2$ represents an unsubstituted alkyl group.

The number of carbon atoms in the alkenyl group which may be used as $R^1$ and $R^2$ is preferably 30 or less and more preferably 20 or less. More specifically, the number of carbon atoms in the alkenyl group which may be used as $R^1$ and $R^2$ is preferably 2 to 30, more preferably 2 to 20, still more preferably 2 to 15, still more preferably 2 to 10, and still more preferably 2 to 4.

A substituent which may be included in the alkenyl group is not particularly limited. For example, the alkenyl group which may be used as $R^1$ and $R^2$ may have the substituent which may be included in the alkyl group used as $R^1$

and $R^2$.

The number of carbon atoms in the alkynyl group which may be used as $R^1$ and $R^2$ is preferably 30 or less and more preferably 20 or less. More specifically, the number of carbon atoms in the alkenyl group which may be used as $R^1$ and $R^2$ is preferably 2 to 30, more preferably 2 to 20, still more preferably 2 to 15, still more preferably 2 to 10, still more preferably 2 to 4, and still more preferably 2.

A substituent which may be included in the alkynyl group is not particularly limited. For example, the alkynyl group which may be used as $R^1$ and $R^2$ may have the substituent which may be included in the alkyl group used as $R^1$ and $R^2$. In particular, as the substituent which may be included in the alkynyl group, a group selected from a silyl group or an aryl group is preferable, a group selected from a trialkylsilyl group or a phenyl group is more preferable, and a trialkylsilyl group is still more preferable.

The number of carbon atoms in the aryl group which may be used as $R^1$ and $R^2$ is preferably 30 or less and more preferably 20 or less. More specifically, the number of carbon atoms in the aryl group which may be used as $R^1$ and $R^2$ is preferably 6 to 30, more preferably 6 to 20, still more preferably 6 to 18, and still more preferably 6 to 12.

A substituent which may be included in the aryl group is not particularly limited. For example, the aryl group which may be used as $R^1$ and $R^2$ may have the substituent which may be included in the alkyl group used as $R^1$ and $R^2$. In addition, the substituent which may be included in the aryl group used as $R^1$ and $R^2$ is preferably an alkyl group (a linear, branched, or cyclic alkyl group having preferably 1 to 20 carbon atoms, more preferably 1 to 15 carbon atoms, and still more preferably 1 to 10 carbon atoms), and may be an alkenyl group (a linear or branched alkenyl group having preferably 2 to 20 carbon atoms, more preferably 2 to 15 carbon atoms, and still more preferably 2 to 10 carbon atoms) or an alkynyl group (a linear or branched alkynyl group having preferably 2 to 20 carbon atoms, more preferably 2 to 15 carbon atoms, and still more preferably 2 to 10 carbon atoms).

In a case where the aryl group which may be used as $R^1$ and $R^2$ has a substituent, the number of substituents in the aryl group is preferably 1 to 3, more preferably 1 or 2, and still more preferably 1.

The number of carbon atoms in the heteroaryl group which may be used as $R^1$ and $R^2$ is preferably 30 or less and more preferably 20 or less. More specifically, the number of carbon atoms in the heteroaryl group which may be used as $R^1$ and $R^2$ is preferably 3 to 30, more preferably 4 to 20, still more preferably 4 to 10, and still more preferably 4. As a ring-constituting heteroatom in the heteroaryl group, a ring at least one kind of atoms selected from the group consisting of a sulfur atom, a nitrogen atom, a selenium atom, an oxygen atom, and a tellurium atom is preferable. In addition, this heteroaryl group is preferably a 3- to 8-membered ring and more preferably 5-or 6-membered ring.

Specific preferable examples of the heteroaryl group which may be used as $R^1$ and $R^2$ include a furanyl group, a pyrrolyl group, a pyrazolyl group, an imidazolyl group, a thienyl group, a thiazolyl group, a thienothienyl group, a benzothienyl group, a thienophenyl group, a pyridyl group, a pyrimidinyl group, a pyridazinyl group, and a pyrazinyl group. In particular, a thienyl group or a furyl group is more preferable, and a thienyl group is still more preferable.

A substituent which may be included in the heteroaryl group is not particularly limited. For example, the heteroaryl group may have the substituent which may be included in the aryl group used as $R^1$ and $R^2$. In a case where the heteroaryl group which may be used as $R^1$ and $R^2$ has a substituent, it is preferable that this substituent is an alkyl group.

From the viewpoint of further improving carrier mobility during application to an organic semiconductor layer of a transistor, it is preferable that the structure of $R^1$ and $R^2$ has an aliphatic hydrocarbon group. In particular, it is preferable that $R^1$ and $R^2$ each independently represent an aryl group or a heteroaryl group and the aryl group or the heteroaryl group has an aliphatic hydrocarbon group as a substituent.

In the present invention, "aliphatic hydrocarbon group" refers to a linear, branched, or cyclic nonaromatic hydrocarbon group, and examples thereof include an alkyl group, an alkenyl group, and an alkynyl group. Among these, an alkyl group is preferable.

In Formula (1), $R^1$ and $R^2$ in Formula (1) are bonded to a ring-constituting atom of the 5-membered ring including Y and Z directly or indirectly through a divalent group A. That is, the configuration of Formula (1) defined in the present invention also includes a configuration in which $R^1$ and/or $R^2$ is bonded to a ring-constituting atom of the 5-membered ring including Y and Z through the divalent group A. The divalent group A is a group selected from -O-, -S-, $-NR^8-$, -CO-, -SO-, or $-SO_2-$ or is a group in which two or more selected from -O-, -S-, $-NR^8-$, -CO-, -SO-, and $-SO_2-$ are linked to each other. In a case where the divalent group A is a group in which two or more selected from -O-, -S-, $-NR^8-$, -CO-, -SO-, or $-SO_2-$ are linked to each other, the number of the two or more groups linked to each other is preferably 2 to 4 and more preferably 2 or 3.

In particular, the divalent group A is preferably a group selected from -O-, -S-, $-NR^8-$, -CO-, -SO-, or $-SO_2-$, more preferably -O-, -S-, or -CO-, and still more preferably -O-.

It is preferable that $R^1$ and $R^2$ have the same structure in a case where the divalent group A is also taken into consideration.

In Formula (1), $R^3$ and $R^4$ each independently represent a halogen atom, an alkyl group, an alkenyl group, an alkynyl group, an aryl group, or a heteroaryl group. The halogen atom which may be used as $R^3$ and $R^4$ is preferably a fluorine atom, a chlorine atom, a bromine atom, or an iodine atom and more preferably a fluorine atom or a chlorine atom.

The alkyl group, the alkenyl group, the alkynyl group, the aryl group, and the heteroaryl group which may be used as $R^3$ and $R^4$ have the same preferable configurations as the alkyl group, the alkenyl group, the alkynyl group, the aryl group, and the heteroaryl group which may be used as $R^1$.

In addition, $R^3$ and $R^4$ are bonded to a ring-constituting atom of a benzene ring in Formula (1) directly or indirectly through the divalent group A, That is, the configuration of Formula (1) defined in the present invention also includes a configuration in which $R^3$ and/or $R^4$ is bonded to a ring-constituting atom of the benzene ring through the divalent group A.

It is preferable that $R^3$ and $R^4$ have the same structure in a case where the divalent group A is also taken into consideration.

m and n representing the numbers of $R^3$ and $R^4$ each independently represent an integer of 0 to 2. m and n each independently represent preferably 0 or 1 and more preferably 0. It is preferable that m and n have the same value.

In Formula (1), $R^5$ in $NR^5$ which may be used as X, $R^6$ in $CR^6$ and $R^7$ in $NR^7$ which may be used as Y and Z, and $R^8$ in $NR^8$ which may be used as the divalent group A each independently represent a hydrogen atom, an alkyl group, an alkenyl group, an alkynyl group, an aryl group, or a heteroaryl group. Examples of preferable configurations of the alkyl group, the alkenyl group, the alkynyl group, the aryl group, and the heteroaryl group which may be used as $R^5$, $R^6$, $R^7$, and $R^8$ include the preferable configurations of the alkyl group, the alkenyl group, the alkynyl group, the aryl group, and the heteroaryl group which may be used as $R^1$.

In particular, $R^5$ represents preferably an alkyl group having 1 to 11 carbon atoms and more preferably an alkyl group having 1 to 5 carbon atoms. In addition, $R^6$ represents preferably a hydrogen atom or an alkyl group and more preferably a hydrogen atom. In addition, $R^7$ represents preferably an alkyl group or an aryl group and more preferably an alkyl group. In addition, $R^8$ represents preferably an alkyl group or an aryl group.

From the viewpoint of improving molecular symmetry to further improve carrier mobility, in Formula (1), it is preferable that $R^1$ and $R^2$ are the same, $R^3$ and $R^4$ are the same, and m and n are the same.

In the present invention, the compound represented by Formula (1) does not include a configuration in which X represents an oxygen atom or a sulfur atom and the 5-membered ring including Y and Z is an imidazole ring (including a configuration in which a ring-constituting atom of the imidazole ring has a substituent). In addition, in the present invention, the compound represented by Formula (1) does not also include a configuration in which X represents a sulfur atom, Y represents CH, Z represents a sulfur atom, both $R^1$ and $R^2$ represent a hydrogen atom, and both m and n represent 0. A compound excluded from Formula (1) has a mother nucleus (fused polycyclic structure) having a specific structure in Formula (1) and has high crystallinity. However, even in a case where the compound excluded from Formula (1) is applied to an organic semiconductor layer of a transistor, it is difficult to obtain a desired carrier mobility, and a variation in performance between elements is likely to occur.

It is preferable that the compound represented by Formula (1) that has a molecular weight of 3000 or lower is a compound represented by the following Formula (2) or (3).

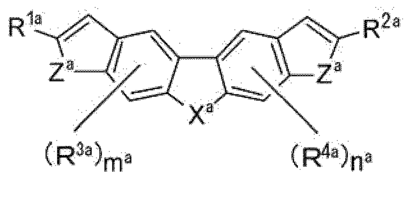

Formula (2)

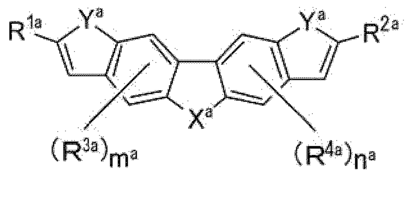

Formula (3)

In Formulae (2) and (3), $X^a$ represents an oxygen atom, a sulfur atom, or a selenium atom.

$Y^a$ and $Z^a$ each independently represent an oxygen atom, a sulfur atom, a selenium atom, or $NR^{7a}$. $R^{7a}$ has the same definition as $R^7$ in Formula (1).

$R^{1a}$, $R^{2a}$, $R^{3a}$, $R^{4a}$, $m^a$, and $n^a$ have the same definitions and the same preferable configurations as $R^1$, $R^2$, $R^3$, $R^4$, m, and n in Formula (1), respectively.

In addition, binding forms of $R^{1a}$, $R^{2a}$, $R^{3a}$, and $R^{4a}$ to a ring-constituting atom are also the same as binding forms of $R^1$, $R^2$, $R^3$, and $R^4$ in Formula (1) to a ring-constituting atom, and preferable binding forms thereof are also the same. That is, $R^{1a}$, $R^{2a}$, $R^{3a}$, and $R^{4a}$ may be bonded to a ring-constituting atom directly or indirectly through the divalent group A. In the present invention, the configuration in which $R^{1a}$, $R^{2a}$, $R^{3a}$, and/or $R^{4a}$ is bonded to a ring-constituting atom through the divalent group A is also included in the structure of Formula (2) or (3).

In this case, a configuration in which, in Formula (2), $X^a$ represents a sulfur atom, $Z^a$ represents a sulfur atom,

both $R^{1a}$ and $R^{2a}$ represent a hydrogen atom, and both $m^a$ and $n^a$ represent 0 is excluded from the compound represented by Formula (2).

In addition, it is more preferable that the compound represented by the formula (2) that has a molecular weight of 3000 or lower is represented by the following Formula (4). In addition, it is more preferable that the compound represented by the formula (3) that has a molecular weight of 3000 or lower is represented by the following Formula (5).

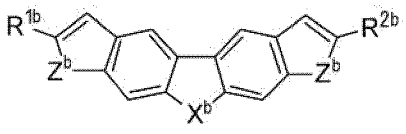

Formula (4)

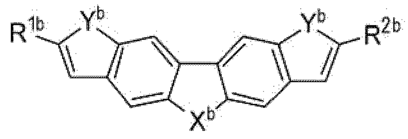

Formula (5)

In Formulae (4) and (5), $X^b$, $Y^b$, and $Z^b$ represent an oxygen atom, a sulfur atom, or a selenium atom.
$R^{1b}$ and $R^{2b}$ have the same definitions and the same preferable configurations as $R^{1a}$ and $R^{2a}$ in Formula (2), respectively. Binding forms of $R^{1b}$ and $R^{2b}$ to a ring-constituting atom are also the same as binding forms of $R^{1a}$ and $R^{2a}$ in Formula (2) to a ring-constituting atom, respectively, and preferable binding forms thereof are also the same. That is, $R^{1b}$ and $R^{2b}$ may be bonded to a ring-constituting atom directly or indirectly through the divalent group A. In the present invention, the configuration in which $R^{1b}$ and/or $R^{2b}$ is bonded to a ring-constituting atom through the divalent group A is also included in the structure of Formula (4) or (5).

A configuration in which $X^b$ represents a sulfur atom, $Z^b$ represents a sulfur atom, and both $R^{1b}$ and $R^{2b}$ represent a hydrogen atom is excluded from the compound represented by Formula (4).

In Formulae (4) and (5), it is preferable that $R^{1b}$ and $R^{2b}$ have an aliphatic hydrocarbon group. It is preferable that the aliphatic hydrocarbon group is a linear aliphatic hydrocarbon group. It is preferable that $R^{1b}$ and $R^{2b}$ represent an aryl group having a linear aliphatic hydrocarbon group or a heteroaryl group having a linear aliphatic hydrocarbon group.

The compound represented by Formula (1) that has a molecular weight of 3000 or lower can be synthesized using a typical method. The synthesis of the compound can be found in, for example, Examples of JP2015-195362A.

Specific examples of the compound represented by Formula (1) that has a molecular weight of 3000 or lower will be shown below and in Examples, but the present invention is not limited thereto.

Examples of the compound represented by Formula (1) that has a molecular weight of 3000 or lower include specific examples 1 to 458 shown in paragraphs "0053" to "0075" and specific examples 535 to 686 shown in paragraphs "0079" to "0087" of JP2015-195362A.

In addition, examples shown in tables below as the compound represented by Formula (1) that has a molecular weight of 3000 or lower can also be used. In the tables below, in a case where $R^1$ and $R^2$ are bonded to a ring-constituting atom through the divalent group A, the columns of $R^1$ and $R^2$ show structures including the divalent group A. In tables below, iPr represents isopropyl, and Bu represents butyl.

[Table 1]

| Specific Example | X | Y | Z | m | n | $R^1$ | $R^2$ | $R^3$ | $R^4$ |
|---|---|---|---|---|---|---|---|---|---|
| 1 | O | CH | Se | 0 | 0 | $CH_3$ | $CH_3$ | - | - |
| 2 | O | CH | Se | 0 | 0 | n-$C_{14}H_{29}$ | n-$C_{14}H_{29}$ | - | - |
| 3 | O | CH | Se | 0 | 0 | 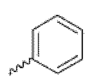 | 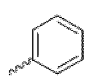 | - | - |
| 4 | O | CH | Se | 0 | 0 | 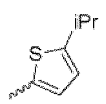 | 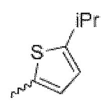 | - | - |
| 5 | O | CH | Se | 1 | 1 | $CH_3$ | $CH_3$ | $CH_3$ | $CH_3$ |
| 6 | O | C(n-$C_8H_{17}$) | Se | 0 | 0 | H | H | - | - |

(continued)

| Specific Example | X | Y | Z | m | n | $R^1$ | $R^2$ | $R^3$ | $R^4$ |
|---|---|---|---|---|---|---|---|---|---|
| 7 | O | $C(n\text{-}C_6H_{13})$ | Se | 0 | 0 | $CH_3$ | $CH_3$ | - | - |
| 8 | O | CH | Se | 1 | 1 | 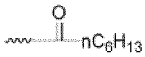 | $N(C_4H_9)_2$ | $OCH_3$ | $OCH_3$ |
| 9 | O | CH | Se | 0 | 0 | 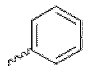 | $n\text{-}C_5H_{11}$ | - | - |
| 10 | O | CH | Se | 2 | 2 | $CH_3$ | $CH_3$ | $CH_3$ | $CH_3$ |

[Table 2]

| Specific Example | X | Y | Z | m | n | $R^1$ | $R^2$ | $R^3$ | $R^4$ |
|---|---|---|---|---|---|---|---|---|---|
| 11 | O | O | N | 0 | 0 | $CH_3$ | $CH_3$ | - | - |
| 12 | O | O | N | 0 | 0 | $n\text{-}C_{14}H_{29}$ | $n\text{-}C_{14}H_{29}$ | - | - |
| 13 | O | O | N | 0 | 0 | 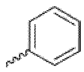 | 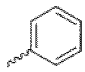 | - | - |
| 14 | O | O | N | 0 | 0 | 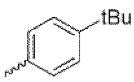 | 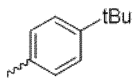 | - | - |
| 15 | O | O | N | 1 | 1 | $CH_3$ | $CH_3$ | $CH_3$ | $CH_3$ |
| 16 | O | O | N | 0 | 0 | 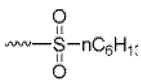 | 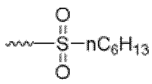 | - | - |
| 17 | O | O | N | 0 | 0 | $CH_3$ | $CH_3$ | - | - |
| 18 | O | O | N | 1 | 1 | 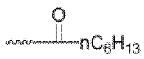 | 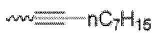 | $SCH_3$ | $SCH_3$ |
| 19 | O | O | N | 0 | 0 | 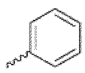 | $n\text{-}C_5H_{11}$ | - | - |
| 20 | O | O | N | 2 | 2 | $CH_3$ | $CH_3$ | $CH_3$ | $CH_3$ |

[Table 3]

| Specific Example | X | Y | Z | m | n | $R^1$ | $R^2$ | $R^3$ | $R^4$ |
|---|---|---|---|---|---|---|---|---|---|
| 21 | O | S | N | 0 | 0 | $CH_3$ | $CH_3$ | - | - |
| 22 | O | S | N | 0 | 0 | $n\text{-}C_{14}H_{29}$ | $n\text{-}C_{14}H_{29}$ | - | - |
| 23 | O | S | N | 0 | 0 | 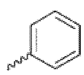 | 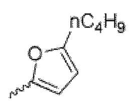 | - | - |

(continued)

| Specific Example | X | Y | Z | m | n | $R^1$ | $R^2$ | $R^3$ | $R^4$ |
|---|---|---|---|---|---|---|---|---|---|
| 24 | O | S | N | 0 | 0 | 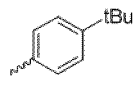 | 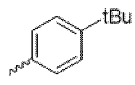 | - | - |
| 25 | O | S | N | 1 | 1 | $CH_3$ | $CH_3$ | $CH_3$ | $CH_3$ |
| 26 | O | S | N | 0 | 0 | $-S-nC_6H_{13}$ | $-S-nC_6H_{13}$ | - | - |
| 27 | O | S | N | 0 | 0 | $CH_3$ | $CH_3$ | - | - |
| 28 | O | S | N | 1 | 1 | 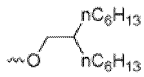 | 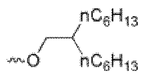 | $SCH_3$ | $SCH_3$ |
| 29 | O | S | N | 0 | 0 | 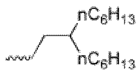 | $n-C_5H_{11}$ | - | - |
| 30 | O | S | N | 2 | 2 | $CH_3$ | $CH_3$ | $CH_3$ | $CH_3$ |

[Table 4]

| Specific Example | X | Y | Z | m | n | $R^1$ | $R^2$ | $R^3$ | $R^4$ |
|---|---|---|---|---|---|---|---|---|---|
| 31 | O | Se | CH | 0 | 0 | $CH_3$ | $CH_3$ | - | - |
| 32 | O | Se | CH | 0 | 0 | $n-C_{14}H_{29}$ | $n-C_{14}H_{29}$ | - | - |
| 33 | O | Se | CH | 0 | 0 | 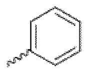 | 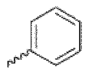 | - | - |
| 34 | O | Se | CH | 0 | 0 | 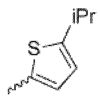 | 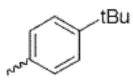 | - | - |
| 35 | O | Se | CH | 1 | 1 | H | H | $n-C_{14}H_{29}$ | $n-C_{14}H_{29}$ |
| 36 | O | Se | $C(n-C_9H_{19})$ | 0 | 0 | 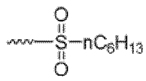 | 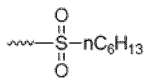 | - | - |
| 37 | O | Se | $C(n-C_6H_{13})$ | 0 | 0 | $CH_3$ | $CH_3$ | - | - |
| 38 | O | Se | CH | 1 | 1 | 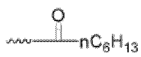 | $-N(C_4H_9)_2$ | $OCH_3$ | $OCH_3$ |
| 39 | O | Se | CH | 0 | 0 | 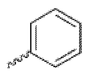 | $n-C_5H_{11}$ | - | - |
| 40 | O | Se | CH | 2 | 2 | $CH_3$ | $CH_3$ | $CH_3$ | $CH_3$ |

[Table 5]

| Specific Example | X | Y | Z | m | n | $R^1$ | $R^2$ | $R^3$ | $R^4$ |
|---|---|---|---|---|---|---|---|---|---|
| 41 | O | Se | N | 0 | 0 | $CH_3$ | $CH_3$ | - | - |

(continued)

| Specific Example | X | Y | Z | m | n | $R^1$ | $R^2$ | $R^3$ | $R^4$ |
|---|---|---|---|---|---|---|---|---|---|
| 42 | O | Se | N | 0 | 0 | $n\text{-}C_{14}H_{29}$ | $n\text{-}C_{14}H_{29}$ | - | - |
| 43 | O | Se | N | 0 | 0 | 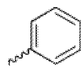 | 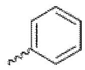 | - | - |
| 44 | O | Se | N | 0 | 0 | 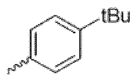 | 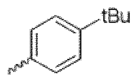 | - | - |
| 45 | O | Se | N | 1 | 1 | $CH_3$ | $CH_3$ | $CH_3$ | $CH_3$ |
| 46 | O | Se | N | 0 | 0 | 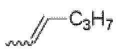 | 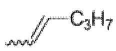 | - | - |
| 47 | O | Se | N | 0 | 0 | $CH_3$ | $CH_3$ | - | - |
| 48 | O | Se | N | 1 | 1 | 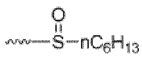 | 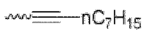 | $SCH_3$ | $SCH_3$ |
| 49 | O | Se | N | 0 | 0 | 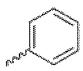 | $n\text{-}C_5H_{11}$ | - | - |
| 50 | O | Se | N | 2 | 2 | $CH_3$ | $CH_3$ | $CH_3$ | $CH_3$ |

[Table 6]

| Specific Example | X | Y | Z | m | n | $R^1$ | $R^2$ | $R^3$ | $R^4$ |
|---|---|---|---|---|---|---|---|---|---|
| 51 | O | CH | S | 0 | 0 | $CH_3$ | $CH_3$ | - | - |
| 52 | O | CH | S | 0 | 0 | $n\text{-}C_{14}H_{29}$ | $n\text{-}C_{14}H_{29}$ | - | - |
| 53 | O | CH | S | 0 | 0 | 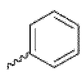 | 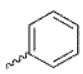 | - | - |
| 54 | O | CH | S | 0 | 0 | 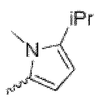 | 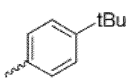 | - | - |
| 55 | O | CH | S | 1 | 1 | H | H | $n\text{-}C_{14}H_{29}$ | $n\text{-}C_{14}H_{29}$ |
| 56 | O | $C(n\text{-}C_9H_{19})$ | S | 0 | 0 | 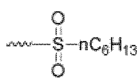 | 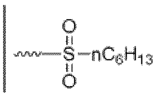 | - | - |
| 57 | O | $C(n\text{-}C_6H_{13})$ | $N(CH_3)$ | 0 | 0 | $CH_3$ | $CH_3$ | - | - |
| 58 | O | CH | $N(CH_3)$ | 1 | 1 | 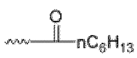 | $N(C_4H_9)_2$ | $OCH_3$ | $OCH_3$ |
| 59 | O | CH | $N(n\text{-}C_9H_{19})$ | 0 | 0 | 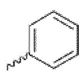 | $n\text{-}C_5H_{11}$ | - | - |
| 60 | O | CH | $N(n\text{-}C_9H_{19})$ | 2 | 2 | $CH_3$ | $CH_3$ | $CH_3$ | $CH_3$ |

[Table 7]

| Specific Example | X | Y | Z | m | n | R1 | R2 | R3 | R4 |
|---|---|---|---|---|---|---|---|---|---|
| 61 | O | O | CH | 0 | 0 | $CH_3$ | $CH_3$ | - | - |
| 62 | O | O | $C(n\text{-}C_9H_{19})$ | 0 | 0 | $n\text{-}C_{14}H_{29}$ | $n\text{-}C_{14}H_{29}$ | - | - |
| 63 | O | O | $C(n\text{-}C_6H_{13})$ | 0 | 0 | 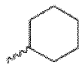 | 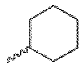 | - | - |
| 64 | O | O | CH | 0 | 0 | 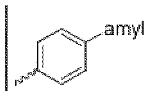 | 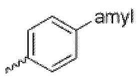 | - | - |
| 65 | O | O | CH | 1 | 1 | $CH_3$ | $CH_3$ | $CH_3$ | $CH_3$ |
| 66 | O | O | $C(n\text{-}C_9H_{19})$ | 0 | 0 | 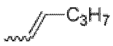 | 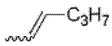 | - | - |
| 67 | O | S | $C(n\text{-}C_6H_{13})$ | 0 | 0 | $CH_3$ | $CH_3$ | - | - |
| 68 | O | S | CH | 1 | 1 | 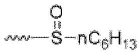 | 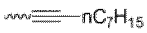 | $SCH_3$ | $SCH_3$ |
| 69 | O | S | CH | 0 | 0 | 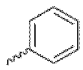 | $n\text{-}C_5H_{11}$ | - | - |
| 70 | O | S | CH | 2 | 2 | $CH_3$ | $CH_3$ | $CH_3$ | $CH_3$ |

[Table 8]

| Specific Example | X | Y | Z | m | n | R1 | R2 | R3 | R4 |
|---|---|---|---|---|---|---|---|---|---|
| 71 | O | N | O | 0 | 0 | $CH_3$ | $CH_3$ | - | - |
| 72 | O | N | O | 0 | 0 | $n\text{-}C_{14}H_{29}$ | $n\text{-}C_{14}H_{29}$ | - | - |
| 73 | O | N | O | 0 | 0 | 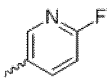 | 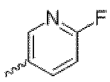 | - | - |
| 74 | O | N | O | 0 | 0 | 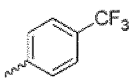 | 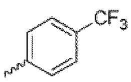 | - | - |
| 75 | O | N | O | 1 | 1 | $CH_3$ | $CH_3$ | $CH_3$ | $CH_3$ |
| 76 | O | N | O | 0 | 0 | 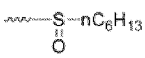 | 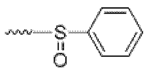 | - | - |
| 77 | O | N | O | 0 | 0 | $CH_3$ | $CH_3$ | - | - |
| 78 | O | N | O | 1 | 1 | 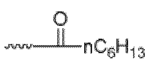 | 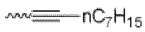 | $SCH_3$ | $SCH_3$ |
| 79 | O | N | O | 0 | 0 | 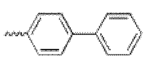 | $n\text{-}C_5H_{11}$ | - | - |
| 80 | O | N | O | 2 | 2 | $CH_3$ | $CH_3$ | $CH_3$ | $CH_3$ |

[Table 9]

| Specific Example | X | Y | Z | m | n | $R^1$ | $R^2$ | $R^3$ | $R^4$ |
|---|---|---|---|---|---|---|---|---|---|
| 81 | O | N | S | 0 | 0 | $CH_3$ | $CH_3$ | - | - |
| 82 | O | N | S | 0 | 0 | n-$C_9H_{19}$ | n-$C_9H_{19}$ | - | - |
| 83 | O | N | S | 0 | 0 | 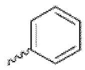 | 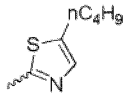 | - | - |
| 84 | O | N | S | 0 | 0 | 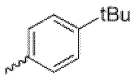 | 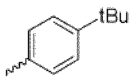 | - | - |
| 85 | O | N | S | 1 | 1 | $CH_3$ | $CH_3$ | $CH_3$ | $CH_3$ |
| 86 | O | N | S | 0 | 0 | S–n$C_6H_{13}$ | S–n$C_6H_{13}$ | - | - |
| 87 | O | N | S | 0 | 0 | $CH_3$ | $CH_3$ | - | - |
| 88 | O | N | S | 1 | 2 | 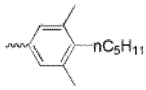 | 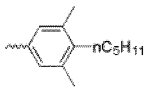 | $SCH_3$ | $SCH_3$ |
| 89 | O | N | S | 0 | 0 | 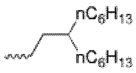 | n-$C_5H_{11}$ | - | - |
| 90 | O | N | Se | 0 | 0 | $CH_3$ | $CH_3$ | - | - |

[Table 10]

| Specific Example | X | Y | Z | m | n | $R^1$ | $R^2$ | $R^3$ | $R^4$ |
|---|---|---|---|---|---|---|---|---|---|
| 91 | O | N | Se | 0 | 0 | n-$C_{14}H_{29}$ | n-$C_{14}H_{29}$ | - | - |
| 92 | O | N | Se | 0 | 0 | 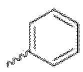 | 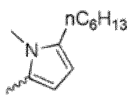 | - | - |
| 93 | O | N | Se | 0 | 0 | 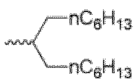 | 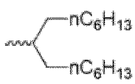 | - | - |
| 94 | O | N | Se | 1 | 1 | H | H | n-$C_{14}H_{29}$ | n-$C_{14}H_{29}$ |
| 95 | O | N | Se | 0 | 0 | 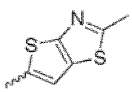 | 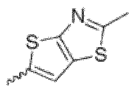 | - | - |
| 96 | O | N | Se | 0 | 0 | $CH_3$ | $CH_3$ | - | - |
| 97 | O | N | Se | 1 | 1 | 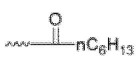 | $N(C_4H_9)_2$ | $OCH_3$ | $OCH_3$ |

(continued)

| Specific Example | X | Y | Z | m | n | $R^1$ | $R^2$ | $R^3$ | $R^4$ |
|---|---|---|---|---|---|---|---|---|---|
| 98 | O | N | Se | 0 | 0 | 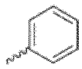 | n-$C_5H_{11}$ | - | - |
| 99 | O | $N(CH_3)$ | CH | 0 | 0 | $CH_3$ | $CH_3$ | - | - |
| 100 | O | NH | CH | 0 | 0 | n-$C_{14}H_{29}$ | n-$C_{14}H_{29}$ | - | - |

[Table 11]

| Specific Example | X | Y | Z | m | n | $R^1$ | $R^2$ | $R^3$ | $R^4$ |
|---|---|---|---|---|---|---|---|---|---|
| 101 | O | $N(CH_3)$ | CH | 0 | 0 | 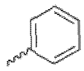 | 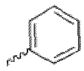 | - | - |
| 102 | O | $N(CH_3)$ | CH | 0 | 0 | 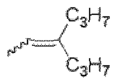 | 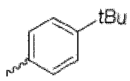 | - | - |
| 103 | O | $N(CH_3)$ | CH | 1 | 1 | H | H | n-$C_{14}H_{29}$ | n-$C_{14}H_{29}$ |
| 104 | O | $N(CH_3)$ | C(n-$C_9H_{19}$) | 0 | 0 | O-n$C_6H_{13}$ | O-n$C_6H_{13}$ | - | - |
| 105 | O | N(n-$C_9H_{19}$) | C(n-$C_6H_{13}$) | 0 | 0 | $CH_3$ | $CH_3$ | - | - |
| 106 | O | $N(CH_3)$ | CH | 1 | 1 | 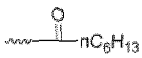 | $N(C_4H_9)_2$ | $OCH_3$ | $OCH_3$ |
| 107 | O | N(i-Pr) | CH | 0 | 0 | 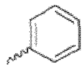 | n-$C_5H_{11}$ | - | - |
| 108 | O | $N(CH_3)$ | CH | 2 | 2 | $CH_3$ | $CH_3$ | $CH_3$ | $CH_3$ |
| 109 | S | CH | Se | 0 | 0 | $CH_3$ | $CH_3$ | - | - |
| 110 | S | CH | Se | 0 | 0 | n-$C_{14}H_{29}$ | n-$C_{14}H_{29}$ | - | - |

[Table 12]

| Specific Example | X | Y | Z | m | n | $R^1$ | $R^2$ | $R^3$ | $R^4$ |
|---|---|---|---|---|---|---|---|---|---|
| 111 | S | CH | Se | 0 | 0 | 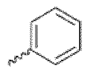 | 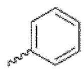 | - | - |
| 112 | S | CH | Se | 0 | 0 | 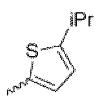 | 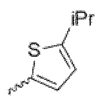 | - | - |
| 113 | S | CH | Se | 1 | 1 | $CH_3$ | $CH_3$ | $CH_3$ | $CH_3$ |
| 114 | S | C(n-$C_8H_{17}$) | Se | 0 | 0 | H | H | - | - |
| 115 | S | C(n-$C_6H_{13}$) | Se | 0 | 0 | $CH_3$ | $CH_3$ | - | - |

(continued)

| Specific Example | X | Y | Z | m | n | R1 | R2 | R3 | R4 |
|---|---|---|---|---|---|---|---|---|---|
| 116 | S | CH | Se | 1 | 1 | 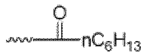 | $N(C_4H_9)_2$ | $OCH_3$ | $OCH_3$ |
| 117 | S | CH | Se | 0 | 0 | 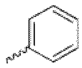 | $n\text{-}C_5H_{11}$ | - | - |
| 118 | S | CH | $N(CH_3)$ | 2 | 2 | $CH_3$ | $CH_3$ | $CH_3$ | $CH_3$ |
| 119 | S | O | N | 0 | 0 | $CH_3$ | $CH_3$ | - | - |
| 120 | S | O | N | 0 | 0 | $n\text{-}C_{14}H_{29}$ | $n\text{-}C_{14}H_{29}$ | - | - |

[Table 13]

| Specific Example | X | Y | Z | m | n | R1 | R2 | R3 | R4 |
|---|---|---|---|---|---|---|---|---|---|
| 121 | S | O | N | 0 | 0 | 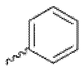 | 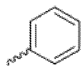 | - | - |
| 122 | S | O | N | 0 | 0 | 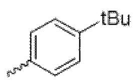 | 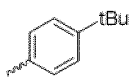 | - | - |
| 123 | S | O | N | 1 | 1 | $CH_3$ | $CH_3$ | $CH_3$ | $CH_3$ |
| 124 | S | O | N | 0 | 0 | 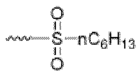 | 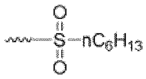 | - | - |
| 125 | S | O | N | 0 | 0 | $CH_3$ | $CH_3$ | - | - |
| 126 | S | O | N | 1 | 1 | 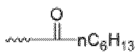 | 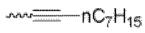 | $SCH_3$ | $SCH_3$ |
| 127 | S | O | N | 0 | 0 | 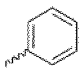 | $n\text{-}C_5H_{11}$ | - | - |
| 128 | S | O | N | 2 | 2 | $CH_3$ | $CH_3$ | $CH_3$ | $CH_3$ |
| 129 | S | S | N | 0 | 0 | $CH_3$ | $CH_3$ | - | - |
| 130 | S | S | N | 0 | 0 | $n\text{-}C_9H_{19}$ | $n\text{-}C_9H_{19}$ | - | - |

[Table 14]

| Specific Example | X | Y | Z | m | n | R1 | R2 | R3 | R4 |
|---|---|---|---|---|---|---|---|---|---|
| 131 | S | S | N | 0 | 0 | 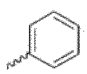 | 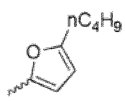 | - | - |
| 132 | S | S | N | 0 | 0 | 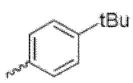 | 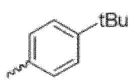 | - | - |
| 133 | S | S | N | 1 | 1 | $CH_3$ | $CH_3$ | $CH_3$ | $CH_3$ |

(continued)

| Specific Example | X | Y | Z | m | n | R¹ | R² | R³ | R⁴ |
|---|---|---|---|---|---|---|---|---|---|
| 134 | S | S | N | 0 | 0 | $-S-nC_6H_{13}$ | $-S-nC_6H_{13}$ | - | - |
| 135 | S | S | N | 0 | 0 | $CH_3$ | $CH_3$ | - | - |
| 136 | S | S | N | 1 | 1 | 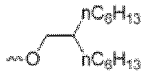 | 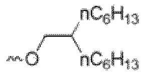 | $SCH_3$ | $SCH_3$ |
| 137 | S | S | N | 0 | 0 | 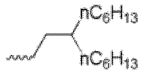 | $n-C_5H_{11}$ | - | - |
| 138 | S | S | N | 2 | 2 | $CH_3$ | $CH_3$ | $CH_3$ | $CH_3$ |
| 139 | S | Se | CH | 0 | 0 | $CH_3$ | $CH_3$ | - | - |
| 140 | S | Se | CH | 0 | 0 | $n-C_{14}H_{29}$ | $n-C_{14}H_{29}$ | - | - |

[Table 15]

| Specific Example | X | Y | Z | m | n | R¹ | R² | R³ | R⁴ |
|---|---|---|---|---|---|---|---|---|---|
| 141 | S | Se | CH | 0 | 0 | 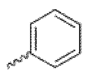 | 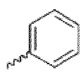 | - | - |
| 142 | S | Se | CH | 0 | 0 | 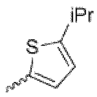 | 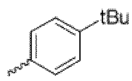 | - | - |
| 143 | S | Se | CH | 1 | 1 | H | H | $n-C_{14}H_{29}$ | $n-C_{14}H_{29}$ |
| 144 | S | Se | $C(n-C_9H_{19})$ | 0 | 0 | 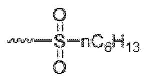 | 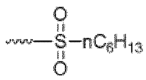 | - | - |
| 145 | S | Se | $C(n-C_6H_{13})$ | 0 | 0 | $CH_3$ | $CH_3$ | - | - |
| 146 | S | Se | CH | 1 | 1 | 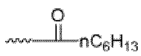 | $-N(C_4H_9)_2$ | $OCH_3$ | $OCH_3$ |
| 147 | S | Se | CH | 0 | 0 | 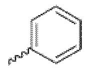 | $n-C_5H_{11}$ | - | - |
| 148 | S | Se | CH | 2 | 2 | $CH_3$ | $CH_3$ | $CH_3$ | $CH_3$ |
| 149 | S | Se | N | 0 | 0 | $CH_3$ | $CH_3$ | - | - |
| 150 | S | Se | N | 0 | 0 | $n-C_{14}H_{29}$ | $n-C_{14}H_{29}$ | - | - |

[Table 16]

| Specific Example | X | Y | Z | m | n | R¹ | R² | R³ | R⁴ |
|---|---|---|---|---|---|---|---|---|---|
| 151 | S | Se | N | 0 | 0 | 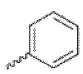 | 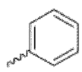 | - | - |

(continued)

| Specific Example | X | Y | Z | m | n | $R^1$ | $R^2$ | $R^3$ | $R^4$ |
|---|---|---|---|---|---|---|---|---|---|
| 152 | S | Se | N | 0 | 0 | 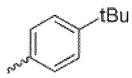 | 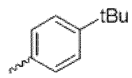 | - | - |
| 153 | S | Se | N | 1 | 1 | $CH_3$ | $CH_3$ | $CH_3$ | $CH_3$ |
| 154 | S | Se | N | 0 | 0 | 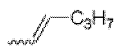 | 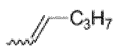 | - | - |
| 155 | S | Se | N | 0 | 0 | $CH_3$ | $CH_3$ | - | - |
| 156 | S | Se | N | 1 | 1 | 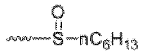 | 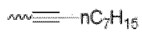 | $SCH_3$ | $SCH_3$ |
| 157 | S | Se | N | 0 | 0 | 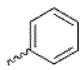 | $n\text{-}C_5H_{11}$ | - | - |
| 158 | S | Se | N | 2 | 2 | $CH_3$ | $CH_3$ | $CH_3$ | $CH_3$ |
| 159 | S | N | O | 0 | 0 | $CH_3$ | $CH_3$ | - | - |
| 160 | S | N | O | 0 | 0 | $n\text{-}C_{14}H_{29}$ | $n\text{-}C_{14}H_{29}$ | - | - |

[Table 17]

| Specific Example | X | Y | Z | m | n | $R^1$ | $R^2$ | $R^3$ | $R^4$ |
|---|---|---|---|---|---|---|---|---|---|
| 161 | S | N | O | 0 | 0 | 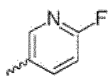 | 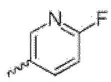 | - | - |
| 162 | S | N | O | 0 | 0 | 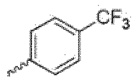 | 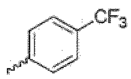 | - | - |
| 163 | S | N | O | 1 | 1 | $CH_3$ | $CH_3$ | $CH_3$ | $CH_3$ |
| 164 | S | N | O | 0 | 0 | 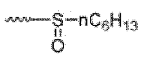 | 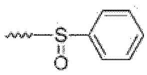 | - | - |
| 165 | S | N | O | 0 | 0 | $CH_3$ | $CH_3$ | - | - |
| 166 | S | N | O | 1 | 1 | 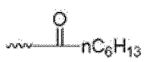 | 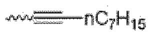 | $SCH_3$ | $SCH_3$ |
| 167 | S | N | O | 0 | 0 | 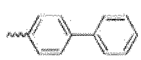 | $n\text{-}C_5H_{11}$ | - | - |
| 168 | S | N | O | 2 | 2 | $CH_3$ | $CH_3$ | $CH_3$ | $CH_3$ |
| 169 | S | N | S | 0 | 0 | $CH_3$ | $CH_3$ | - | - |
| 170 | S | N | S | 0 | 0 | $n\text{-}C_9H_{19}$ | $n\text{-}C_9H_{19}$ | - | - |

[Table 18]

| Specific Example | X | Y | Z | m | n | $R^1$ | $R^2$ | $R^3$ | $R^4$ |
|---|---|---|---|---|---|---|---|---|---|
| 171 | S | N | S | 0 | 0 | 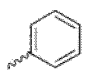 | 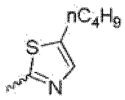 | - | - |
| 172 | S | N | S | 0 | 0 | 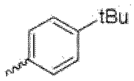 | 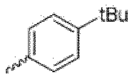 | - | - |
| 173 | S | N | S | 1 | 1 | $CH_3$ | $CH_3$ | $CH_3$ | $CH_3$ |
| 174 | S | N | S | 0 | 0 | $S-nC_6H_{13}$ | $S-nC_6H_{13}$ | - | - |
| 175 | S | N | S | 0 | 0 | $CH_3$ | $CH_3$ | - | - |
| 176 | S | N | S | 1 | 2 | 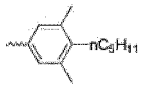 | 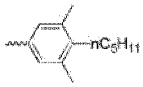 | $SCH_3$ | $SCH_3$ |
| 177 | S | N | S | 0 | 0 | 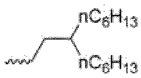 | $n-C_5H_{11}$ | - | - |
| 178 | S | N | Se | 0 | 0 | $CH_3$ | $CH_3$ | - | - |
| 179 | S | N | Se | 0 | 0 | $n-C_{14}H_{29}$ | $n-C_{14}H_{29}$ | - | - |
| 180 | S | N | Se | 0 | 0 | 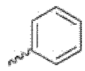 | 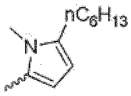 | - | - |

[Table 19]

| Specific Example | X | Y | Z | m | n | $R^1$ | $R^2$ | $R^3$ | $R^4$ |
|---|---|---|---|---|---|---|---|---|---|
| 181 | S | N | Se | 0 | 0 | 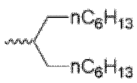 | 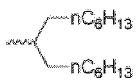 | - | - |
| 182 | S | N | Se | 1 | 1 | H | H | $n-C_{14}H_{29}$ | $n-C_{14}H_{29}$ |
| 183 | S | N | Se | 0 | 0 | 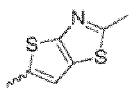 | 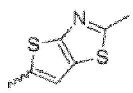 | - | - |
| 184 | S | N | Se | 0 | 0 | $CH_3$ | $CH_3$ | - | - |
| 185 | S | N | Se | 1 | 1 | 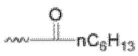 | $N(C_4H_9)_2$ | $OCH_3$ | $OCH_3$ |
| 186 | S | N | Se | 0 | 0 | 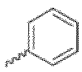 | $n-C_5H_{11}$ | - | - |
| 187 | S | $N(CH_3)$ | CH | 0 | 0 | $CH_3$ | $CH_3$ | - | - |
| 188 | S | NH | CH | 0 | 0 | $n-C_{14}H_{29}$ | $n-C_{14}H_{29}$ | - | - |
| 189 | S | $N(CH_3)$ | CH | 0 | 0 | 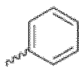 | 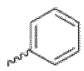 | - | - |

(continued)

| Specific Example | X | Y | Z | m | n | $R^1$ | $R^2$ | $R^3$ | $R^4$ |
|---|---|---|---|---|---|---|---|---|---|
| 190 | S | $N(CH_3)$ | CH | 0 | 0 | 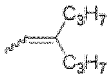 | 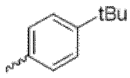 | - | - |

[Table 20]

| Specific Example | X | Y | Z | m | n | $R^1$ | $R^2$ | $R^3$ | $R^4$ |
|---|---|---|---|---|---|---|---|---|---|
| 191 | S | $N(CH_3)$ | CH | 1 | 1 | H | H | $n-C_{14}H_{29}$ | $n-C_{14}H_{29}$ |
| 192 | S | $N(CH_3)$ | $C(n-C_9H-_{19})$ | 0 | 0 | $-O-nC_6H_{13}$ | $-O-nC_6H_{13}$ | - | - |
| 193 | S | $N(n-C_9H_{19})$ | $C(n-C_6H_{13})$ | 0 | 0 | $CH_3$ | $CH_3$ | - | - |
| 194 | S | $N(CH_3)$ | CH | 1 | 1 | 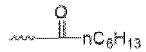 | $-N(C_4H_9)_2$ | $OCH_3$ | $OCH_3$ |
| 195 | S | N(i-Pr) | CH | 0 | 0 | 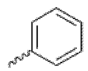 | $n-C_5H_{11}$ | - | - |
| 196 | S | $N(CH_3\ )$ | CH | 2 | 2 | $CH_3$ | $CH_3$ | $CH_3$ | $CH_3$ |
| 197 | Se | CH | Se | 0 | 0 | $CH_3$ | $CH_3$ | - | - |
| 198 | Se | CH | Se | 0 | 0 | $n-C_{14}H_{29}$ | $n-C_{14}H_{29}$ | - | - |
| 199 | Se | CH | Se | 0 | 0 | 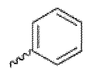 | 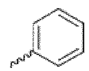 | - | - |
| 200 | Se | CH | Se | 0 | 0 | 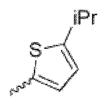 | 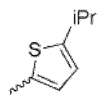 | - | - |

[Table 21]

| Specific Example | X | Y | Z | m | n | $R^1$ | $R^2$ | $R^3$ | $R^4$ |
|---|---|---|---|---|---|---|---|---|---|
| 201 | Se | CH | Se | 1 | 1 | $CH_3$ | $CH_3$ | $CH_3$ | $CH_3$ |
| 202 | Se | $C(n\text{-}C_8H_{17})$ | Se | 0 | 0 | H | H | - | - |
| 203 | Se | $C(n\text{-}C_6H_{13})$ | Se | 0 | 0 | $CH_3$ | $CH_3$ | - | - |
| 204 | Se | CH | Se | 1 | 1 | 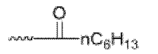 | $N(C_4H_9)_2$ | $OCH_3$ | $OCH_3$ |
| 205 | Se | CH | Se | 0 | 0 | 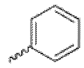 | $n\text{-}C_5H_{11}$ | - | - |
| 206 | Se | CH | Se | 2 | 2 | $CH_3$ | $CH_3$ | $CH_3$ | $CH_3$ |
| 207 | Se | 0 | N | 0 | 0 | $CH_3$ | $CH_3$ | - | - |
| 208 | Se | 0 | N | 0 | 0 | $n\text{-}C_{14}H_{29}$ | $n\text{-}C_{14}H_{29}$ | - | - |
| 209 | Se | 0 | N | 0 | 0 | 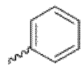 | 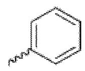 | - | - |
| 210 | Se | 0 | N | 0 | 0 | 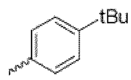 | 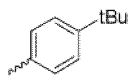 | - | - |

[Table 22]

| Specific Example | X | Y | Z | m | n | $R^1$ | $R^2$ | $R^3$ | $R^4$ |
|---|---|---|---|---|---|---|---|---|---|
| 211 | Se | 0 | N | 1 | 1 | $CH_3$ | $CH_3$ | $CH_3$ | $CH_3$ |
| 212 | Se | o | N | 0 | 0 | 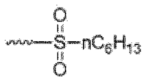 | 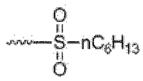 | - | - |
| 213 | Se | 0 | N | 0 | 0 | $CH_3$ | $CH_3$ | - | - |
| 214 | Se | 0 | N | 1 | 1 | 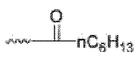 | 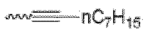 | $SCH_3$ | $SCH_3$ |
| 215 | Se | 0 | N | 0 | 0 | 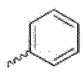 | $n\text{-}C_5H_{11}$ | - | - |
| 216 | Se | 0 | N | 2 | 2 | $CH_3$ | $CH_3$ | $CH_3$ | $CH_3$ |
| 217 | Se | S | N | 0 | 0 | $CH_3$ | $CH_3$ | - | - |
| 218 | Se | S | N | 0 | 0 | $n\text{-}C_9H_{19}$ | $n\text{-}C_9H_{19}$ | - | - |
| 219 | Se | S | N | 0 | 0 | 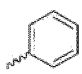 | 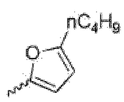 | - | - |
| 220 | Se | S | N | 0 | 0 | 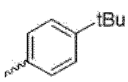 | 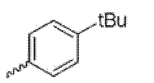 | - | - |

[Table 23]

| Specific Example | X | Y | Z | m | n | $R^1$ | $R^2$ | $R^3$ | $R^4$ |
|---|---|---|---|---|---|---|---|---|---|
| 221 | Se | S | N | 1 | 1 | $CH_3$ | $CH_3$ | $CH_3$ | $CH_3$ |
| 222 | Se | S | N | 0 | 0 | $S-nC_6H_{13}$ | $S-nC_6H_{13}$ | - | - |
| 223 | Se | S | N | 0 | 0 | $CH_3$ | $CH_3$ | - | - |
| 224 | Se | S | N | 1 | 1 | 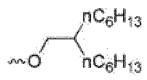 | 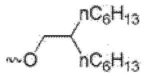 | $SCH_3$ | $SCH_3$ |
| 225 | Se | S | N | 0 | 0 | 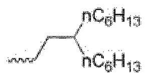 | $n-C_5H_{11}$ | - | - |
| 226 | Se | S | N | 2 | 2 | $CH_3$ | $CH_3$ | $CH_3$ | $CH_3$ |
| 227 | Se | Se | CH | 0 | 0 | $CH_3$ | $CH_3$ | - | - |
| 228 | Se | Se | CH | 0 | 0 | $n-C_{14}H_{29}$ | $n-C_{14}H_{29}$ | - | - |
| 229 | Se | Se | H | 0 | 0 | 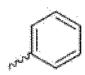 | 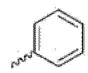 | - | - |
| 230 | Se | Se | CH | 0 | 0 | 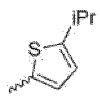 | 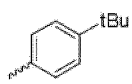 | - | - |

[Table 24]

| Specific Example | X | Y | Z | m | n | $R^1$ | $R^2$ | $R^3$ | $R^4$ |
|---|---|---|---|---|---|---|---|---|---|
| 231 | Se | Se | CH | 1 | 1 | H | H | $n-C_{14}H_{29}$ | $n-C_{14}H_{29}$ |
| 232 | Se | Se | $C(n-C_9H_{19})$ | 0 | 0 | 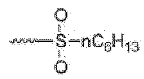 | 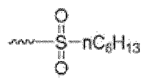 | - | - |
| 233 | Se | Se | $C(n-C_6H_{13})$ | 0 | 0 | $CH_3$ | $CH_3$ | - | - |
| 234 | Se | Se | CH | 1 | 1 | 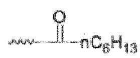 | $N(C_4H_9)_2$ | $OCH_3$ | $OCH_3$ |
| 235 | Se | Se | CH | 0 | 0 | 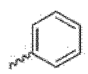 | $n-C_5H_{11}$ | - | - |
| 236 | Se | Se | CH | 2 | 2 | $CH_3$ | $CH_3$ | $CH_3$ | $CH_3$ |
| 237 | Se | Se | N | 0 | 0 | $CH_3$ | $CH_3$ | - | - |

(continued)

| Specific Example | X | Y | Z | m | n | $R^1$ | $R^2$ | $R^3$ | $R^4$ |
|---|---|---|---|---|---|---|---|---|---|
| 238 | Se | Se | N | 0 | 0 | n-$C_{14}H_{29}$ | n-$C_{14}H_{29}$ | - | - |
| 239 | Se | Se | N | 0 | 0 | 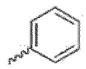 | 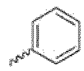 | - | - |
| 240 | Se | Se | N | 0 | 0 | 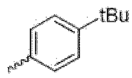 | 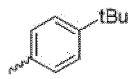 | - | - |

[Table 25]

| Specific Example | X | Y | Z | m | n | $R^1$ | $R^2$ | $R^3$ | $R^4$ |
|---|---|---|---|---|---|---|---|---|---|
| 241 | Se | Se | N | 1 | 1 | $CH_3$ | $CH_3$ | $CH_3$ | $CH_3$ |
| 242 | Se | Se | N | 0 | 0 | 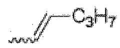 | 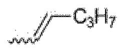 | - | - |
| 243 | Se | Se | N | 0 | 0 | $CH_3$ | $CH_3$ | - | - |
| 244 | Se | Se | N | 1 | 1 | 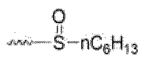 | 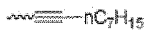 | $SCH_3$ | $SCH_3$ |
| 245 | Se | Se | N | 0 | 0 | 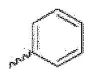 | n-$C_5H_{11}$ | - | - |
| 246 | Se | Se | N | 2 | 2 | $CH_3$ | $CH_3$ | $CH_3$ | $CH_3$ |
| 247 | Se | CH | 0 | 0 | 0 | $CH_3$ | $CH_3$ | - | - |
| 248 | Se | CH | 0 | 0 | 0 | n-$C_{14}H_{29}$ | n-$C_{14}H_{29}$ | - | - |
| 249 | Se | CH | 0 | 0 | 0 | 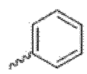 | 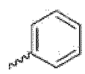 | - | - |
| 250 | Se | CH | 0 | 0 | 0 | 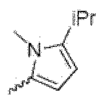 | 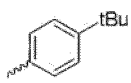 | - | - |

[Table 26]

| Specific Example | X | Y | Z | m | n | $R^1$ | $R^2$ | $R^3$ | $R^4$ |
|---|---|---|---|---|---|---|---|---|---|
| 251 | Se | CH | 0 | 1 | 1 | H | H | n-$C_{14}H_{29}$ | n-$C_{14}H_{29}$ |
| 252 | Se | C(n-$C_9H_{19}$) | 0 | 0 | 0 | 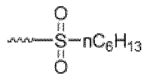 | 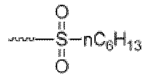 | - | - |
| 253 | Se | C(n-$C_6H_{13}$) | O | 0 | 0 | $CH_3$ | $CH_3$ | - | - |
| 254 | Se | CH | 0 | 1 | 1 | 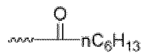 | $N(C_4H_9)_2$ | $OCH_3$ | $OCH_3$ |
| 255 | Se | CH | 0 | 0 | 0 | 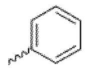 | n-$C_5H_{11}$ | - | - |
| 256 | Se | CH | 0 | 2 | 2 | $CH_3$ | $CH_3$ | $CH_3$ | $CH_3$ |
| 257 | Se | 0 | CH | 0 | 0 | $CH_3$ | $CH_3$ | - | - |
| 258 | Se | 0 | CH | 0 | 0 | n-$C_{14}H_{29}$ | n-$C_{14}H_{29}$ | - | - |
| 259 | Se | 0 | CH | 0 | 0 | 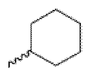 | 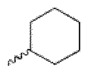 | - | - |
| 260 | Se | 0 | C(n-$C_9H_{19}$) | 0 | 0 | 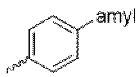 | 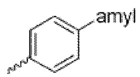 | - | - |

[Table 27]

| Specific Example | X | Y | Z | m | n | $R^1$ | $R^2$ | $R^3$ | $R^4$ |
|---|---|---|---|---|---|---|---|---|---|
| 261 | Se | S | $C(n\text{-}C_6H_{13})$ | 1 | 1 | $CH_3$ | $CH_3$ | $CH_3$ | $CH_3$ |
| 262 | Se | S | CH | 0 | 0 | 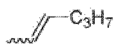 | 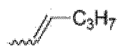 | - | - |
| 263 | Se | S | CH | 0 | 0 | $CH_3$ | $CH_3$ | - | - |
| 264 | Se | S | $C(n\text{-}C_9H_{19})$ | 1 | 1 | 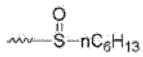 | 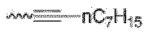 | $SCH_3$ | $SCH_3$ |
| 265 | Se | S | $C(CH_3)$ | 0 | 0 | 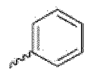 | $n\text{-}C_5H_{11}$ | - | - |
| 266 | Se | S | $C(n\text{-}C_6H_{13})$ | 2 | 2 | $CH_3$ | $CH_3$ | $CH_3$ | $CH_3$ |
| 267 | Se | N | 0 | 0 | 0 | $CH_3$ | $CH_3$ | - | - |
| 268 | Se | N | 0 | 0 | 0 | $n\text{-}C_{14}H_{29}$ | $n\text{-}C_{14}H_{29}$ | - | - |
| 269 | Se | N | 0 | 0 | 0 | 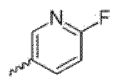 | 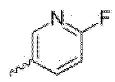 | - | - |
| 270 | Se | N | 0 | 0 | 0 | 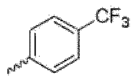 | 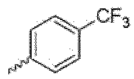 | - | - |

[Table 28]

| Specific Example | X | Y | Z | m | n | $R^1$ | $R^2$ | $R^3$ | $R^4$ |
|---|---|---|---|---|---|---|---|---|---|
| 271 | Se | N | 0 | 1 | 1 | $CH_3$ | $CH_3$ | $CH_3$ | $CH_3$ |
| 272 | Se | N | 0 | 0 | 0 | 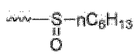 | 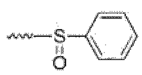 | - | - |
| 273 | Se | N | 0 | 0 | 0 | $CH_3$ | $CH_3$ | - | - |
| 274 | Se | N | 0 | 1 | 1 | 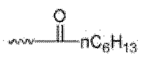 | 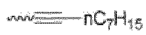 | $SCH_3$ | $SCH_3$ |
| 275 | Se | N | 0 | 0 | 0 | 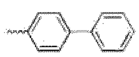 | $n\text{-}C_5H_{11}$ | - | - |
| 276 | Se | N | 0 | 2 | 2 | $CH_3$ | $CH_3$ | $CH_3$ | $CH_3$ |
| 277 | Se | N | S | 0 | 0 | $CH_3$ | $CH_3$ | - | - |
| 278 | Se | N | S | 0 | 0 | $n\text{-}C_9H_{19}$ | $n\text{-}C_9H_{19}$ | - | - |
| 279 | Se | N | S | 0 | 0 | 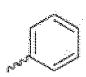 | 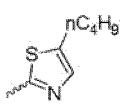 | - | - |
| 280 | Se | N | S | 0 | 0 | 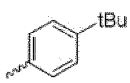 | 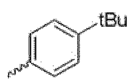 | - | - |

[Table 29]

| Specific Example | X | Y | Z | m | n | $R^1$ | $R^2$ | $R^3$ | $R^4$ |
|---|---|---|---|---|---|---|---|---|---|
| 281 | Se | N | S | 1 | 1 | $CH_3$ | $CH_3$ | $CH_3$ | $CH_3$ |
| 282 | Se | N | S | 0 | 0 | $-S-nC_6H_{13}$ | $-S-nC_6H_{13}$ | - | - |
| 283 | Se | N | S | 0 | 0 | $CH_3$ | $CH_3$ | - | - |
| 284 | Se | N | S | 1 | 2 | 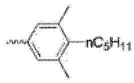 | 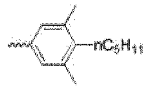 | $SCH_3$ | $SCH_3$ |
| 285 | Se | N | S | 0 | 0 | 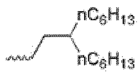 | $n-C_5H_{11}$ | - | - |
| 286 | Se | N | Se | 0 | 0 | $CH_3$ | $CH_3$ | - | - |
| 287 | Se | N | Se | 0 | 0 | $n-C_{14}H_{29}$ | $n-C_{14}H_{29}$ | - | - |
| 288 | Se | N | Se | 0 | 0 | 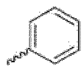 | 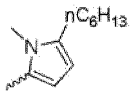 | - | - |
| 289 | Se | N | Se | 0 | 0 | 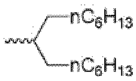 | 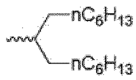 | - | - |
| 290 | Se | N | Se | 1 | 1 | $H$ | $H$ | $n-C_{14}H_{29}$ | $n-C_{14}H_{29}$ |

[Table 30]

| Specific Example | X | Y | Z | m | n | $R^1$ | $R^2$ | $R^3$ | $R^4$ |
|---|---|---|---|---|---|---|---|---|---|
| 291 | Se | N | Se | 0 | 0 | 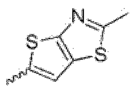 | 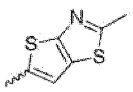 | - | - |
| 292 | Se | N | Se | 0 | 0 | $CH_3$ | $CH_3$ | - | - |
| 293 | Se | N | Se | 1 | 1 | 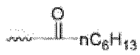 | $-N(C_4H_9)_2$ | $OCH_3$ | $OCH_3$ |
| 294 | Se | N | Se | 0 | 0 | 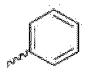 | $n-C_5H_{11}$ | - | - |
| 295 | Se | N | $N(CH_3)$ | 2 | 2 | $CH_3$ | $CH_3$ | $CH_3$ | $CH_3$ |
| 296 | Se | N | NH | 0 | 0 | $C_2H_5$ | $C_2H_5$ | - | - |
| 297 | Se | N | $N(CH_3)$ | 0 | 0 | $n-C_{14}H_{29}$ | $n-C_{14}H_{29}$ | - | - |
| 298 | Se | N | $N(CH_3)$ | 0 | 0 | 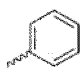 | 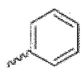 | - | - |
| 299 | Se | N | $N(CH_3)$ | 0 | 0 | 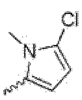 | 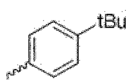 | - | - |

(continued)

| Specific Example | X | Y | Z | m | n | $R^1$ | $R^2$ | $R^3$ | $R^4$ |
|---|---|---|---|---|---|---|---|---|---|
| 300 | Se | N | $N(CH_3)$ | 1 | 1 | H | H | $n\text{-}C_{14}H_{29}$ | $n\text{-}C_{14}H_{29}$ |

[Table 31]

| Specific Example | X | Y | Z | m | n | $R^1$ | $R^2$ | $R^3$ | $R^4$ |
|---|---|---|---|---|---|---|---|---|---|
| 301 | Se | N | $N(n\text{-}C_9H_{19})$ | 0 | 0 | 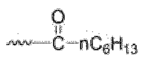 | 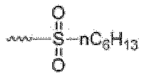 | - | - |
| 302 | Se | N | $N(CH_3)$ | 0 | 0 | $CH_3$ | $CH_3$ | - | - |
| 303 | Se | N | N(i-Pr) | 1 | 1 | 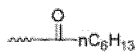 | 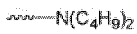 | $OCH_3$ | $OCH_3$ |
| 304 | Se | N | $N(CH_3)$ | 0 | 0 | 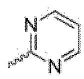 | $n\text{-}C_5H_{11}$ | - | - |
| 305 | Se | N | $N(CH_3)$ | 2 | 2 | $CH_3$ | $CH_3$ | $CH_3$ | $CH_3$ |
| 306 | Se | $N(CH_3)$ | N | 0 | 0 | $CH_3$ | $CH_3$ | - | - |
| 307 | Se | NH | N | 0 | 0 | $n\text{-}C_{14}H_{29}$ | $n\text{-}C_{14}H_{29}$ | - | - |
| 308 | Se | $N(CH_3)$ | N | 0 | 0 | 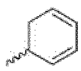 | 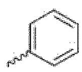 | - | - |
| 309 | Se | $N(CH_3)$ | N | 0 | 0 | 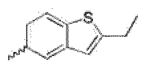 | 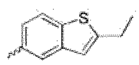 | - | - |
| 310 | Se | $N(CH_3)$ | N | 1 | 1 | $CH_3$ | $CH_3$ | $CH_3$ | $CH_3$ |

[Table 32]

| Specific Example | X | Y | Z | m | n | $R^1$ | $R^2$ | $R^3$ | $R^4$ |
|---|---|---|---|---|---|---|---|---|---|
| 311 | Se | $N(CH_3)$ | N | 0 | 0 | 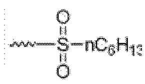 | 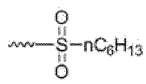 | - | - |
| 312 | Se | $N(n\text{-}C_9H_{19})$ | N | 0 | 0 | $CH_3$ | $CH_3$ | - | - |
| 313 | Se | $N(CH_3)$ | N | 1 | 1 | 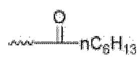 | 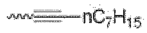 | 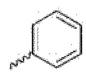 | 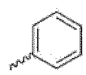 |
| 314 | Se | N(i-Pr) | N | 0 | 0 | 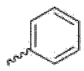 | $n\text{-}C_5H_{11}$ | - | - |
| 315 | Se | $N(CH_3)$ | N | 2 | 2 | $CH_3$ | $CH_3$ | $CH_3$ | $CH_3$ |
| 316 | Se | $N(CH_3)$ | CH | 0 | 0 | $CH_3$ | $CH_3$ | - | - |

(continued)

| Specific Example | X | Y | Z | m | n | $R^1$ | $R^2$ | $R^3$ | $R^4$ |
|---|---|---|---|---|---|---|---|---|---|
| 317 | Se | NH | CH | 0 | 0 | n-$C_{14}H_{29}$ | n-$C_{14}H_{29}$ | - | - |
| 318 | Se | $N(CH_3)$ | CH | 0 | 0 | 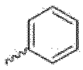 | 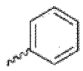 | - | - |
| 319 | Se | $N(CH_3)$ | CH | 0 | 0 | 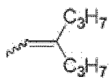 | 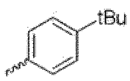 | - | - |
| 320 | Se | $N(CH_3)$ | CH | 1 | 1 | H | H | n-$C_{14}H_{29}$ | n-$C_{14}H_{29}$ |

[Table 33]

| Specific Example | X | Y | Z | m | n | $R^1$ | $R^2$ | $R^3$ | $R^4$ |
|---|---|---|---|---|---|---|---|---|---|
| 321 | Se | $N(CH_3)$ | C(n-$C_9H_{19}$) | 0 | 0 | —O−n$C_6H_{13}$ | —O−n$C_6H_{13}$ | - | - |
| 322 | Se | N(n-$C_9H_{19}$) | C(n-$C_6H_{13}$) | 0 | 0 | $CH_3$ | $CH_3$ | - | - |
| 323 | Se | $N(CH_3)$ | CH | 1 | 1 | 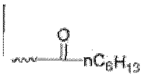 | —$N(C_4H_9)_2$ | $OCH_3$ | $OCH_3$ |
| 324 | Se | N(i-Pr) | CH | 0 | 0 | 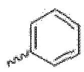 | n-$C_5H_{11}$ | - | - |
| 325 | Se | $N(CH_3)$ | CH | 2 | 2 | $CH_3$ | $CH_3$ | $CH_3$ | $CH_3$ |
| 326 | Te | CH | Se | 0 | 0 | $CH_3$ | $CH_3$ | - | - |
| 327 | Te | CH | Se | 0 | 0 | n-$C_{14}H_{29}$ | n-$C_{14}H_{29}$ | - | - |
| 328 | Te | CH | Se | 0 | 0 | 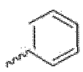 | 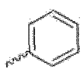 | - | - |
| 329 | Te | CH | Se | 0 | 0 | 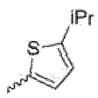 | 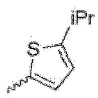 | - | - |
| 330 | Te | CH | Se | 1 | 1 | $CH_3$ | $CH_3$ | $CH_3$ | $CH_3$ |

[Table 34]

| Specific Example | X | Y | Z | m | n | $R^1$ | $R^2$ | $R^3$ | $R^4$ |
|---|---|---|---|---|---|---|---|---|---|
| 331 | Te | C(n-$C_8H_{17}$) | Se | 0 | 0 | H | H | - | - |
| 332 | Te | C(n-$C_6H_{13}$) | Se | 0 | 0 | $CH_3$ | $CH_3$ | - | - |
| 333 | Te | CH | Se | 1 | 1 | 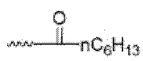 | —$N(C_4H_9)_2$ | $OCH_3$ | $OCH_3$ |

(continued)

| Specific Example | X | Y | Z | m | n | R1 | R2 | R3 | R4 |
|---|---|---|---|---|---|---|---|---|---|
| 334 | Te | CH | Se | 0 | 0 | 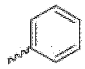 | n-$C_5H_{11}$ | - | - |
| 335 | Te | CH | Se | 2 | 2 | $CH_3$ | $CH_3$ | $CH_3$ | $CH_3$ |
| 336 | Te | O | N | 0 | 0 | $CH_3$ | $CH_3$ | - | - |
| 337 | Te | O | N | 0 | 0 | n-$C_{14}H_{29}$ | n-$C_{14}H_{29}$ | - | - |
| 338 | Te | O | N | 0 | 0 | 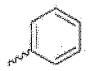 | 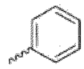 | - | - |
| 339 | Te | O | N | 0 | 0 | 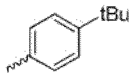 | 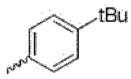 | - | - |
| 340 | Te | O | N | 1 | 1 | $CH_3$ | $CH_3$ | $CH_3$ | $CH_3$ |

[Table 35]

| Specific Example | X | Y | Z | m | n | R1 | R2 | R3 | R4 |
|---|---|---|---|---|---|---|---|---|---|
| 341 | Te | O | N | 0 | 0 | 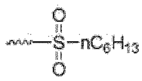 | 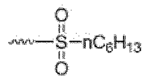 | - | - |
| 342 | Te | O | N | 0 | 0 | $CH_3$ | $CH_3$ | - | - |
| 343 | Te | O | N | 1 | 1 | 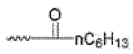 | 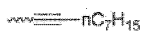 | $SCH_3$ | $SCH_3$ |
| 344 | Te | O | N | 0 | 0 | 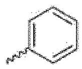 | n-$C_5H_{11}$ | - | - |
| 345 | Te | O | N | 2 | 2 | $CH_3$ | $CH_3$ | $CH_3$ | $CH_3$ |
| 346 | Te | S | N | 0 | 0 | $CH_3$ | $CH_3$ | - | - |
| 347 | Te | S | N | 0 | 0 | n-$C_9H_{19}$ | n-$C_9H_{19}$ | - | - |
| 348 | Te | S | N | 0 | 0 | 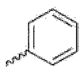 | 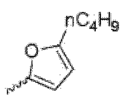 | - | - |
| 349 | Te | S | N | 0 | 0 | 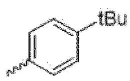 | 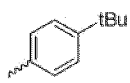 | - | - |

(continued)

| Specific Example | X | Y | Z | m | n | $R^1$ | $R^2$ | $R^3$ | $R^4$ |
|---|---|---|---|---|---|---|---|---|---|
| 350 | Te | S | N | 1 | 1 | $CH_3$ | $CH_3$ | $CH_3$ | $CH_3$ |

[Table 36]

| Specific Example | X | Y | Z | m | n | $R^1$ | $R^2$ | $R^3$ | $R^4$ |
|---|---|---|---|---|---|---|---|---|---|
| 351 | Te | S | N | 0 | 0 | $-S-nC_6H_{13}$ | $-S-nC_6H_{13}$ | - | - |
| 352 | Te | S | N | 0 | 0 | $CH_3$ | $CH_3$ | - | - |
| 353 | Te | S | N | 1 | 1 | 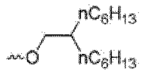 | 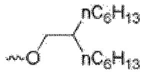 | $SCH_3$ | $SCH_3$ |
| 354 | Te | S | N | 0 | 0 | 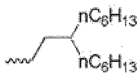 | $n-C_5H_{11}$ | - | - |
| 355 | Te | S | N | 2 | 2 | $CH_3$ | $CH_3$ | $CH_3$ | $CH_3$ |
| 356 | Te | Se | CH | 0 | 0 | $CH_3$ | $CH_3$ | - | - |
| 357 | Te | Se | CH | 0 | 0 | $n-C_{14}H_{29}$ | $n-C_{14}H_{29}$ | - | - |
| 358 | Te | Se | CH | 0 | 0 | 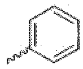 | 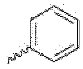 | - | - |
| 359 | Te | Se | CH | 0 | 0 | 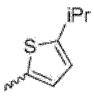 | 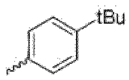 | - | - |
| 360 | Te | Se | CH | 1 | 1 | H | H | $n-C_{14}H_{29}$ | $n-C_{14}H_{29}$ |

[Table 37]

| Specific Example | X | Y | Z | m | n | $R^1$ | $R^2$ | $R^3$ | $R^4$ |
|---|---|---|---|---|---|---|---|---|---|
| 361 | Te | Se | $C(n-C_9H_{19})$ | 0 | 0 | 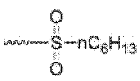 | 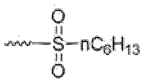 | - | - |
| 362 | Te | Se | $C(n-C_6H_{13})$ | 0 | 0 | $CH_3$ | $CH_3$ | - | - |
| 363 | Te | Se | CH | 1 | 1 | 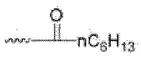 | $-N(C_4H_9)_2$ | $OCH_3$ | $OCH_3$ |
| 364 | Te | Se | CH | 0 | 0 | 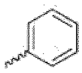 | $n-C_5H_{11}$ | - | - |
| 365 | Te | Se | CH | 2 | 2 | $CH_3$ | $CH_3$ | $CH_3$ | $CH_3$ |

(continued)

| Specific Example | X | Y | Z | m | n | R1 | R2 | R3 | R4 |
|---|---|---|---|---|---|---|---|---|---|
| 366 | Te | Se | N | 0 | 0 | $CH_3$ | $CH_3$ | - | - |
| 367 | Te | Se | N | 0 | 0 | n-$C_{14}H_{29}$ | n-$C_{14}H_{29}$ | - | - |
| 368 | Te | Se | N | 0 | 0 | 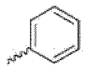 | 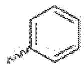 | - | - |
| 369 | Te | Se | N | 0 | 0 | 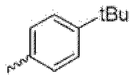 | 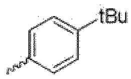 | - | - |
| 370 | Te | Se | N | 1 | 1 | $CH_3$ | $CH_3$ | $CH_3$ | $CH_3$ |

[Table 38]

| Specific Example | X | Y | Z | m | n | R1 | R2 | R3 | R4 |
|---|---|---|---|---|---|---|---|---|---|
| 371 | Te | Se | N | 0 | 0 | 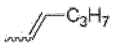 | 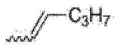 | - | - |
| 372 | Te | Se | N | 0 | 0 | $CH_3$ | $CH_3$ | - | - |
| 373 | Te | Se | N | 1 | 1 | 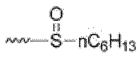 | 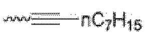 | $SCH_3$ | $SCH_3$ |
| 374 | Te | Se | N | 0 | 0 | 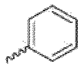 | n-$C_5H_{11}$ | | - |
| 375 | Te | Se | N | 2 | 2 | $CH_3$ | $CH_3$ | $CH_3$ | $CH_3$ |
| 376 | Te | CH | O | 0 | 0 | $CH_3$ | $CH_3$ | - | - |
| 377 | Te | CH | O | 0 | 0 | n-$C_{14}H_{29}$ | n-$C_{14}H_{29}$ | - | - |
| 378 | Te | CH | O | 0 | 0 | 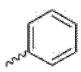 | 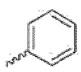 | - | - |
| 379 | Te | CH | O | 0 | 0 | 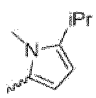 | 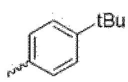 | - | - |
| 380 | Te | CH | S | 1 | 1 | H | H | n-$C_{14}H_{29}$ | n-$C_{14}H_{29}$ |

[Table 39]

| Specific Example | X | Y | Z | m | n | R1 | R1 | R3 | R4 |
|---|---|---|---|---|---|---|---|---|---|
| 381 | Te | C(n-$C_9H_{19}$) | S | 0 | 0 | 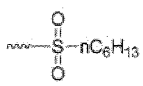 | 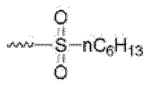 | - | - |

(continued)

| Specific Example | X | Y | Z | m | n | $R^1$ | $R^1$ | $R^3$ | $R^4$ |
|---|---|---|---|---|---|---|---|---|---|
| 382 | Te | C(n-$C_6H_{13}$) | S | 0 | 0 | $CH_3$ | $CH_3$ | - | - |
| 383 | Te | CH | S | 1 | 1 | 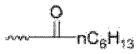 | $N(C_4H_9)_2$ | $OCH_3$ | $OCH_3$ |
| 384 | Te | CH | N($CH_3$) | 0 | 0 | 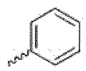 | n-$C_5H_{11}$ | - | - |
| 385 | Te | CH | N(n-C3H7) | 2 | 2 | $CH_3$ | $CH_3$ | $CH_3$ | $CH_3$ |
| 386 | Te | O | CH | 0 | 0 | $CH_3$ | $CH_3$ | - | - |
| 387 | Te | O | CH | 0 | 0 | n-$C_{14}H_{29}$ | n-$C_{14}H_{29}$ | - | - |
| 388 | Te | O | C(n-$C_9H_{19}$) | 0 | 0 | 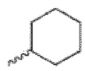 | 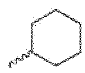 | - | - |
| 389 | Te | O | C(n-$C_6H_{13}$) | 0 | 0 | 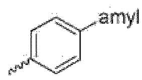 | 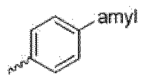 | - | - |
| 390 | Te | O | CH | 1 | 1 | $CH_3$ | $CH_3$ | $CH_3$ | $CH_3$ |

[Table 40]

| Specific Example | X | Y | Z | m | n | $R^1$ | $R^2$ | $R^3$ | $R^4$ |
|---|---|---|---|---|---|---|---|---|---|
| 391 | Te | O | CH | 0 | 0 | 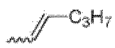 | 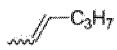 | - | - |
| 392 | Te | S | C(n-$C_9H_{19}$) | 0 | 0 | $CH_3$ | $CH_3$ | - | - |
| 393 | Te | S | C(n-$C_6H_{13}$) | 1 | 1 | 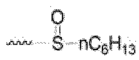 | 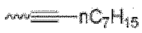 | $SCH_3$ | $SCH_3$ |
| 394 | Te | S | CH | 0 | 0 | 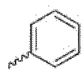 | n-$C_5H_{11}$ | - | - |
| 395 | Te | s | CH | 2 | 2 | $CH_3$ | $CH_3$ | $CH_3$ | $CH_3$ |
| 396 | Te | N | O | 0 | 0 | $CH_3$ | $CH_3$ | - | - |
| 397 | Te | N | O | 0 | 0 | n-$C_{14}H_{29}$ | n-$C_{14}H_{29}$ | - | - |
| 398 | Te | N | O | 0 | 0 | 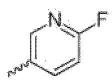 | 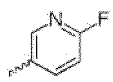 | - | - |
| 399 | Te | N | O | 0 | 0 | 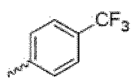 | 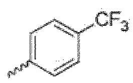 | - | - |
| 400 | Te | N | O | 1 | 1 | $CH_3$ | $CH_3$ | $CH_3$ | $CH_3$ |

[Table 41]

| Specific Example | X | Y | Z | m | n | R1 | R2 | R3 | R4 |
|---|---|---|---|---|---|---|---|---|---|
| 401 | Te | N | O | 0 | 0 | 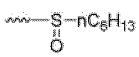 | 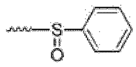 | - | - |
| 402 | Te | N | O | 0 | 0 | $CH_3$ | $CH_3$ | - | - |
| 403 | Te | N | O | 1 | 1 | 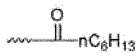 | 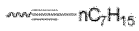 | $SCH_3$ | $SCH_3$ |
| 404 | Te | N | O | 0 | 0 | 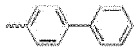 | $n-C_5H_{11}$ | - | - |
| 405 | Te | N | O | 2 | 2 | $CH_3$ | $CH_3$ | $CH_3$ | $CH_3$ |
| 406 | Te | N | s | 0 | 0 | $CH_3$ | $CH_3$ | - | - |
| 407 | Te | N | S | 0 | 0 | $n-C_9H_{19}$ | $n-C_9H_{19}$ | - | - |
| 408 | Te | N | S | 0 | 0 | 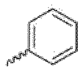 | 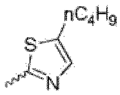 | - | - |
| 409 | Te | N | S | 0 | 0 | 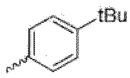 | 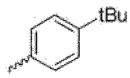 | - | - |
| 410 | Te | N | S | 1 | 1 | $CH_3$ | $CH_3$ | $CH_3$ | $CH_3$ |

[Table 42]

| Specific Example | X | Y | Z | m | n | R1 | R2 | R3 | R4 |
|---|---|---|---|---|---|---|---|---|---|
| 411 | Te | N | S | 0 | 0 | $S-nC_6H_{13}$ | $S-nC_6H_{13}$ | - | - |
| 412 | Te | N | S | 0 | 0 | $CH_3$ | $CH_3$ | - | - |
| 413 | Te | N | S | 1 | 2 | 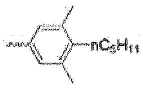 | 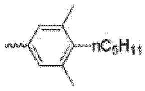 | $SCH_3$ | $SCH_3$ |
| 414 | Te | N | S | 0 | 0 | 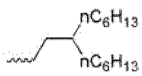 | $n-C_5H_{11}$ | - | - |
| 415 | Te | N | Se | 0 | 0 | $CH_3$ | $CH_3$ | - | - |
| 416 | Te | N | Se | 0 | 0 | $n-C_{14}H_{29}$ | $n-C_{14}H_{29}$ | - | - |
| 417 | Te | N | Se | 0 | 0 | 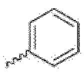 | 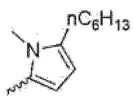 | - | - |
| 418 | Te | N | Se | 0 | 0 | 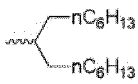 | 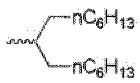 | - | - |
| 419 | Te | N | Se | 1 | 1 | H | H | $n-C_{14}H_{29}$ | $n-C_{14}H_{29}$ |

(continued)

| Specific Example | X | Y | Z | m | n | $R^1$ | $R^2$ | $R^3$ | $R^4$ |
|---|---|---|---|---|---|---|---|---|---|
| 420 | Te | N | Se | 0 | 0 | 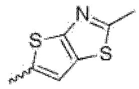 | 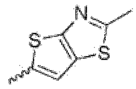 | - | - |

[Table 43]

| Specific Example | X | Y | Z | m | n | $R^1$ | $R^2$ | $R^3$ | $R^4$ |
|---|---|---|---|---|---|---|---|---|---|
| 421 | Te | N | Se | 0 | 0 | $CH_3$ | $CH_3$ | - | - |
| 422 | Te | N | Se | 1 | 1 | 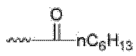 | $N(C_4H_9)_2$ | $OCH_3$ | $OCH_3$ |
| 423 | Te | N | Se | 0 | 0 | 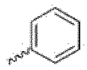 | $n$-$C_5H_{11}$ | - | - |
| 424 | Te | N | $N(CH_3)$ | 2 | 2 | $CH_3$ | $CH_3$ | $CH_3$ | $CH_3$ |
| 425 | Te | N | NH | 0 | 0 | $C_2H_5$ | $C_2H_5$ | - | - |
| 426 | Te | N | $N(CH_3)$ | 0 | 0 | $n$-$C_{14}H_{29}$ | $n$-$C_{14}H_{29}$ | - | - |
| 427 | Te | N | $N(CH_3)$ | 0 | 0 | 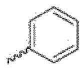 | 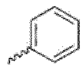 | - | - |
| 428 | Te | N | $N(CH_3)$ | 0 | 0 | 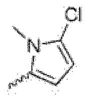 | 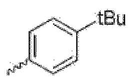 | - | - |
| 429 | Te | N | $N(CH_3)$ | 1 | 1 | H | H | $n$-$C_{14}H_{29}$ | $n$-$C_{14}H_{29}$ |
| 430 | Te | N | $N(n$-$C_9H_{19})$ | 0 | 0 | 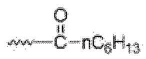 | 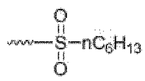 | - | - |

[Table 44]

| Specific Example | X | Y | Z | m | n | $R^1$ | $R^2$ | $R^3$ | $R^4$ |
|---|---|---|---|---|---|---|---|---|---|
| 431 | Te | N | $N(CH_3)$ | 0 | 0 | $CH_3$ | $CH_3$ | - | - |
| 432 | Te | N | N(i-Pr) | 1 | 1 | 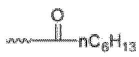 | $N(C_4H_9)_2$ | $OCH_3$ | $OCH_3$ |
| 433 | Te | N | $N(CH_3)$ | 0 | 0 | 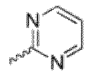 | $n$-$C_5H_{11}$ | - | - |
| 434 | Te | N | $N(CH_3)$ | 2 | 2 | $CH_3$ | $CH_3$ | $CH_3$ | $CH_3$ |
| 435 | Te | $N(CH_3)$ | N | 0 | 0 | $CH_3$ | $CH_3$ | - | - |
| 436 | Te | NH | N | 0 | 0 | $n$-$C_{14}H_{29}$ | $n$-$C_{14}H_{29}$ | - | - |
| 437 | Te | $N(CH_3)$ | N | 0 | 0 | 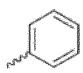 | 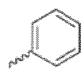 | - | - |

(continued)

| Specific Example | X | Y | Z | m | n | $R^1$ | $R^2$ | $R^3$ | $R^4$ |
|---|---|---|---|---|---|---|---|---|---|
| 438 | Te | $N(CH_3)$ | N | 0 | 0 | 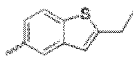 | 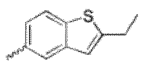 | - | - |
| 439 | Te | $N(CH_3)$ | N | 1 | 1 | 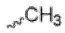 | 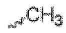 | 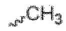 | 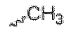 |
| 440 | Te | $N(CH_3)$ | N | 0 | 0 | 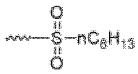 | 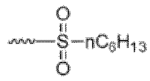 | - | - |

[Table 45]

| Specific Example | X | Y | Z | m | n | $R^1$ | $R^2$ | $R^3$ | $R^4$ |
|---|---|---|---|---|---|---|---|---|---|
| 441 | Te | $N(n-C_9H_{19})$ | N | 0 | 0 | 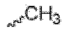 | 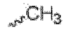 | - | - |
| 442 | Te | $N(CH_3)$ | N | 1 | 1 | 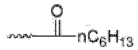 | 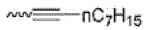 | 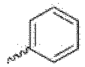 | 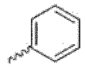 |
| 443 | Te | N(i-Pr) | N | 0 | 0 | 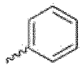 | 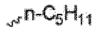 | - | - |
| 444 | Te | $N(CH_3)$ | N | 2 | 2 | 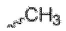 | 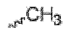 | 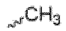 | 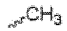 |
| 445 | Te | $N(CH_3)$ | CH | 0 | 0 | 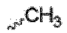 | 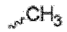 | - | - |
| 446 | Te | NH | CH | 0 | 0 | 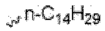 | 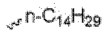 | - | - |
| 447 | Te | $N(CH_3)$ | CH | 0 | 0 | 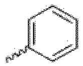 | 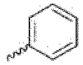 | - | - |
| 448 | Te | $N(CH_3)$ | CH | 0 | 0 | 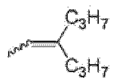 | 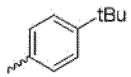 | - | - |
| 449 | Te | $N(CH_3)$ | CH | 1 | 1 | 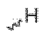 | 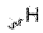 | 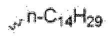 | 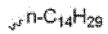 |
| 450 | Te | $N(CH_3)$ | $C(n-C_9H_{19})$ | 0 | 0 | 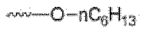 | 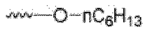 | - | - |

[Table 46]

| Specific Example | X | Y | Z | m | n | $R^1$ | $R^2$ | $R^3$ | $R^4$ |
|---|---|---|---|---|---|---|---|---|---|
| 451 | Te | N(n-$C_9H_{19}$) | C(n-$C_6H_{13}$) | 0 | 0 | $CH_3$ | $CH_3$ | - | - |
| 452 | Te | N($CH_3$) | CH | 1 | 1 | 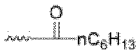 | $N(C_4H_9)_2$ | $OCH_3$ | $OCH_3$ |
| 453 | Te | N(i-Pr) | CH | 0 | 0 | 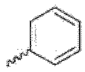 | n-$C_5H_{11}$ | - | - |
| 454 | Te | N($CH_3$) | CH | 2 | 2 | $CH_3$ | $CH_3$ | $CH_3$ | $CH_3$ |
| 455 | N($CH_3$) | CH | Se | 0 | 0 | $CH_3$ | $CH_3$ | - | - |
| 456 | NH | CH | Se | 0 | 0 | n-$C_{14}H_{29}$ | n-$C_{14}H_{29}$ | - | - |
| 457 | N($CH_3$) | CH | Se | 0 | 0 | 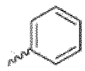 | 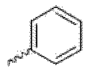 | - | - |
| 458 | N($CH_3$) | CH | Se | 0 | 0 | 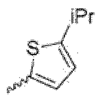 | 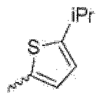 | - | - |
| 459 | N($CH_3$) | CH | Se | 1 | 1 | $CH_3$ | $CH_3$ | $CH_3$ | $CH_3$ |
| 460 | N($CH_3$) | C(n-$C_8H_{17}$) | Se | 0 | 0 | H | H | - | - |

[Table 47]

| Specific Example | X | Y | Z | m | n | $R^1$ | $R^2$ | $R^3$ | $R^4$ |
|---|---|---|---|---|---|---|---|---|---|
| 461 | N(n-$C_9H_{19}$) | C(n-$C_6H_{13}$) | Se | 0 | 0 | $CH_3$ | $CH_3$ | - | - |
| 462 | N($CH_3$) | CH | Se | 1 | 1 | 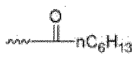 | $N(C_4H_9)_2$ | $OCH_3$ | $OCH_3$ |
| 463 | N(i-Pr) | CH | Se | 0 | 0 | 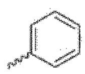 | n-$C_5H_{11}$ | - | - |
| 464 | N($CH_3$) | CH | Se | 2 | 2 | $CH_3$ | $CH_3$ | $CH_3$ | $CH_3$ |
| 465 | N($CH_3$) | O | N | 0 | 0 | $CH_3$ | $CH_3$ | - | - |
| 466 | NH | O | N | 0 | 0 | n-$C_{14}H_{29}$ | n-$C_{14}H_{29}$ | - | - |
| 467 | N($CH_3$) | O | N | 0 | 0 | 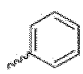 | 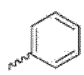 | - | - |
| 468 | N($CH_3$) | O | N | 0 | 0 | 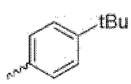 | 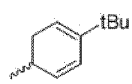 | - | - |
| 469 | N($CH_3$) | O | N | 1 | 1 | $CH_3$ | $CH_3$ | $CH_3$ | $CH_3$ |

(continued)

| Specific Example | X | Y | Z | m | n | $R^1$ | $R^2$ | $R^3$ | $R^4$ |
|---|---|---|---|---|---|---|---|---|---|
| 470 | N($CH_3$) | O | N | 0 | 0 | 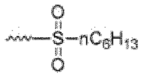 | 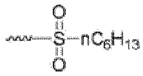 | - | - |

[Table 48]

| Specific Example | X | Y | Z | m | n | $R^1$ | $R^2$ | $R^3$ | $R^4$ |
|---|---|---|---|---|---|---|---|---|---|
| 471 | N(n-$C_9H_{19}$) | O | N | 0 | 0 | 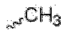 | 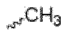 | - | - |
| 472 | N($CH_3$) | O | N | 1 | 1 | 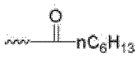 | 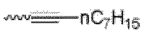 | 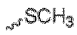 | 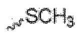 |
| 473 | N(i-Pr) | O | N | 0 | 0 | 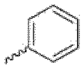 | 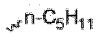 | - | - |
| 474 | N($CH_3$) | O | N | 2 | 2 | 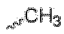 | 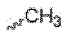 | 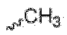 | 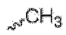 |
| 475 | N($CH_3$) | S | N | 0 | 0 | 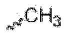 | 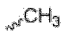 | - | - |
| 476 | NH | S | N | 0 | 0 | 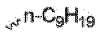 | 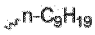 | - | - |
| 477 | N($CH_3$) | S | N | 0 | 0 | 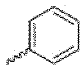 | 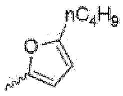 | - | - |
| 478 | N($CH_3$) | S | N | 0 | 0 | 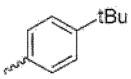 | 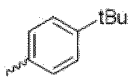 | - | - |
| 479 | N($CH_3$) | S | N | 1 | 1 | 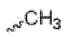 | 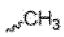 | 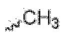 | 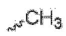 |
| 480 | N($CH_3$) | S | N | 0 | 0 | 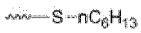 | 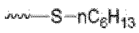 | - | - |

[Table 49]

| Specific Example | X | Y | Z | m | n | $R^1$ | $R^2$ | $R^3$ | $R^4$ |
|---|---|---|---|---|---|---|---|---|---|
| 481 | $N(n-C_9H_{19})$ | S | N | 0 | 0 | 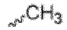 | 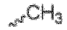 | - | - |
| 482 | $N(CH_3)$ | S | N | 1 | 1 | 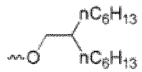 | 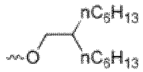 | 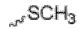 | 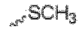 |
| 483 | N(i-Pr) | S | N | 0 | 0 | 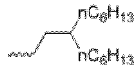 | 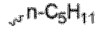 | - | - |
| 484 | $N(CH_3)$ | S | N | 2 | 2 | 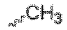 | 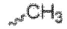 | 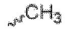 | 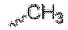 |
| 485 | $N(CH_3)$ | Se | CH | 0 | 0 | 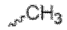 | 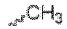 | - | - |
| 486 | NH | Se | CH | 0 | 0 | 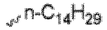 | 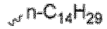 | - | - |
| 487 | $N(CH_3)$ | Se | CH | 0 | 0 | 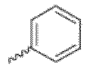 | 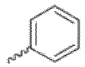 | - | - |
| 488 | $N(CH_3)$ | Se | CH | 0 | 0 | 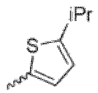 | 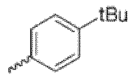 | - | - |
| 489 | $N(CH_3)$ | Se | CH | 1 | 1 | 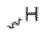 | 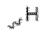 | 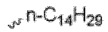 | 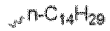 |
| 490 | $N(CH_3)$ | Se | $C(n-C_9H_{19})$ | 0 | 0 | 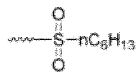 | 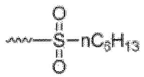 | - | - |

[Table 50]

| Specific Example | X | Y | Z | m | n | R¹ | R² | R³ | R⁴ |
|---|---|---|---|---|---|---|---|---|---|
| 491 | $N(n\text{-}C_9H_{19})$ | Se | $C(n\text{-}C_6H_{13})$ | 0 | 0 | $CH_3$ | $CH_3$ | - | - |
| 492 | $N(CH_3)$ | Se | CH | 1 | 1 | 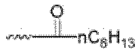 | $N(C_4H_9)_2$ | $OCH_3$ | $OCH_3$ |
| 493 | NH | Se | CH | 0 | 0 | 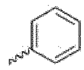 | $n\text{-}C_5H_{11}$ | - | - |
| 494 | $N(CH_3)$ | Se | CH | 2 | 2 | $CH_3$ | $CH_3$ | $CH_3$ | $CH_3$ |
| 495 | $N(CH_3)$ | Se | N | 0 | 0 | $CH_3$ | $CH_3$ | - | - |
| 496 | $N(CH_3)$ | Se | N | 0 | 0 | $n\text{-}C_{14}H_{29}$ | $n\text{-}C_{14}H_{29}$ | - | - |
| 497 | $N(CH_3)$ | Se | N | 0 | 0 | 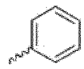 | 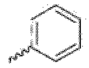 | - | - |
| 498 | $N(n\text{-}C_9H_{19})$ | Se | N | 0 | 0 | 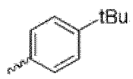 | 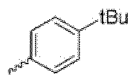 | - | - |
| 499 | $N(CH_3)$ | Se | N | 1 | 1 | $CH_3$ | $CH_3$ | $CH_3$ | $CH_3$ |
| 500 | N(i-Pr) | Se | N | 0 | 0 | 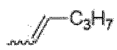 | 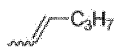 | - | - |

[Table 51]

| Specific Example | X | Y | Z | m | n | R¹ | R² | R³ | R⁴ |
|---|---|---|---|---|---|---|---|---|---|
| 501 | $N(CH_3)$ | Se | N | 0 | 0 | $CH_3$ | $CH_3$ | - | - |
| 502 | $N(CH_3)$ | Se | N | 1 | 1 | 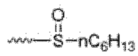 | 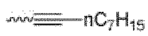 | $SCH_3$ | $SCH_3$ |
| 503 | NH | Se | N | 0 | 0 | 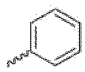 | $n\text{-}C_5H_{11}$ | - | - |
| 504 | $N(CH_3)$ | Se | N | 2 | 2 | $CH_3$ | $CH_3$ | $CH_3$ | $CH_3$ |
| 505 | $N(CH_3)$ | CH | O | 0 | 0 | $CH_3$ | $CH_3$ | - | - |
| 506 | $N(CH_3)$ | CH | O | 0 | 0 | $n\text{-}C_{14}H_{29}$ | $n\text{-}C_{14}H_{29}$ | - | - |
| 507 | $N(CH_3)$ | CH | O | 0 | 0 | 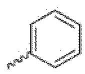 | 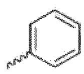 | - | - |
| 508 | NH | CH | O | 0 | 0 | 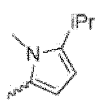 | 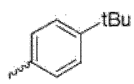 | - | - |
| 509 | $N(CH_3)$ | CH | S | 1 | 1 | $CH_3$ | $CH_3$ | $n\text{-}C_{14}H_{29}$ | $n\text{-}C_{14}H_{29}$ |
| 510 | $N(CH_3)$ | $C(n\text{-}C_9H_{19})$ | S | 0 | 0 | 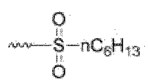 | 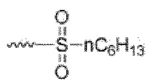 | - | - |

[Table 52]

| Specific Example | X | Y | Z | m | n | $R^1$ | $R^2$ | $R^3$ | $R^4$ |
|---|---|---|---|---|---|---|---|---|---|
| 511 | $N(CH_3)$ | C(n-$C_6H_{13}$) | S | 0 | 0 | $CH_3$ | $CH_3$ | - | - |
| 512 | $N(CH_3)$ | CH | S | 1 | 1 | 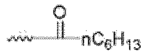 | $N(C_4H_9)_2$ | $OCH_3$ | $OCH_3$ |
| 513 | N(n-$C_9H_{19}$) | CH | $N(CH_3)$ | 0 | 0 | 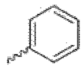 | n-$C_5H_{11}$ | - | - |
| 514 | $N(CH_3)$ | CH | N(n-C3H7) | 2 | 2 | $CH_3$ | $CH_3$ | $CH_3$ | $CH_3$ |
| 515 | N(i-Pr) | O | CH | 0 | 0 | $CH_3$ | $CH_3$ | - | - |
| 516 | $N(CH_3)$ | O | CH | 0 | 0 | n-$C_{14}H_{29}$ | n-$C_{14}H_{29}$ | - | - |
| 517 | $N(CH_3)$ | O | C(n-$C_9H_{19}$) | 0 | 0 | 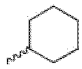 | 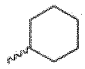 | - | - |
| 518 | NH | O | C(n-$C_6H_{13}$) | 0 | 0 | 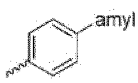 | 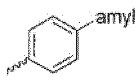 | - | - |
| 519 | $N(CH_3)$ | O | CH | 1 | 1 | $CH_3$ | $CH_3$ | $CH_3$ | $CH_3$ |
| 520 | $N(CH_3)$ | O | CH | 0 | 0 | 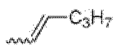 | 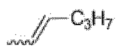 | - | - |

[Table 53]

| Specific Example | X | Y | Z | m | n | $R^1$ | $R^2$ | $R^3$ | $R^4$ |
|---|---|---|---|---|---|---|---|---|---|
| 521 | $N(CH_3)$ | S | C(n-$C_9H_{19}$) | 0 | 0 | $CH_3$ | $CH_3$ | - | - |
| 522 | $N(CH_3)$ | S | C(n-$C_6H_{13}$) | 1 | 1 | 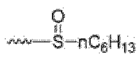 | 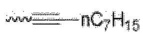 | $SCH_3$ | $SCH_3$ |
| 523 | N(n-$C_9H_{19}$) | S | CH | 0 | 0 | 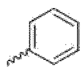 | n-$C_5H_{11}$ | - | - |
| 524 | $N(CH_3)$ | S | CH | 2 | 2 | $CH_3$ | $CH_3$ | $CH_3$ | $CH_3$ |
| 525 | N(i-Pr) | N | S | 0 | 0 | $CH_3$ | $CH_3$ | - | - |
| 526 | $N(CH_3)$ | N | S | 0 | 0 | n-$C_{14}H_{29}$ | n-$C_{14}H_{29}$ | - | - |
| 527 | $N(CH_3)$ | N | S | 0 | 0 | 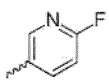 | 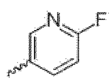 | - | - |
| 528 | NH | N | S | 0 | 0 | 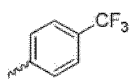 | 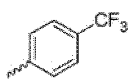 | - | - |

(continued)

| Specific Example | X | Y | Z | m | n | $R^1$ | $R^2$ | $R^3$ | $R^4$ |
|---|---|---|---|---|---|---|---|---|---|
| 529 | $N(CH_3)$ | N | S | 1 | 1 | $CH_3$ | $CH_3$ | $CH_3$ | $CH_3$ |
| 530 | $N(CH_3)$ | N | S | 0 | 0 | 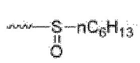 | 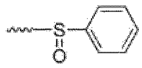 | - | - |

[Table 54]

| Specific Example | x | Y | Z | m | n | $R^1$ | $R^2$ | $R^3$ | $R^4$ |
|---|---|---|---|---|---|---|---|---|---|
| 531 | $N(CH_3)$ | N | S | 0 | 0 | $CH_3$ | $CH_3$ | - | - |
| 532 | $N(CH_3)$ | N | S | 1 | 1 | 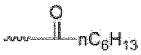 | $\equiv$ $nC_7H_{15}$ | $SCH_3$ | $SCH_3$ |
| 533 | $N(n\text{-}C_9H_{19})$ | N | S | 0 | 0 | 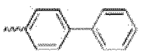 | $n\text{-}C_5H_{11}$ | - | - |
| 534 | $N(CH_3)$ | N | S | 2 | 2 | $CH_3$ | $CH_3$ | $CH_3$ | $CH_3$ |
| 535 | N(i-Pr) | N | O | 0 | 0 | $CH_3$ | $CH_3$ | - | - |
| 536 | $N(CH_3)$ | N | O | 0 | 0 | $n\text{-}C_9H_{19}$ | $n\text{-}C_9H_{19}$ | - | - |
| 537 | $N(CH_3)$ | N | O | 0 | 0 | 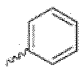 | 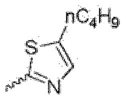 | - | - |
| 538 | NH | N | O | 0 | 0 | 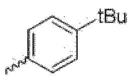 | 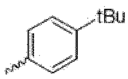 | - | - |
| 539 | $N(CH_3)$ | N | O | 1 | 1 | $CH_3$ | $CH_3$ | $CH_3$ | $CH_3$ |
| 540 | $N(CH_3)$ | N | O | 0 | 0 | $S\text{-}nC_6H_{13}$ | $S\text{-}nC_6H_{13}$ | - | - |

[Table 55]

| Specific Example | X | Y | Z | m | n | $R^1$ | $R^2$ | $R^3$ | $R^4$ |
|---|---|---|---|---|---|---|---|---|---|
| 541 | $N(CH_3)$ | N | O | 0 | 0 | $CH_3$ | $CH_3$ | - | - |
| 542 | $N(CH_3)$ | N | O | 1 | 2 | 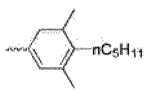 | 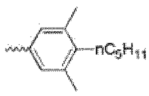 | $SCH_3$ | $SCH_3$ |
| 543 | $N(n\text{-}C_9H_{19})$ | N | O | 0 | 0 | 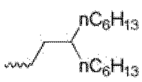 | $n\text{-}C_5H_{11}$ | - | - |
| 544 | $N(CH_3)$ | N | Se | 0 | 0 | $CH_3$ | $CH_3$ | - | - |
| 545 | N(i-Pr) | N | Se | 0 | 0 | $n\text{-}C_{14}H_{29}$ | $n\text{-}C_{14}H_{29}$ | - | - |
| 546 | $N(CH_3)$ | N | Se | 0 | 0 | 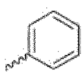 | 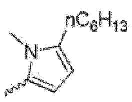 | - | - |

(continued)

| Specific Example | X | Y | Z | m | n | $R^1$ | $R^2$ | $R^3$ | $R^4$ |
|---|---|---|---|---|---|---|---|---|---|
| 547 | $N(CH_3)$ | N | Se | 0 | 0 | 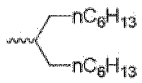 | 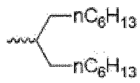 | - | - |
| 548 | NH | N | Se | 1 | 1 | H | H | $n-C_{14}H_{29}$ | $n-C_{14}H_{29}$ |
| 549 | $N(CH_3)$ | N | Se | 0 | 0 | 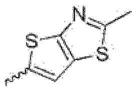 | 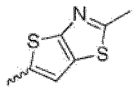 | - | - |
| 550 | $N(CH_3)$ | N | Se | 0 | 0 | $CH_3$ | $CH_3$ | - | - |

[Table 56]

| Specific Example | X | Y | Z | m | n | $R^1$ | $R^2$ | $R^3$ | $R^4$ |
|---|---|---|---|---|---|---|---|---|---|
| 551 | $N(CH_3)$ | N | Se | 1 | 1 | 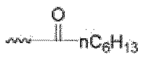 | $N(C_4H_9)_2$ | $OCH_3$ | $OCH_3$ |
| 552 | $N(CH_3)$ | N | Se | 0 | 0 | 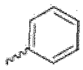 | $n-C_5H_{11}$ | - | - |
| 553 | $M(n-C_9H_{19})$ | N | $N(CH_3)$ | 2 | 2 | $CH_3$ | $CH_3$ | $CH_3$ | $CH_3$ |
| 554 | $N(CH_3)$ | N | NH | 0 | 0 | $C_2H_5$ | $C_2H_5$ | - | - |
| 555 | N(i-Pr) | N | $N(CH_3)$ | 0 | 0 | $n-C_{14}H_{29}$ | $n-C_{14}H_{29}$ | - | - |
| 556 | $N(CH_3)$ | N | $N(CH_3)$ | 0 | 0 | 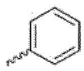 | 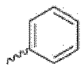 | - | - |
| 557 | $N(CH_3)$ | N | $N(CH_3)$ | 0 | 0 | 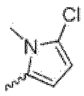 | 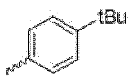 | - | - |
| 558 | NH | N | $N(CH_3)$ | 1 | 1 | H | H | $n-C_{14}H_{29}$ | $n-C_{14}H_{29}$ |
| 559 | $N(CH_3)$ | N | $N(n-C_9H_{19})$ | 0 | 0 | 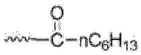 | 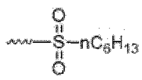 | - | - |
| 560 | $N(CH_3)$ | N | $N(CH_3)$ | 0 | 0 | $CH_3$ | $CH_3$ | - | - |

[Table 57]

| Specific Example | X | Y | Z | m | n | $R^1$ | $R^2$ | $R^3$ | $R^4$ |
|---|---|---|---|---|---|---|---|---|---|
| 561 | $N(CH_3)$ | N | N(i-Pr) | 1 | 1 | 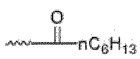 | $N(C_4H_9)_2$ | $OCH_3$ | $OCH_3$ |
| 562 | $N(CH_3)$ | N | $N(CH_3)$ | 0 | 0 | 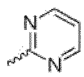 | $n-C_5H_{11}$ | - | - |

(continued)

| Specific Example | X | Y | Z | m | n | $R^1$ | $R^2$ | $R^3$ | $R^4$ |
|---|---|---|---|---|---|---|---|---|---|
| 563 | $N(n-C_9H_{19})$ | N | $N(CH_3)$ | 2 | 2 | $CH_3$ | $CH_3$ | $CH_3$ | $CH_3$ |
| 564 | $N(CH_3)$ | $N(CH_3)$ | N | 0 | 0 | $CH_3$ | $CH_3$ | - | - |
| 565 | $N(CH_3)$ | NH | N | 0 | 0 | $n-C_{14}H_{29}$ | $n-C_{14}H_{29}$ | - | - |
| 566 | NH | $N(CH_3)$ | N | 0 | 0 | 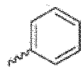 | 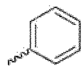 | - | - |
| 567 | $N(CH_3)$ | $N(CH_3)$ | N | 0 | 0 | 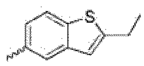 | 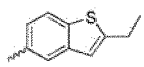 | - | - |
| 568 | $N(CH_3)$ | $N(CH_3)$ | N | 1 | 1 | $CH_3$ | $CH_3$ | $CH_3$ | $CH_3$ |
| 569 | $N(CH_3)$ | $N(CH_3)$ | N | 0 | 0 | 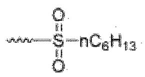 | 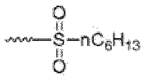 | - | - |
| 570 | $N(CH_3)$ | $N(n-c_9H_{19})$ | N | 0 | 0 | $CH_3$ | $CH_3$ | - | - |

[Table 58]

| Specific Example | X | Y | Z | m | n | $R^1$ | $R^2$ | $R^3$ | $R^4$ |
|---|---|---|---|---|---|---|---|---|---|
| 571 | $N(n\text{-}C_9H_{19})$ | $N(CH_3)$ | N | 1 | 1 | 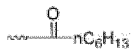 | 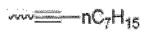 | 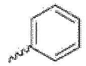 | 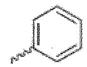 |
| 572 | $N(CH_3)$ | N(i-Pr) | N | 0 | 0 | 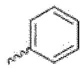 | 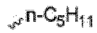 | - | - |
| 573 | N(i-Pr) | $N(CH_3)$ | N | 2 | 2 | 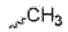 | 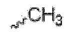 | 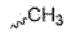 | 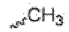 |
| 574 | $N(CH_3)$ | $N(CH_3)$ | CH | 0 | 0 | 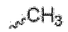 | 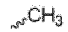 | - | - |
| 575 | $N(CH_3)$ | NH | CH | 0 | 0 | 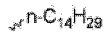 | 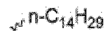 | - | - |
| 576 | NH | $N(CH_3)$ | CH | 0 | 0 | 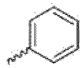 | 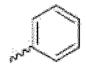 | - | - |
| 577 | $N(CH_3)$ | $N(CH_3)$ | CH | 0 | 0 | 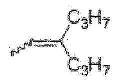 | 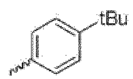 | - | - |
| 578 | $N(CH_3)$ | $N(CH_3)$ | CH | 1 | 1 | 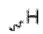 | 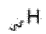 | 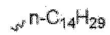 | 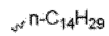 |
| 579 | $N(CH_3)$ | $N(CH_3)$ | $C(n\text{-}C_9H_{19})$ | 0 | 0 | 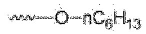 | 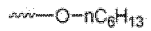 | - | - |
| 580 | $N(CH_3)$ | $N(n\text{-}C_9H_{19})$ | $C(n\text{-}C_6H_{13})$ | 0 | 0 | 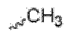 | 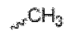 | - | - |

[Table 59]

| Specific Example | X | Y | Z | m | n | $R^1$ | $R^2$ | $R^3$ | $R^4$ |
|---|---|---|---|---|---|---|---|---|---|
| 581 | $N(n\text{-}C_9H_{19})$ | $N(CH_3)$ | CH | 1 | 1 | 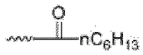 | $N(C_4H_9)_2$ | $OCH_3$ | $OCH_3$ |
| 582 | $N(CH_3)$ | N(i-Pr) | CH | 0 | 0 | 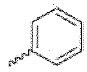 | $n\text{-}C_5H_{11}$ | - | - |
| 583 | N(i-Pr) | $N(CH_3)$ | CH | 2 | 2 | $CH_3$ | $CH_3$ | $CH_3$ | $CH_3$ |
| 584 | S | CH | S | 0 | 0 | $CH_3$ | $CH_3$ | - | - |
| 585 | S | CH | S | 0 | 0 | $n\text{-}C_9H_{19}$ | $n\text{-}C_9H_{19}$ | - | - |
| 586 | S | CH | S | 0 | 0 | $n\text{-}C_3H_7$ | $n\text{-}C_3H_7$ | - | - |
| 587 | S | CH | S | 0 | 0 | $n\text{-}C_4H_9$ | $n\text{-}C_4H_9$ | - | - |
| 588 | S | CH | S | 0 | 0 | $n\text{-}C_5H_{11}$ | $n\text{-}C_5H_{11}$ | - | - |
| 589 | S | CH | S | 0 | 0 | $n\text{-}C_8H_{17}$ | $n\text{-}C_8H_{17}$ | - | - |
| 590 | S | CH | S | 0 | 0 | $n\text{-}C_{10}H_{21}$ | $n\text{-}C_{10}H_{21}$ | - | - |

[Table 60]

| Specific Example | X | Y | Z | m | n | R1 | R2 | R3 | R4 |
|---|---|---|---|---|---|---|---|---|---|
| 591 | S | CH | S | 0 | 0 | $n\text{-}C_{13}H_{27}$ | $n\text{-}C_{13}H_{27}$ | - | - |
| 592 | S | CH | S | 0 | 0 | $n\text{-}C_4H_9$ | $n\text{-}C_5H_{11}$ | - | - |
| 593 | S | CH | S | 0 | 0 | $n\text{-}C_4H_9$ | $n\text{-}C_8H_{17}$ | - | - |
| 594 | S | CH | S | 0 | 0 | $n\text{-}C_4H_9$ | $n\text{-}C_{10}H_{21}$ | - | - |
| 595 | S | CH | S | 0 | 0 | $n\text{-}C_5H_{11}$ | $n\text{-}C_8H_{17}$ | - | - |
| 596 | S | CH | S | 0 | 0 | $n\text{-}C_8H_{17}$ | $n\text{-}C_{10}H_{21}$ | - | - |
| 597 | S | CH | S | 0 | 0 | $n\text{-}C_{10}H_{21}$ | $n\text{-}C_3H_7$ | - | - |
| 598 | S | CH | S | 0 | 0 | 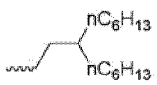 | 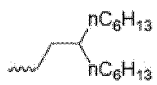 | - | - |
| 599 | S | CH | S | 0 | 0 | i-Pr | i-Pr | - | - |
| 600 | S | CH | S | 0 | 0 | t-Bu | $n\text{-}C_3H_7$ | - | - |
| 601 | S | CH | S | 0 | 0 | 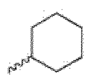 | $n\text{-}C_3H_7$ | - | - |
| 602 | O | CH | Se | 1 | 1 | $n\text{-}C_{10}H_{21}$ | $n\text{-}C_{10}H_{21}$ | F | F |
| 603 | O | CH | Se | 1 | 1 | $n\text{-}C_{10}H_{21}$ | $n\text{-}C_{10}H_{21}$ | Cl | Cl |

Next, an overall configuration of the organic semiconductor transistor according to the embodiment of the present invention will be described.

[Organic Semiconductor Transistor]

The organic semiconductor transistor according to the embodiment of the present invention (hereinafter, also referred to as "transistor according to the embodiment of the present invention") is a bottom gate type organic semiconductor transistor in which an organic semiconductor layer is formed using a film including the compound represented by Formula (1) that has a molecular weight of 3000 or lower. The organic semiconductor transistor according to the embodiment of the present invention includes: a gate electrode; the organic semiconductor layer; a gate insulating layer that is provided between the gate electrode and the organic semiconductor layer; and a source electrode and a drain electrode that are provided adjacent to the organic semiconductor layer and are linked to each other through the organic semiconductor layer. Typically, the gate electrode is provided on the substrate. The surface free energy of the surface Os of the gate insulating layer positioned on the organic semiconductor layer side is 20 to 50 mN/m, and the surface roughness Ra of the surface Os is 2 nm or lower.

In a case where the transistor according to the embodiment of the present invention is a bottom gate type including the above-described respective configurations, the structure thereof is not particularly limited. For example, the transistor according to the embodiment of the present invention may have any structure of a bottom contact type (bottom gate-bottom contact type) or a top contact type (bottom gate-top contact type).

Hereinafter, an example of the transistor according to the embodiment of the present invention and a method of manufacturing the same will be described with reference to the accompanying drawings.

(Bottom Gate-Bottom Contact Type)

Fig. 1 is schematic cross-sectional view showing a bottom gate-bottom contact type organic semiconductor transistor 100 that is an example of the film transistor according to an embodiment of the present invention.

As shown in Fig. 1, the organic semiconductor transistor 100 includes a substrate (base material) 10, a gate electrode 20, a gate insulating layer 30, a source electrode 40 and a drain electrode 42, an organic semiconductor layer 50, and a sealing layer 60 in this order.

Hereinafter, the substrate (base material), the gate electrode, the gate insulating layer (film), the source electrode, the drain electrode, the organic semiconductor layer (film), and the sealing layer, and preparation methods thereof will be described in detail.

-Substrate-

The substrate functions to support the gate electrode, the source electrode, the drain electrode, and the like described below.

The kind of the substrate is not particularly limited, and examples thereof include a plastic substrate, a silicon substrate, a glass substrate, and a ceramic substrate. In particular, from the viewpoints of versatility, applicability to each device and costs, a silicon substrate, a glass substrate, or a plastic substrate is preferable.

The thickness of the substrate is not particularly limited and is, for example, preferably 10 mm or less, more preferably 2 mm or less, and still more preferably 1.5 mm or less. On the other hand, the thickness of the substrate is preferably 0.01 mm or more and more preferably 0.05 mm or more.

-Gate Electrode-

As the gate electrode, a typical electrode that is used as a gate electrode of an organic TFT element can be used without any particular limitation.

A material (electrode material) which forms the gate electrode is not particularly limited, and examples thereof include: a metal such as gold, silver, aluminum, copper, chromium, nickel, cobalt, titanium, platinum, magnesium, calcium, barium, or sodium; a conductive oxide such as $InO_2$, $SnO_2$, or indium tin oxide (ITO); a conductive polymer such as polyaniline, polypyrrole, polythiophene, polyacetylene, or polydiacetylene; a semiconductor such as silicon, germanium, or gallium-arsenic; and a carbon material such as fullerene, carbon nanotube, or graphite. Among these, the metal is preferable, and silver or aluminum is more preferable.

The thickness of the gate electrode is not particularly limited and is preferably 20 to 200 nm.

The gate electrode may function as the substrate such as a silicon substrate. In this case, the substrate is not necessarily provided.

A method of forming the gate electrode is not particularly limited, and examples thereof include a method of

performing vacuum deposition (hereinafter, simply referred to as "vapor deposition") or sputtering on the substrate using the above-described electrode material and a method of applying or printing an electrode-forming composition including the above-described electrode material. In addition, in a case where an electrode is patterned, examples of a patterning method include a printing method such as ink jet printing, screen printing, offset printing, or relief printing (flexographic printing); a photolithography method, and a mask deposition method.

-Gate Insulating Layer-

The gate insulating layer is not particularly limited as long as it is an insulating layer provided between the gate electrode and the organic semiconductor layer, and may have a single-layer structure or a multi-layer structure.

It is preferable that the gate insulating layer is formed of an insulating material, and preferable examples of the insulating material include an organic material such as an organic polymer and an inorganic material such as an inorganic oxide. From the viewpoint of handleability, in a case where a plastic substrate or a glass substrate is used, it is preferable that an organic material is used.

The organic polymer, the inorganic oxide, or the like is not particularly limited as long as it has insulating characteristics, and an organic polymer or an inorganic oxide with which a thin film, for example, a thin film having a thickness of 1 μm or less can be formed is preferable.

As the organic polymer or the inorganic oxide, one kind may be used alone, and two or more kinds may be used in combination. In addition, the gate insulating layer may be a hybrid layer formed of a mixture of the organic polymer and the inorganic oxide described below.

The organic polymer is not particularly limited, and examples thereof include: a poly(meth)acrylate such as polyvinyl phenol, polystyrene (PS), or polymethyl methacrylate; a cyclic fluoroalkyl polymer such as polyvinyl alcohol, polyvinyl chloride (PVC), polyvinylidene fluoride (PVDF), polytetrafluoroethylene (PTFE), or CYTOP; a polyorganosiloxane such as polycycloolefin, polyester, polyethersulfone, polyether ketone, polyimide, poly(meth)acrylic acid, polybenzoxazole, an epoxy resin, or polydimethylsiloxane (PDMS); polysilsesquioxane; and butadiene rubber. In addition to the above-described examples, a thermosetting resin such as a phenolic resin, a novolac resin, a cinnamate resin, an acrylic resin, or a polyparaxylylene resin may also be used.

The organic polymer can also be used in combination with a compound having a reactive substituent such as an alkoxysilyl group, a vinyl group, an acryloyloxy group, an epoxy group, or a methylol group.

In a case where the gate insulating layer is formed of the organic polymer, it is preferable that the organic polymer is crosslinked and cured, for example, in order to improve solvent resistance or insulation resistance of the gate insulating layer. It is preferable that crosslinking is performed by generating an acid or a radical using either or both light and heat.

In a case where the organic polymer is crosslinked by a radical, as a radical generator that generates a radical using light or heat, for example, a thermal polymerization initiator (H1) and a photopolymerization initiator (H2) described in paragraphs "0182" to "0186" of JP2013-214649A, a photoradical generator described in paragraphs "0046" to "0051" of JP2011-186069A, or a photoradical polymerization initiator described in paragraphs "0042" to "0056" of JP2010-285518A can be preferably used, the contents of which are preferably incorporated herein by reference.

In addition, "a compound (G) having a number-average molecular weight (Mn) of 140 to 5000, having a crosslinking functional group, and not having a fluorine atom" which is described in paragraphs "0167" to "0177" of JP2013-214649A can also be preferably used, the contents of which are incorporated herein by reference.

In a case where the organic polymer is crosslinked by an acid, as a photoacid generator that generates an acid using light, for example, a photocationic polymerization initiator described in paragraphs "0033" and "0034" of JP2010-285518A or an acid generator, in particular, a sulfonium salt or an iodonium salt described in paragraphs "0120" to "0136" of JP2012-163946A can be preferably used, the contents of which are preferably incorporated herein by reference.

As a thermal acid generator (catalyst) that generates an acid using heat, for example, a thermal cationic polymerization initiator, in particular, an onium salt or the like described in paragraphs "0035" to "0038" of JP2010-285518A or a catalyst, in particular, a sulfonic acid or a sulfonic acid amine salt described in paragraphs "0034" and "0035" of JP2005-354012A can be preferably used, the contents of which are preferably incorporated herein by reference.

In addition, a crosslinking agent, in particular, a bifunctional or higher epoxy compound or oxetane compound described in paragraphs "0032" and "0033" of JP2005-354012A, a crosslinking agent, in particular, a compound having two or more crosslinking groups at least one of which is a methylol group or an NH group described in paragraphs "0046" to "0062" of JP2006-303465A, or a compound having two or more hydroxymethyl groups or alkoxymethyl groups in a molecule described in paragraphs "0137" to "0145" of JP2012-163946A is also preferably used, the contents of which are preferably incorporated herein by reference.

Examples of forming the gate insulating layer using the organic polymer include a method of applying and

curing the organic polymer. A coating method is not particularly limited, and examples thereof include the above-described printing methods. Among these, a wet coating method such as a microgravure coating method, a dip coating method, a screen coating printing method, a die coating method, or a spin coating method is preferable.

The inorganic oxide is not particularly limited, and examples thereof include: an oxide such as silicon oxide, silicon nitride ($SiN_Y$), hafnium oxide, titanium oxide, tantalum oxide, aluminum oxide, niobium oxide, zirconium oxide, copper oxide, or nickel oxide; a compound having a perovskite structure such as $SrTiO_3$, $CaTiO_3$, $BaTiO_3$, $MgTiO_3$, or $SrNb_2O_6$; and a composite oxide or a mixture thereof. Examples of the silicon oxide include silicon oxide ($SiO_X$), boron phosphorus silicon glass (BPSG), phosphorus silicon glass (PSG), borosilicate glass (BSG), arsenic silicate glass (AsSG), lead silicate glass (PbSG), silicon nitride oxide (SiON), spin-on-glass (SOG), and a low dielectric constant $SiO_2$ material (for example, polyarylether, a cycloperfluorocarbon polymer, benzocyclobutene, a cyclic fluororesin, polytetrafluoroethylene, fluorinated aryl ether, fluorinated polyimide, amorphous carbon, or organic SOG).

A method of forming the gate insulating layer using the inorganic oxide is not particularly limited. For example, a vacuum film formation method such as a vacuum deposition method, a sputtering method, or an ion plating or chemical vapor deposition (CVD) method can be used. In addition, the film formation may be assisted with plasma using predetermined gas, an ion gun, or a radical gun.

In addition, the gate insulating layer may also be formed by causing a precursor corresponding to each of metal oxides, specifically, a metal halide such as a chloride or a bromide, a metal alkoxide, a metal hydroxide, or the like is to react with an acid such as hydrochloric acid, sulfuric acid, or nitric acid or a base such as sodium hydroxide or potassium hydroxide in alcohol or water for hydrolysis. In a case where the solution-based process is used, the wet coating method can be used.

In addition to the above-described method, the gate insulating layer can also be formed optionally using a combination of any one of a lift-off method, a sol-gel method, an electrodeposition method, or a shadow mask method with a patterning method can also be optionally used.

The gate insulating layer may undergo a surface treatment such as a corona treatment, a plasma treatment, or an ultraviolet (UV)/ozone treatment.

In the present invention, the surface free energy of the surface Os of the gate insulating layer is 20 mN/m to 50 mN/m. By adjusting the surface free energy of the surface Os to be 20 mN/m to 50 mN/m, although the reason is not clear yet, it is presumed that, for example, charge induction in an interface is smooth, a variation in performance between transistor elements can be effectively suppressed, and a threshold voltage can also be suppressed. The surface free energy of the surface Os is preferably 30 to 50 mN/m and more preferably 35 to 50 mN/m.

The surface free energy can be measured using a well-known method. That is, the surface free energy can be obtained by measuring the contact angle of the film with both water and diiodomethane and substituting the measured values to the following Owen's equation (in the following description, a case where diiodomethane ($Ch_2I_2$) is used as an organic solvent is assumed).

Owen's Equation

$$1+\cos\theta_{H2O}=2(\gamma_S{}^d)^{1/2}(\gamma_{H2O}{}^d)^{1/2}/\gamma_{H2O,V}+2(\gamma_S{}^h)^{1/2}(\gamma_{H2O}{}^h)^{1/2}/\gamma_{H2O,V}$$

$$1+\cos\theta_{CH2I2}=2(\gamma_S{}^d)^{1/2}(\gamma_{CH2I2}{}^d)^{1/2}/\gamma_{CH2I2,V}+2(\gamma_S{}^h)^{1/2}(\gamma_{CH2I2}{}^h)^{1/2}/\gamma_{CH2I2,V}$$

Here, $\gamma_{H2O}{}^d$=21.8, $\gamma_{CH2I2}{}^d$=49.5, $\gamma_{H2O}{}^h$=51.0, $\gamma_{CH2I2}{}^h$=1.3, $\gamma_{H2O,V}$=72.8, and $\gamma_{CH2I2,V}$=50.8. By substituting the measured value of the contact angle with water to $\theta_{H2O}$ and substituting the measured value of the contact angle with diiodomethane to $\theta_{CH2I2}$, a dispersion force component $\gamma_S{}^d$ of the surface energy and a polar component $\gamma_S{}^h$ of the surface energy are obtained, respectively, and the sum thereof $\gamma_S{}^{Vh}=\gamma_S{}^d+\gamma_S{}^h$ can be obtained as the surface free energy (mN/m).

In the measurement of the contact angle, the liquid droplet volumes of pure water and diiodomethane are set as 1 μL, and the contact angle is read 10 seconds after dropwise addition. At this time, a measurement atmosphere has conditions of temperature: 23°C and relative humidity: 50%.

The average roughness Ra of the surface Os of the gate insulating layer is preferably 2 nm or lower and more preferably 1 nm or lower. By suppressing the surface roughness Ra of the gate insulating layer to be 2 nm or lower, adhesiveness with the organic semiconductor layer formed of the highly crystalline compound can be improved, a deterioration or variation in carrier mobility can be effectively suppressed, and hysteresis can also be improved. The

reason for this is not clear but is presumed to be that the compound represented by Formula (1) that has a molecular weight of 3000 or lower and forms the organic semiconductor layer is a highly crystalline compound having a specific fused polycyclic structure as a mother nucleus. That is, in a case where the organic semiconductor layer is formed using a compound having low crystallinity (for example, amorphous compound), an organic semiconductor layer that adheres to the surface of the gate insulating layer is formed. Therefore, the average roughness Ra of the surface Os of the gate insulating layer has little effect on the performance of the transistor in practice. However, in the transistor according to the embodiment of the present invention in which the organic semiconductor layer is formed of the highly crystalline compound, it is presumed that the average roughness Ra of the surface Os has a large effect on the performance of the transistor, and a deterioration or variation in carrier mobility can be effectively suppressed by highly suppressing Ra. The lower limit value of the average roughness Ra of the surface Os is not particularly limited and is typically 0.05 nm or higher.

The average roughness Ra is obtained by measuring a 1 $\mu m^2$ range of the film using an atomic force microscope (AFM) according to JIS B 0601.

In addition, in order to further improve the state of an interface with the organic semiconductor layer, it is preferable that the gate insulating layer includes an organic component.

Further, it is preferable that an elution amount of an organic component having a molecular weight of 1000 or lower (hereinafter, also simply referred to as "organic component elution amount") in the gate insulating layer is lower than 10 ppm. This organic component elution amount is a numerical value that reflects the amount of the organic component having a molecular weight of 1000 or lower present in the gate insulating layer and is determined as follows.

That is, the gate insulating layer is dipped in 10 mL of a mixed solution of water:ethanol=20:80 (mass ratio) per 1 square centimeter of the gate insulating layer, is sealed such that the solution is not volatilized, and is left to stand at 40°C for 10 days. Next, the concentration (ppm) of the organic component having a molecular weight of 1000 or lower in the mixed solution is determined, and is set as the organic component elution amount.

More specifically, the organic component elution amount can be determined using a method described below in Examples.

An acid or a radical generator used in a case where a crosslinked structure is introduced into the gate insulating layer remains in the gate insulating film as a decomposition product even after completion of a crosslinking reaction. In addition, an unreacted generator or an uncrosslinked component of a material forming the gate insulating film remains to some extent. The effects of this low molecular weight component on the properties of the transistor have not attracted much attention and have not been clarified. Under the above-described circumstances, the present inventors found that, in a configuration in which the organic semiconductor layer is formed using the compound having the specific structure represented by Formula (1), by highly suppressing the organic component elution amount in the configuration of the gate insulating layer, a variation in performance between elements can be suppressed, and power consumption can be more effectively suppressed. For example, the reason for this is not clear but is presumed to be as follows. The compound represented by Formula (1) that has a molecular weight of 3000 or lower has high crystallinity as described above, and the organic semiconductor layer that is formed using this compound is in a state where the crystalline structure thereof is present in a wide range. Therefore, a low molecular weight component is not likely to penetrate through the organic semiconductor layer and to be volatilized to air, remains at an interface between the gate insulating layer and the organic semiconductor layer, and is likely to function as a trap or the like during charge transport. In addition, the transistor in which the organic semiconductor layer is formed using the compound represented by Formula (1) that has a molecular weight of 3000 or lower exhibits a high carrier mobility, and in a case where the low molecular weight component functions as a trap or the like during charge transport, the low molecular weight component has a large effect on the carrier mobility or the like.

The thickness of the gate insulating layer is not particularly limited and is preferably 100 to 1000 nm.

-Source Electrode and Drain Electrode-

In the transistor according to the embodiment of the present invention, the source electrode is an electrode into which charges flow from the outside through a wiring. In addition, the drain electrode is an electrode from which charges flow to the outside through a wiring.

As a material which forms the source electrode and the drain electrode, the same electrode material as that of the gate electrode can be used. Among these, a metal is preferable, and gold or silver is more preferable. In addition, it is preferable that a charge injection layer is provided between the metal and the organic semiconductor so as to promote charge injection from the source into the organic semiconductor and to improve mobility.

The thickness of each of the source electrode and the drain electrode is not particularly limited and is preferably 1 nm or more and more preferably 10 nm or more. In addition, the thickness of each of the source electrode and the drain electrode is preferably 500 nm or less and more preferably 300 nm or less.

An interval (gate length) between the source electrode and the drain electrode can be appropriately determined

and is, for example, preferably 200 μm or less and more preferably 100 μm or less. In addition, the gate width can be appropriately determined and is, for example, preferably 10 μm or more and more preferably 50 μm or more.

A method of forming the source electrode and the drain electrode is not particularly limited, and examples thereof include a method of performing vacuum deposition or sputtering using the electrode material on the substrate on which the gate electrode and the gate insulating film are formed and a method of applying or printing an electrode-forming composition to or on the substrate. In a case where the source electrode and the drain electrode are patterned, a patterning method thereof is the same as that of the gate electrode.

-Organic Semiconductor Layer-

In the transistor according to the embodiment of the present invention, a method of forming the organic semiconductor layer is not particularly limited as long as the organic semiconductor layer is formed using the compound represented by Formula (1) that has a molecular weight of 3000 or lower. The organic semiconductor layer may be formed using a vacuum process (for example, vapor deposition) or using a solution process. However, it is preferable that the organic semiconductor layer is formed using a solution process from the viewpoint of further increasing the crystal domain size. In this solution process, the compound represented by Formula (1) is dissolved in a solvent, and the film is formed using this solution. Specifically, a coating method such as a drop casting method, a cast method, a dip coating method, a die coater method, a roll coater method, a bar coater method, or a spin coating method and a printing method such as an ink jet method, a screen printing method, a gravure printing method, a flexographic printing method, an off set printing method, a microcontact printing method or a method (edge casting method) described in paragraphs "0187" and "0188" of JP2015-195362A can be used.

(Sealing Layer)

In the transistor according to the embodiment of the present invention, it is preferable that the sealing layer is provided on the outermost layer from the viewpoint of durability. For the sealing layer, a sealing agent (sealing layer-forming composition) that is typically used in the organic semiconductor transistor can be used.

The thickness of the sealing layer is not particularly limited and is preferably 0.1 to 10 μm.

(Bottom Gate-Top Contact Type Organic Semiconductor Transistor)

Fig. 2 is a schematic cross-sectional view showing a bottom gate-top contact type organic semiconductor transistor 200 as an example of the transistor according to the embodiment of the present invention.

As shown in Fig. 2, the organic semiconductor transistor 200 includes the substrate 10, the gate electrode 20, the gate insulating layer (film) 30, the organic semiconductor layer (film) 50, the source electrode 40 and the drain electrode 42, and the sealing layer 60 in this order.

The organic semiconductor transistor 200 is the same as the organic semiconductor transistor 100 except for the layer configuration (stack aspect). Accordingly, the details of the substrate, the gate electrode, the gate insulating layer, the source electrode, the drain electrode, the organic semiconductor layer, and the sealing layer are the same as those of the bottom gate-bottom contact type organic TFT, and thus the description thereof will not be repeated.

Examples

The present invention will be described in more detail using Examples, but the present invention is not limited to the following Examples.

(Synthesis Example 1) Synthesis of Compound 1

In the following reaction scheme, Bu represents butyl, Et represents ethyl, THF represents tetrahydrofuran, DMF represents N,N-dimethylformamide, TMP represents tetramethylpiperidine, and dppf represents 1,1'-bis(diphenylphosphino)ferrocene.

-Synthesis of Intermediate 1a-

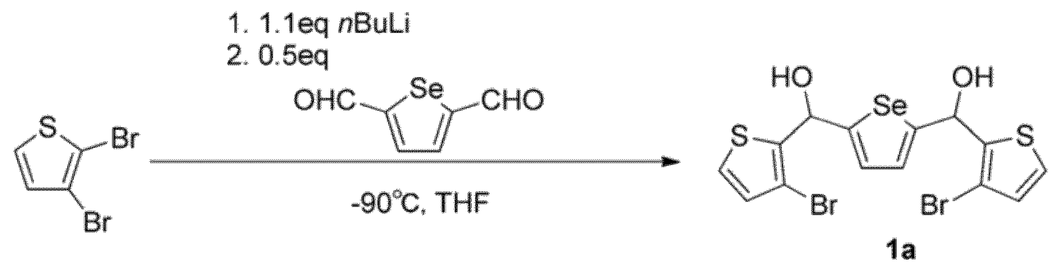


**1a**

A 2,3-dibromothiophene n-butyllithium solution (15.9 g, 65.8 mmol) was dissolved in 120 ml of diethyl ether, and n-butyllithium (1.6 M solution) was added dropwise to the solution while stirring the solution at -90°C. After 30 minutes, a solution in which 2,5-selenophene dicarboxaldehyde (6.00 g, 32. 1 mmol) was dissolved in 50 ml of tetrahydrofuran was added dropwise, was stirred at -78°C for 20 minutes, and then was heated to room temperature. The reaction solution was quenched with water, and the organic layer was extracted with diethyl ether and was dried with magnesium sulfate. After concentration with an evaporator, an intermediate 1a (12.9 g) as a brown oily target material was obtained. A coarse body of the obtained target material was used for the next reaction without being purified.
$^1$H-NMR (400 MHz, $CDCl_3$) δ: 7.28 (d, J=5.2 Hz, 2H), 7.04 (d, J=5.2 Hz, 2H), 6.93 (d, J=5.2 Hz, 2H), 6.31 (s, 2H)

-Synthesis of Intermediate 2a-

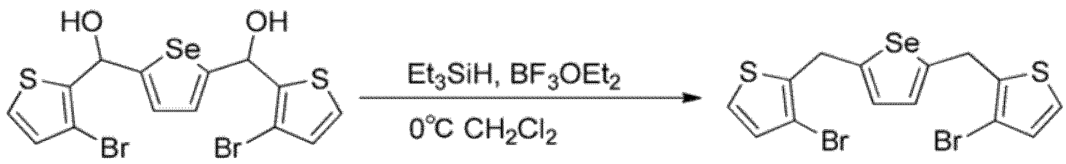


**1a** **2a**

The intermediate 1a (12.9 g) and triethylsilane (15.4 ml, 96.2 mmol) were dissolved in 70 ml of dichloromethane, and the solution was cooled to 0°C. Next, boron trifluoride etherate (11.9 ml, 96.2 mmol) was added dropwise to the solution and was stirred for 30 minutes. Next, the solution was quenched with water, the organic layer was extracted with ethyl acetate and was dried with magnesium sulfate. After concentration, the coarse body was purified by column chromatography (hexane:ethyl acetate=95:5). As a result, an intermediate 2a (9.20 g, 19.1 mmol, 60% yield for 2 steps) as a yellow oily target material was obtained.
$^1$H-NMR (400 MHz, $CDCl_3$) δ: 7.16 (d, J=5.2 Hz, 2H), 6.92 (d, J=5.2 Hz, 2H), 6.86 (s, 2H), 4.28 (s, 4H)

-Synthesis of Intermediate 3a-

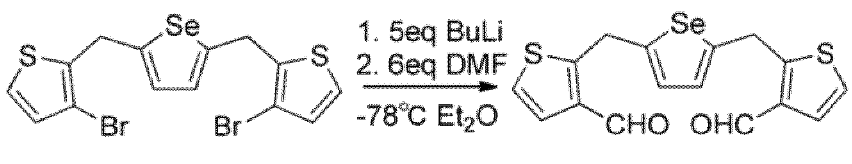


**2a** **3a**

N-butyllithium (1.6 M solution) (58.5 ml, 93.5 mmol) was cooled to -78°C, a solution in which the intermediate 2a (9.00 g, 18.7 mmol) was dissolved in 240 ml of diethyl ether was added dropwise thereto, and the solution was stirred for 30 minutes. Next, N,N-dimethylformamide (8.7 ml, 112 mmol) was added dropwise. The solution was stirred at -78°C for 20 minutes, was heated to room temperature, and was quenched with water. Next, the organic layer was extracted with diethyl ether and was dried with magnesium sulfate. After concentration, an intermediate 3a (6.50 g) as a red oily target material was obtained. A coarse body of the obtained target material was used for the next reaction without being purified.

$^1$H-NMR (400 MHz, $CDCl_3$) δ: 10.0 (s, 2H), 7.40 (d, J=4.8 Hz, 2H), 7.15 (d, J=4.8 Hz, 2H), 6.88 (s, 2H), 4.68 (s, 4H)

-Synthesis of Intermediate 4a-

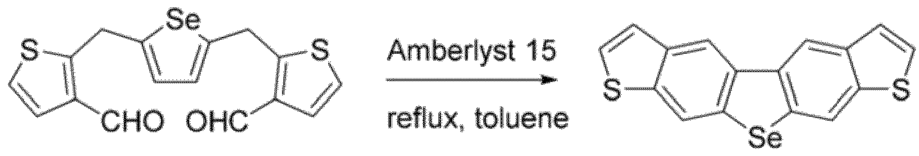


3a 4a

The intermediate 3a (6.50 g) was dissolved in 350 ml of toluene, AMBERLYST (registered trade name) 15 hydrogen form (15.0 g) was added thereto, and the solution was heated to reflux for 2 hours. The reaction solution was separated by filtration, and the filtrate was concentrated recrystallized with toluene/methanol, and purified by column chromatography (toluene). As a result, an intermediate 4a (2.35 g, 6.84 mmol, 36% yield for 2 steps) as a white solid target material was obtained.
$^1$H-NMR (400 MHz, $CDCl_3$) δ: 8.63 (s, 2H), 8.31 (d, J=0.8 Hz, 2H), 7.46 (m, 4H)

-Synthesis of Intermediate 5a-

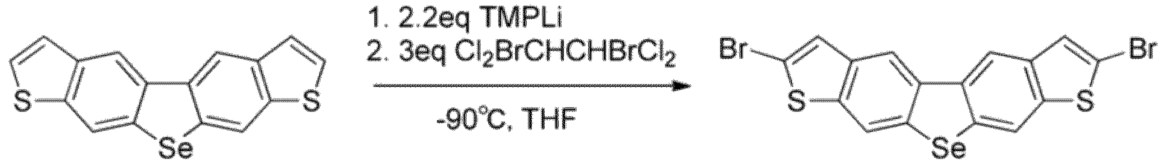


4a 5a

A mixed solution of the intermediate 4a (2.00 g, 5.83 mmol) and 58 ml of tetrahydrofuran was stirred at -90°C, 20 ml of a tetrahydrofuran solution of lithiumtetramethylpiperidine (12.8 mmol) was added dropwise, and the solution was stirred for 30 minutes. A solution in which dibromotetrachloroethane (5.69 g, 17.5 mmol) was dissolved in 20 ml of tetrahydrofuran was added dropwise to the reaction solution, and the solution was stirred at -78°C for 20 minutes and was heated to room temperature. The reaction solution was quenched with water, and the organic layer was extracted with dichloromethane and was dried with magnesium sulfate. After concentration, the solution was recrystallized with tetrahydrofuran/methanol. As a result, an intermediate 5a (2.21 g, 4.41 mmol, 76% yield) as a white solid target material was obtained.
$^1$H-NMR (400 MHz, $CDCl_3$) δ: 8.46 (s, 2H), 8.16 (s, 2H), 7.45 (s, 2H)

-Synthesis of Compound 1-

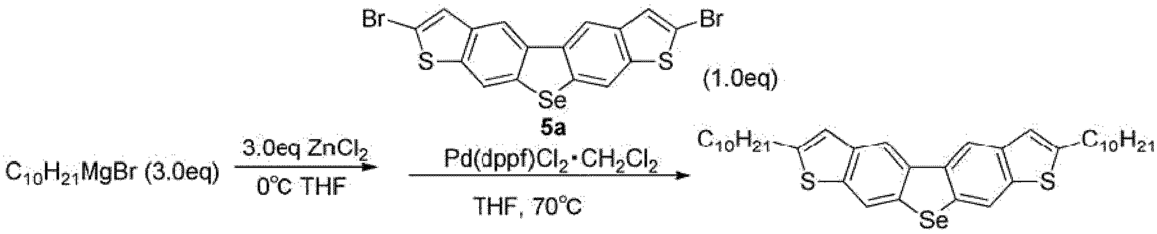


Compound 1

A zinc chloride (II) solution (1.0 mol/L, tetrahydrofuran solution, 1.50 ml) was added at 0°C to an n-decyl magnesium bromide solution (1.0 mol/L, in diethylether, 1.50 ml, 1.50 mmol) used as a reactant. Next, the solution was stirred for 15 minutes, and the intermediate 5a (250 mg, 0.45 mmol) and a 1,1'-bis(diphenylphosphino) ferrocene dichloro palladium (II) dichloromethane adduct (20.2 mg, 0.025 mmol) were added thereto. The reaction solution was stirred at 70°C for 1 hour, was concentrated, and was purified by column chromatography (hexane/chloroform=95/5). As a result, a compound 1 (102 mg, 0.16 mmol, 33% yield) as a white solid target material was obtained.
$^1$H-NNM (400 MHz, $CDCl_3$) $\delta$: 8.43 (s, 2H), 8.17 (s, 2H), 7.10 (s, 2H), 2.93 (t, J=7.6 Hz, 4H), 1.78 (quint, J=6.4 Hz, 4H), 1.46-1.27 (m, 28H), 0.88 (t, J=6.8 Hz, 6H)

[Synthesis Examples 2 to 108] Synthesis of Compounds 2 to 108

Under the same conditions as those of Synthesis Example 1, compounds 2 to 108 shown in tables below were synthesized referring to Examples of JP2015-195362A.

Structures of the compounds 1 to 108 synthesized in the respective synthesis examples are shown below.

[Table 61]

| | | | |
|---|---|---|---|
| Compound 1 | 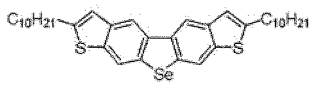 | Compound 12 | 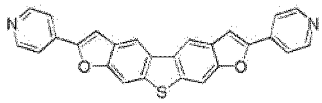 |
| Compound 2 | 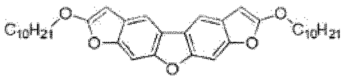 | Compound 13 | 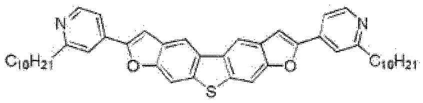 |
| Compound 3 | 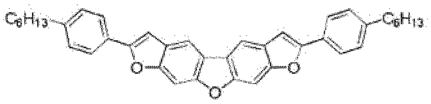 | Compound 14 | 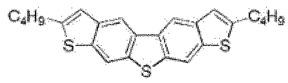 |
| Compound 4 | 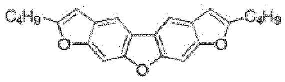 | Compound 15 | 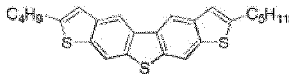 |
| Compound 5 | 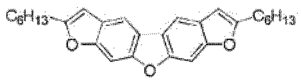 | Compound 16 | 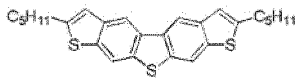 |
| Compound 6 | 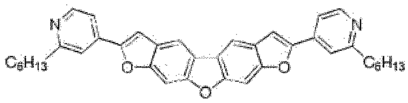 | Compound 17 | 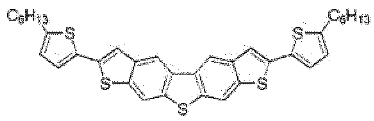 |
| Compound 7 | 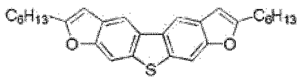 | Compound 18 | 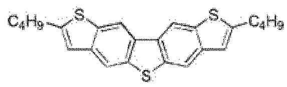 |
| Compound 8 | 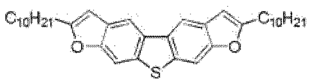 | Compound 19 | 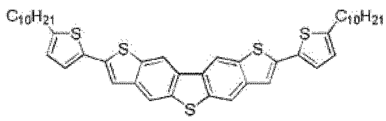 |
| Compound 9 | 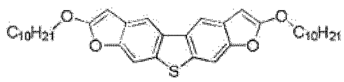 | Compound 20 | 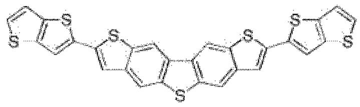 |
| Compound 10 | 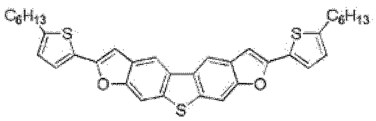 | Compound 21 | 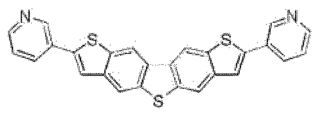 |
| Compound 11 | 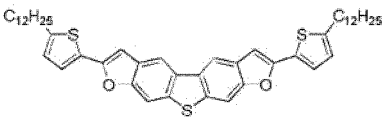 | Compound 22 | 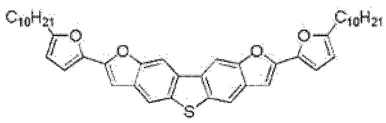 |

[Table 62]

| | | | | |
|---|---|---|---|---|
| Compound 23 | 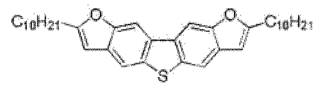 | | Compound 34 | 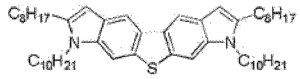 |
| Compound 24 | 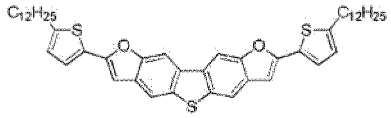 | | Compound 35 | 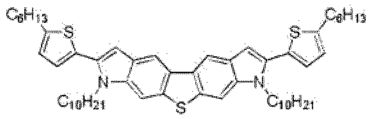 |
| Compound 25 | 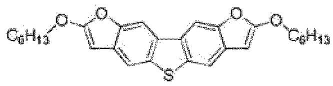 | | Compound 36 | 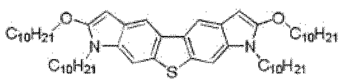 |
| Compound 26 | 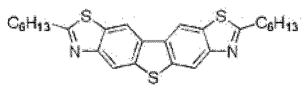 | | Compound 37 | 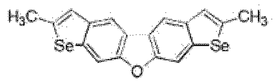 |
| Compound 27 | 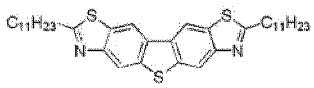 | | Compound 38 | 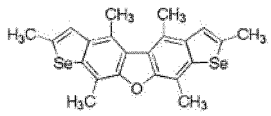 |
| Compound 28 | 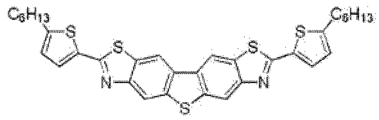 | | Compound 39 | 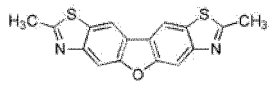 |
| Compound 29 | 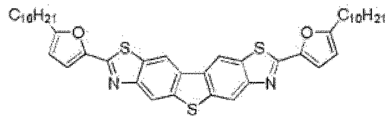 | | Compound 40 | 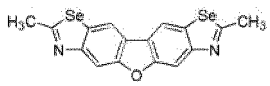 |
| Compound 30 | 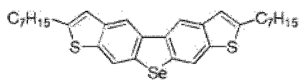 | | Compound 41 | 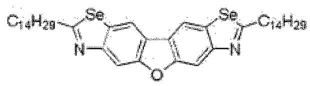 |
| Compound 31 | 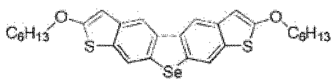 | | Compound 42 | 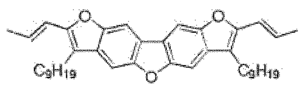 |
| Compound 32 | 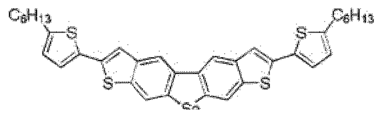 | | Compound 43 | 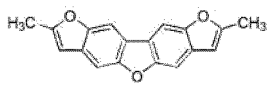 |
| Compound 33 | 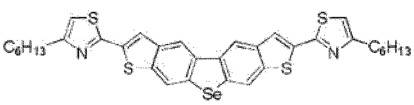 | | Compound 44 | 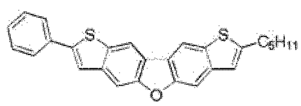 |

[Table 63]

| | | | |
|---|---|---|---|
| Compound 45 | 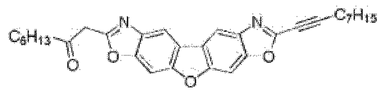 | Compound 56 | 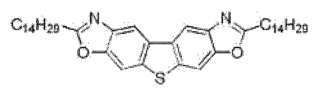 |
| Compound 46 | 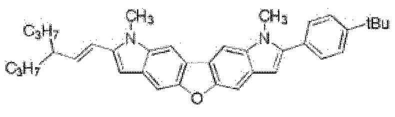 | Compound 57 | 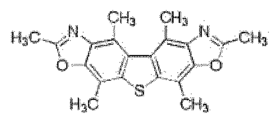 |
| Compound 47 | 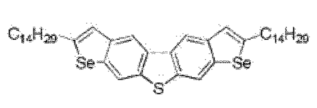 | Compound 58 | 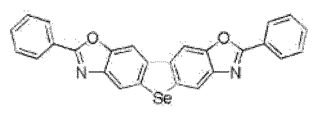 |
| Compound 48 | 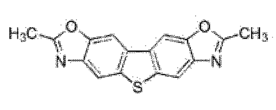 | Compound 59 | 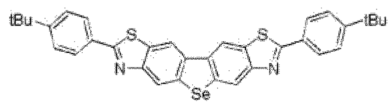 |
| Compound 49 | 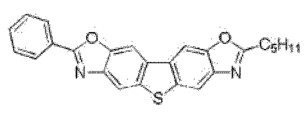 | Compound 60 | 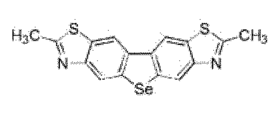 |
| Compound 50 | 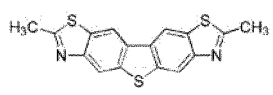 | Compound 61 | 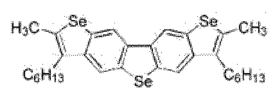 |
| Compound 51 | 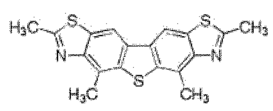 | Compound 62 | 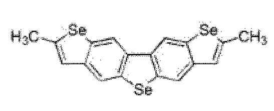 |
| Compound 52 | 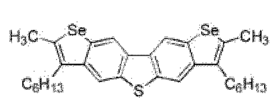 | Compoun d 63 | 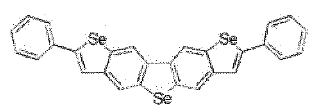 |
| Compound 53 | 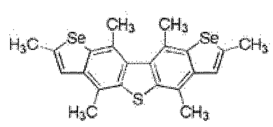 | Compound 64 | 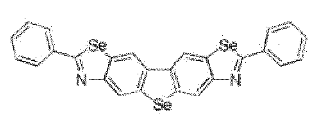 |
| Compound 54 | 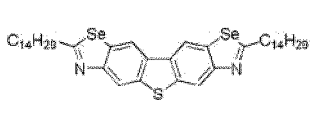 | Compound 65 | 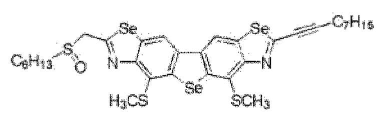 |
| Compound 55 | 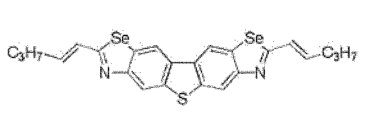 | Compound 66 | 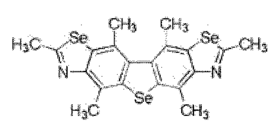 |

[Table 64]

| | | | |
|---|---|---|---|
| Compound 67 | 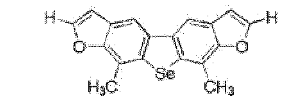 | Compound 78 | 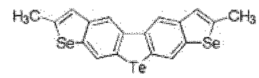 |
| Compound 68 | 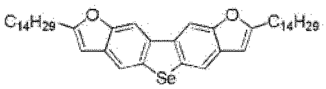 | Compound 79 | 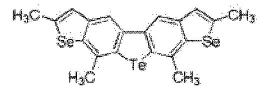 |
| Compound 69 | 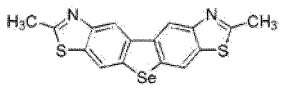 | Compound 80 | 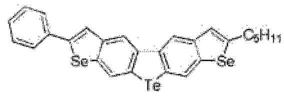 |
| Compound 70 | 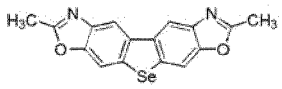 | Compound 81 | 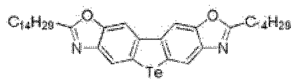 |
| Compound 71 | 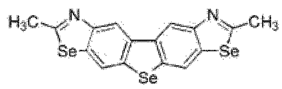 | Compound 82 | 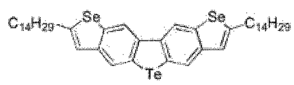 |
| Compound 72 | 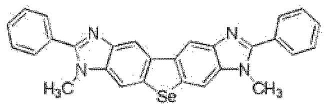 | Compound 83 | 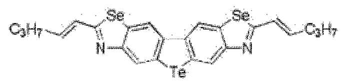 |
| | | Compound 84 | 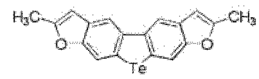 |
| Compound 73 | 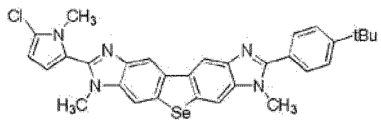 | Compound 85 | 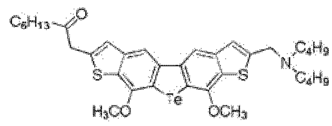 |
| Compound 74 | 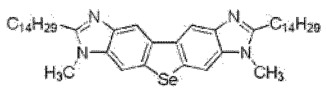 | Compound 86 | 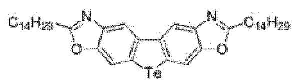 |
| Compound 75 | 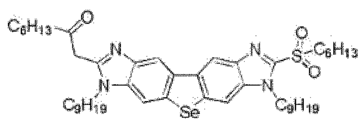 | Compound 87 | 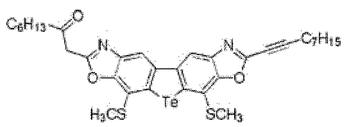 |
| Compound 76 | 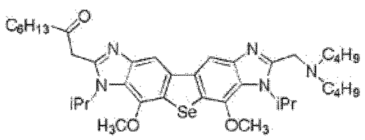 | Compound 88 | 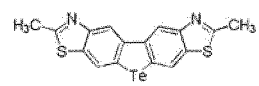 |
| Compound 77 | 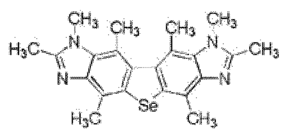 | | |

[Table 65]

| | | | |
|---|---|---|---|
| Compound 89 | 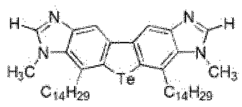 | Compound 100 | 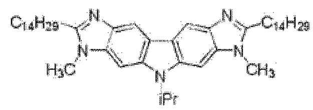 |
| Compound 90 | 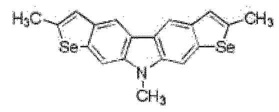 | Compound 101 | 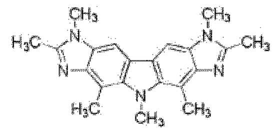 |
| Compound 91 | 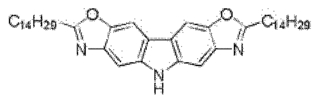 | Compound 102 | 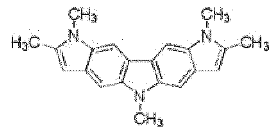 |
| Compound 92 | 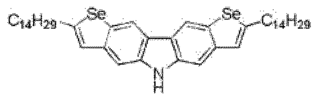 | Compound 103 | 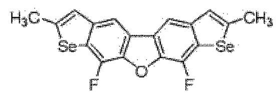 |
| Compound 93 | 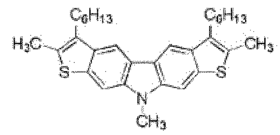 | Compound 104 | 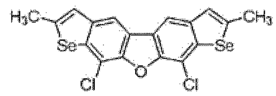 |
| Compound 94 | 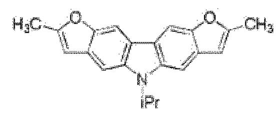 | Compound 105 | 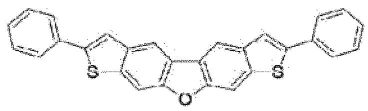 |
| Compound 95 | 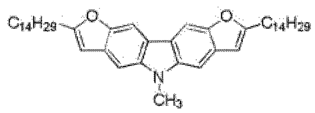 | Compound 106 | 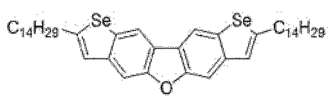 |
| Compound 96 | 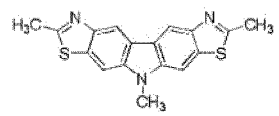 | Compound 107 | 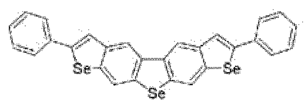 |
| Compound 97 | 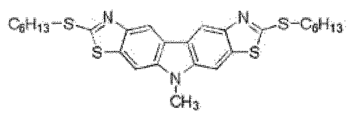 | Compound 108 | 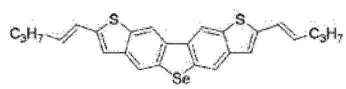 |
| Compound 98 | 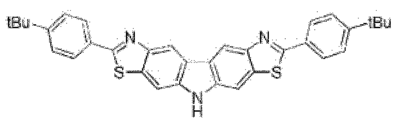 | | |
| Compound 99 | 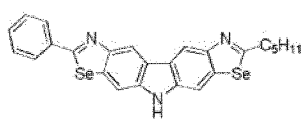 | | |

In addition, structures of comparative compounds 1 to 4 used in the following Comparative Examples 1-3 to 1-6 are shown below. In the following examples, the comparative compounds 2 and 3 are polymers that include a repeating unit having a structure shown in parentheses, and Mw represents a weight-average molecular weight.

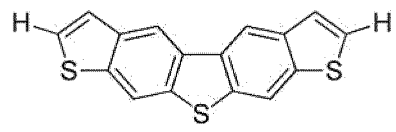

Comparative Compound 1

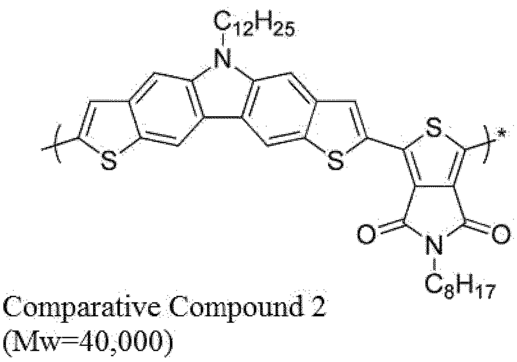

Comparative Compound 2
(Mw=40,000)

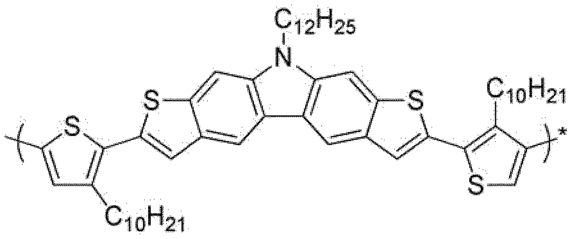

Comparative Compound 3
(Mw=40,000)

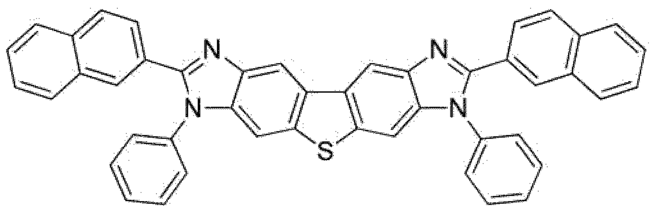

Comparative Compound 4

[Example 1-1] Manufacturing of Bottom Gate-Bottom Contact Type Organic Semiconductor Transistor

A bottom gate-bottom contact type organic semiconductor transistor 400 shown in Fig. 4 was manufactured as follows.

<Gate Electrode and Gate Insulating Layer>

A polyimide film-forming solution (coating solution, SE-130, polyimide precursor solution, manufactured by Nissan Chemical Industries Ltd.) that was diluted to 2 mass% using N-methyl-2-pyrrolidone was applied to a thermal oxide film of a conductive silicon substrate (gate electrode, 0.7 mm) including the $SiO_2$ thermal oxide film (thickness: 200 nm), and was dried at 100°C for 10 minutes. Next, the dried film was imidized at 230°C for 2 hours to form a polyimide film insulating layer (thickness 50 nm). In this polyimide film insulating layer, the surface roughness Ra of the surface Os was 0.8 nm, and the surface free energy of the surface Os was 44 mN/m. In the configuration, the gate insulating layer includes the thermal oxide film and the polyimide film insulating layer.

<Source Electrode and Drain Electrode>

Next, silver ink (H-1, manufactured by Mitsubishi Materials Corporation) was drawn on the gate insulating layer using an ink jet device DMP-2831 (manufactured by Fuji Film Dimatix Inc.) in a shape of a source electrode and a drain electrode (channel length: 40 μm, channel width: 200 μm). Next, the silver ink was baked using an oven at 180°C for 30 minutes and was sintered to form the source electrode and the drain electrode. This way, an element substrate for evaluation of thin film transistor characteristics was obtained.

<Organic Semiconductor Layer>

The element substrate for evaluation of thin film transistor characteristics was placed on a hot plate heated to 90°C. Next, a coating solution in which the compound 1 was dissolved in anisole such that the concentration thereof was 0.10 mass% was drop-cast on the element substrate, and was dried as it is to form an organic semiconductor layer (thickness: 300 nm). This way, a bottom gate-bottom contact type organic semiconductor transistor (Example 1-1) was obtained.

[Example 1-2 and Comparative Examples 1-1 to 1-6] Manufacturing of Bottom Gate-Bottom Contact Type Organic Semiconductor Transistor

In Example 1-1, after the formation of the polyimide film insulating layer, the surface Os was rubbed or treated with ultraviolet light and ozone such that the surface Os of the polyimide film insulating layer was adjusted to have surface characteristics of Example 1-2 and Comparative Examples 1-1 and 1-2 in the following table. Next, a source electrode and a drain electrode were formed on the surface of each of the polyimide film insulating layers under the same conditions as those of Example 1-1. As a result, an element substrate for evaluation of thin film transistor characteristics corresponding to each surface characteristics was obtained.

Next, an organic semiconductor layer was formed on the polyimide film insulating layer under the same conditions of Example 1-1 using each of the compound 1 and the comparative compounds 1 to 4 as shown in the following table. This way, organic semiconductor transistors were obtained (Example 1-2 and Comparative Examples 1-1 to 1-6). In the organic semiconductor transistors according to Comparative Examples 1-3 to 1-6, the surface characteristics of the gate insulating layers were the same as those of Example 1-1, and the compounds used for forming the organic semiconductor layers were the comparative compounds 1-4 not having the structure represented by Formula (1), respectively.

[Measurement Method And Evaluation Method]

<Measurement of Elution Amount of Organic Component having Molecular Weight of 1000 or lower>

The substrate on which the gate electrode and the gate insulating layer were formed was cut into a size of 1 square centimeter, and 10 mL of a mixed solution of water:ethanol=20:80 (mass ratio) was added dropwise to the surface of the gate insulating layer such that the entire gate insulating layer was dipped. Next, the substrate was put into an airtight container such that the water-ethanol mixed solution was not volatilized, and was left to stand at 40°C for 10 days. Next, the concentration of the organic component having a molecular weight of 1000 or lower (the total concentration of the organic component having a molecular weight of 1000 or lower) included in 10 mL of the water-ethanol mixed solution was determined by high-performance liquid chromatography, and was evaluated based on the following evaluation standards.

(Evaluation Standards of Elution Amount of Organic Component having Molecular Weight of 1000 or lower)

A: lower than 1 ppm in 10 mL of the water-ethanol mixed solution
B: 1 ppm or higher and lower than 3 ppm in 10 mL of the water-ethanol mixed solution
C: 3 ppm or higher and lower than 10 ppm in 10 mL of the water-ethanol mixed solution
D: 10 ppm or higher and lower than 30 ppm in 10 mL of the water-ethanol mixed solution
E: 30 ppm or higher in 10 mL of the water-ethanol mixed solution

<Evaluation of Characteristics of Organic Semiconductor Transistor>

Regarding each of the manufactured organic semiconductor transistors, characteristics of the transistor in air were evaluated using a semiconductor characteristic evaluation device: 4155C (trade name, manufactured by Agilent Technologies Inc.).

Specifically, a voltage of -15 V was applied between the source electrode and the drain electrode of each of the organic thin film transistors, and a gate voltage was caused to vary in a range of +40 V to -40 V in a reciprocating manner. In this case, a carrier mobility $\mu$ ($cm^2/Vs$) and a threshold voltage $V_{th}$ (V) in a case the gate voltage was caused to vary in a range of +40 V to -40 V and a carrier mobility $\mu$ ($cm^2/Vs$) and a threshold voltage $V_{th}$ (V) in a case where the gate voltage was caused to vary in a range of -40 V to +40 V were calculated using the following expression indicating a drain current $I_d$.

$$I_d=(w/2L)\mu C_i(V_g-V_{th})^2$$

In the expression, L represents the gate length, w represents the gate width, $\mu$ represents the carrier mobility, $C_i$ represents the volume of the gate insulating layer per unit area, $V_g$ represents the gate voltage, and $V_{th}$ represents a threshold voltage.

Regarding each of Examples and Comparative Examples 100 organic semiconductor transistors were prepared. Based on the characteristics of each of the 100 transistors, the performance of the transistor was evaluated based on the following evaluation standards.

(Evaluation Standards of Average Mobility)

The average carrier mobility of the 100 organic semiconductor transistors was obtained and was evaluated based on the following evaluation standards. The carrier mobility of one organic semiconductor transistor was the average value of the carrier mobility in a case where the gate voltage was swept from +40 V to -40 V and the carrier mobility in a case where the gate voltage was swept from -40 V to +40 V

A: the average value of the carrier mobilities was 1 $cm^2/Vs$ or higher
B: the average value of the carrier mobilities was 0.5 $cm^2/Vs$ or higher and lower than 1 $cm^2/Vs$
C: the average value of the carrier mobilities was 0.1 $cm^2/Vs$ or higher and lower than 0.5 $cm^2/Vs$
D: the average value of the carrier mobilities was 0.01 $cm^2/Vs$ or higher and lower than 0.1 $cm^2/Vs$
E: the average value of the carrier mobilities was lower than 0.01 $cm^2/Vs$

(Evaluation Standards of Variation in Mobility)

Based on a coefficient of variation obtained from the following expression, a variation in carrier mobility was evaluated by the following evaluation standards.

Coefficient of Variation (%)=100×[Standard Deviation of Carrier Mobilities of 10 Organic Semiconductor Transistors]/[Average Value of Carrier Mobilities of 10 Organic Semiconductor Transistors] The carrier mobility of one organic semiconductor transistor was the average value of the carrier mobility in a case where the gate voltage was swept from +40 V to -40 V and the carrier mobility in a case where the gate voltage was swept from -40 V to +40 V.

A: the coefficient of variation was lower than 10%
B: the coefficient of variation was 10% or higher and lower than 20%
C: the coefficient of variation was 20% or higher and lower than 30%
D: the coefficient of variation was 30% or higher and lower than 40%
E: the coefficient of variation was 40% or higher

(Yield)

Regarding the organic semiconductor transistor in which the organic semiconductor layer was formed of each of the compounds, 100 samples were prepared. By using the number of defective products having a carrier mobility of lower than 0.01 $cm^2/Vs$ among the 100 organic semiconductor transistors as an index, the yield was evaluated based on the following evaluation standards.

The carrier mobility of one organic semiconductor transistor was the average value of the carrier mobility in a case where the gate voltage was swept from +40 V to -40 V and the carrier mobility in a case where the gate voltage was swept from -40 V to +40 V.

A: the number of defective products was 0
B: the number of defective products was 1 or 2
C: the number of defective products was 3 to 5
D: the number of defective products was 6 to 10
E: the number of defective products was 11 or more

($V_{th}$ Shift)

Regarding each of the 100 organic semiconductor transistors, the average of $V_{th}$ in a case where the gate voltage was swept from +40 V to -40 V and $V_{th}$ in a case where the gate voltage was swept from -40 V to +40 V was obtained as an average $V_{th}$. The average value (referred to as "$V_{th}^{100}$") of the respective average Vth values of the 100 organic semiconductor transistors was obtained (that is, the average value of the 100 average Vth values was calculated) and was evaluated based on the following evaluation standards.

A: the absolute value of $V_{th}^{100}$ was lower than 3 V
B: the absolute value of $V_{th}^{100}$ was 3 V or higher and lower than 5 V
C: the absolute value of $V_{th}^{100}$ was 5 V or higher and lower than 10 V
D: the absolute value of $V_{th}^{100}$ was 10 V or higher and lower than 15 V
E: the absolute value of $V_{th}^{100}$ was 15 V or higher

(Evaluation of Hysteresis)

The absolute value of a difference between $V_{th}$ in a case where the gate voltage was swept from +40 V to -40 V and $V_{th}$ in a case where the gate voltage was swept from -40 V to +40 V was defined as hysteresis. The average value of the hysteresis values of the 100 organic semiconductor transistors was obtained and was evaluated based on the following evaluation standards.

A: the average hysteresis was lower than 3 V
B: the average hysteresis was 3 V or higher and lower than 5 V
C: the average hysteresis was 5 V or higher and lower than 10 V
D: the average hysteresis was 10 V or higher and lower than 15 V
E: the average hysteresis was 15 V or higher

The evaluation results of Examples 1-1 and 1-2 and Comparative Examples 1-1 to 1-6 are shown in the following table.

[Table 66]

| | Compound of Organic Semiconductor Layer | Surface Characteristics of Gate Insulating Layer | | Organic Component Elution Amount | Average Mobility | Variation in Mobility | Yield | $V_{th}$ Shift | Hysteresis |
|---|---|---|---|---|---|---|---|---|---|
| | | Surface Free Energy (mN/N) | Ra (nm) | | | | | | |
| Example 1-1 | Compound 1 | 44 | 0.8 | A | B | B | A | B | B |
| Example 1-2 | Compound 1 | 44 | 1.5 | A | B | C | C | B | C |
| Comparative Example 1-1 | Compound 1 | 52 | 1.0 | A | C | A | B | D | C |
| Comparative Example 1-2 | Compound 1 | 44 | 2.3 | A | C | C | D | C | D |
| Comparative Example 1-3 | Comparative Compound 1 | 44 | 0.8 | A | D | E | E | D | C |
| Comparative Example 1-4 | Comparative Compound 2 | 44 | 0.8 | A | E | E | E | B | B |
| Comparative Example 1-5 | Comparative Compound 3 | 44 | 0.8 | A | E | E | E | C | B |
| Comparative Example 1-6 | Comparative Compound 4 | 44 | 0.8 | A | E | E | E | D | C |

As shown in the table, in a case where the surface free energy of the surface Os of the gate insulating layer was higher than 50 mN/m, the $V_{th}$ shift was large, and the power consumption was high (Comparative Example 1-1). In addition, in a case where the surface roughness Ra the surface Os was higher than 2 nm, an element having a significantly low carrier mobility appeared to some extent, and the yield deteriorated. In addition, this element was poor in the evaluation of hysteresis (Comparative Example 1-2).

Further, in Comparative Examples 1-3 to 1-6 not including the compound represented by Formula (1) having a molecular weight of 3000 or lower as a material for forming the organic semiconductor layer, the average mobility was low, and the variation in mobility was large. In addition, the yield was also low (that is, the defect rate was high), and the $V_{th}$ shift also tended to be high.

On the other hand, in the elements according to Examples 1-1 and 1-2 as the organic semiconductor transistors according to the embodiment of the present invention, the results were excellent in all the evaluations of the carrier mobility, the variation in carrier mobility, the yield, the $V_{th}$ shift, and the hysteresis.

Organic semiconductor transistors were manufactured under the same conditions Examples 1-1 and 1-2 and Comparative Examples 1-1 and 1-2, except that the compounds 2 to 108 were used instead of the compound 1 as the material for forming the organic semiconductor layer, respectively. Regarding the four elements in which the organic semiconductor layers were formed using the same compound (the four elements including the gate insulating layers corresponding to Examples 1-1 and 1-2 and Comparative Examples 1-1 and 1-2, respectively), the performances were evaluated. As a result, the same results as those of Examples 1-1 and 1-2 and Comparative Examples 1-1 and 1-2 were obtained. That is, in a case where the surface free energy of the surface Os of the gate insulating layer was 50 mN/m or higher, the $V_{th}$ shift was large. In a case where the surface roughness Ra the surface Os was higher than 2 nm, an element having a significantly low carrier mobility appeared to some extent, the yield deteriorated, and the evaluation of the hysteresis was also poor.

[Examples 2-1 to 2-5 and Comparative Examples 2-1 and 2-2] Manufacturing of Bottom Gate-Bottom Contact Type Organic Semiconductor Transistor

Organic semiconductor transistors were manufactured under the same conditions as those of Example 1-1, except that a gate electrode and a gate insulating layer were formed as described below. Regarding these organic semiconductor transistors, the performances were evaluated.

<Gate Electrode and Gate Insulating Layer>

Aluminum for forming a gate electrode was vapor-deposited on a glass substrate (EAGLE XG: manufactured by Corning Inc.) (thickness: 50 nm). As a material for forming the gate insulating layer, CYTOP (registered trade name, CTL-800 and CT-Solv, manufactured by Asahi Glass Co., Ltd.) was applied to the aluminum using a spin coating method, was baked at 80°C for 60 minutes and baked at 200°C for 60 minutes to form a gate insulating layer having a thickness of 500 nm. In the surface Os of the gate insulating layer, the surface roughness Ra was 1.2 nm, and the surface free energy was 19 mN/m.

In addition, the surface Os of the gate insulating layer was rubbed or treated with ultraviolet light and ozone such that the surface Os was adjusted to have characteristics shown in the following table.

The results are shown in the table below.

[Table 67]

| | Compound of Organic Semiconductor Layer | Surface Characteristics of Gate Insulating Layer | | Organic Component Elution Amount | Average Mobility | Variation in Mobility | Yield | $V_{th}$ Shift | Hysteresis |
|---|---|---|---|---|---|---|---|---|---|
| | | Surface Free Energy (mN/N) | Ra (nm) | | | | | | |
| Example 2-1 | Compound 1 | 30 | 1.2 | A | B | B | B | B | B |
| Example 2-2 | Compound 1 | 36 | 1.3 | A | B | B | A | B | B |
| Example 2-3 | Compound 1 | 25 | 1.1 | A | B | C | B | B | B |
| Example 2-4 | Compound 1 | 38 | 1.5 | A | B | B | C | B | B |
| Example 2-5 | Compound 1 | 45 | 1.8 | A | B | C | C | C | B |
| Comparative Example 2-1 | Compound 1 | 19 | 1.2 | B | B | D | D | B | B |
| Comparative Example 2-2 | Compound 1 | 19 | 2.5 | B | C | E | E | C | E |

As shown in the table, in a case where the surface free energy of the surface Os of the gate insulating layer was lower than 20 mN/N, the variation in mobility was large, and the yield deteriorated (Comparative Example 2-1). Further, in a case where the surface roughness Ra of the surface Os was higher than 2.0, the variation in mobility and the yield further deteriorated, and the evaluation of hysteresis also significantly deteriorated (Comparative Example 2-2).

On the other hand, in the elements according to Examples 2-1 to 2-5 as the organic semiconductor transistors according to the embodiment of the present invention, the results were excellent in all the evaluations of the carrier mobility, the variation in carrier mobility, the yield, the $V_{th}$ shift, and the hysteresis.

Organic semiconductor transistors were manufactured under the same conditions Examples 2-1 and 2-5 and Comparative Examples 2-1 to 2-2, except that the compounds 2 to 108 were used instead of the compound 1 as the material for forming the organic semiconductor layer, respectively. Regarding the five elements in which the organic semiconductor layers were formed using the same compound (the five elements including the gate insulating layers corresponding to Examples 2-1 and 2-5 and Comparative Examples 2-1 and 2-2, respectively), the performances were evaluated. As a result, the same results as those of Examples 2-1 and 2-5 and Comparative Examples 2-1 and 2-2 were obtained. That is, in a case where the surface free energy of the surface Os of the gate insulating layer was lower than 20 mN/m, the variation in mobility was large, and the yield also deteriorated. Further, in a case where the surface roughness Ra of the surface Os was higher than 2 nm, the variation in mobility and the yield further deteriorated, and the evaluation of hysteresis also significantly deteriorated.

[Examples 3-1 to 3-4 and Comparative Examples 3-1 and 3-2] Manufacturing of Bottom Gate-Bottom Contact Type Organic Semiconductor Transistor

Organic semiconductor transistors were manufactured under the same conditions as those of Example 1-1, except that a gate electrode and a gate insulating layer were formed as described below. Regarding these organic semiconductor transistors, the performances were evaluated.

<Gate Electrode and Gate Insulating Layer>

Aluminum for forming a gate electrode was vapor-deposited on a glass substrate (EAGLE XG: manufactured by Corning Inc.) (thickness: 50 nm). As a composition for forming the gate insulating layer, a solution (solid content concentration: 2 mass%) in which poly(styrene-co-methyl methacrylate)/pentaerythritol tetraacrylate/1-[4-(phenylthio)phenyl]-1,2-octanedione 2-(O-benzoyloxime)=1 part by mass/1 part by mass/0.01 parts by mass was dissolved in propylene glycol monomethyl ether acetate was applied to the aluminum using a spin coating method, was pre-baked at 110°C for 5 minutes, and was exposed (365 nm, 100 mJ/cm$^2$). By post-baking the applied composition at 200°C for 60 minutes, a gate insulating layer having a thickness of 400 nm was formed. In the surface Os of the insulating layer, the surface roughness Ra was 0.9 nm, and the surface free energy was 42 mN/m.

In addition, exposure conditions during the formation of the gate insulating layer were adjusted such that the organic component elution amount was as shown in the following table. In addition, the surface Os of the gate insulating layer was rubbed or treated with ultraviolet light and ozone such that the surface Os was adjusted to have characteristics shown in the following table.

The results are shown in the table below.

[Table 68]

| | Compound of Organic Semiconductor Layer | Surface Characteristics of Gate Insulating Layer | | Organic Component Elution Amount | Average Mobility | Variation in Mobility | Yield | $V_{th}$ Shift | Hysteresis |
|---|---|---|---|---|---|---|---|---|---|
| | | Surface Free Energy (mN/N) | Ra (nm) | | | | | | |
| Example 3-1 | Compound 1 | 42 | 0.9 | A | B | A | A | A | A |
| Example 3-2 | Compound 1 | 42 | 1.2 | A | B | B | A | A | B |
| Example 3-3 | Compound 1 | 44 | 0.9 | B | B | B | A | B | B |
| Example 3-4 | Compound 1 | 44 | 0.9 | C | B | C | B | C | B |
| Example 3-5 | Compound 1 | 44 | 0.9 | D | C | C | C | C | C |
| Comparative Example 3-1 | Compound 1 | 53 | 1.3 | A | C | B | B | D | B |

As shown in the table, in a case where the surface free energy of the surface Os of the gate insulating layer was higher than 50 mN/N, the $V_{th}$ shift was large, and the power consumption was high (Comparative Example 3-1).

On the other hand, in the elements according to Examples 3-1 to 3-5 as the organic semiconductor transistors according to the embodiment of the present invention, the results were excellent in all the evaluations of the carrier mobility, the variation in carrier mobility, the yield, the $V_{th}$ shift, and the hysteresis. Here, in the organic semiconductor transistor according to the embodiment of the present invention, in a case where the organic component elution amount was 3 ppm or higher, the variation in mobility and the yield were slightly low, but the $V_{th}$ shift also became higher (Example 3-4). In a case where the organic component elution amount was 10 ppm or higher, the average mobility, the yield, and the evaluation of hysteresis were tended to become lower (Example 3-5). In either case, however, the results were in a practically allowable range.

Organic semiconductor transistors were manufactured under the same conditions Examples 3-1 and 3-5 and Comparative Example 3-1, except that the compounds 2 to 108 were used instead of the compound 1 as the material for forming the organic semiconductor layer, respectively. Regarding the six elements in which the organic semiconductor layers were formed using the same compound (the six elements including the gate insulating layers corresponding to Examples 3-1 and 3-5 and Comparative Example 3-1, respectively), the performances were evaluated. As a result, the same results as those of Examples 3-1 to 3-5 and Comparative Example 3-1 were obtained. That is, in a case where the surface free energy of the surface Os of the gate insulating layer was higher than 50 mN/m, the $V_{th}$ shift was large, and power consumption was high.

[Examples 4-1 to 4-4 and Comparative Example 4-1] Manufacturing of Bottom Gate-Top Contact Type Organic Semiconductor Transistor

A bottom gate-top contact type organic semiconductor transistor 300 shown in Fig. 3 was manufactured as follows.

<Gate Electrode and Gate Insulating Layer>

A gate insulating layer in which characteristics of the surface Os were as shown in the following table was formed under the same conditions as described above in <Gate Electrode and Gate Insulating Layer> in Examples 3-1 to 3-4 and Comparative Example 3-1.

<Organic Semiconductor Layer>

Using a solution in which 0.10 mass% of the compound 1 was dissolved in anisole, an organic semiconductor layer (thickness: 20 nm) was formed on the gate insulating layer with a method (edge casting method) described in paragraphs "0187" and "0188" of JP2015-195362A.

<Source Electrode and Drain Electrode>

7,7,8,8-tetracyanoquinodimethane (manufactured by Tokyo Chemical Industry Co., Ltd.) and a gold electrode were vapor-deposited on the semiconductor layer through a mask to form a source electrode (thickness: 1.5 nm) and a drain electrode (thickness: 50 nm), respectively.

The performance of the obtained organic semiconductor transistor was evaluated. The results are shown in the table below.

[Table 69]

| | Compound of Organic Semiconductor Layer | Surface Characteristics of Gate Insulating Layer | | Organic Component Elution Amount | Average Mobility | Variation in Mobility | Yield | $V_{th}$ Shift | Hysteresis |
|---|---|---|---|---|---|---|---|---|---|
| | | Surface Free Energy (mN/N) | Ra (nm) | | | | | | |
| Example 4-1 | Compound 1 | 42 | 0.9 | A | A | B | A | B | B |
| Example 4-2 | Compound 1 | 42 | 1.2 | A | A | A | A | B | B |
| Example 4-3 | Compound 1 | 44 | 0.9 | B | B | C | B | C | C |
| Example 4-4 | Compound 1 | 44 | 0.9 | C | C | C | C | B | C |
| Comparative Example 4-1 | Compound 1 | 53 | 1.3 | A | C | B | B | D | D |

As shown in the table, in a case where the surface free energy of the surface Os of the gate insulating layer was higher than 50 mN/N, the $V_{th}$ shift was large, and the power consumption was high. In addition, this element was poor in the evaluation of hysteresis (Comparative Example 4-1).

On the other hand, in the elements according to Examples 4-1 to 4-4 as the organic semiconductor transistors according to the embodiment of the present invention, the results were excellent in all the evaluations of the carrier mobility, the variation in carrier mobility, the yield, the $V_{th}$ shift, and the hysteresis.

Organic semiconductor transistors were manufactured under the same conditions Examples 4-1 and 4-4 and Comparative Example 4-1, except that the compounds 2 to 108 were used instead of the compound 1 as the material for forming the organic semiconductor layer, respectively. Regarding the five elements in which the organic semiconductor layers were formed using the same compound (the five elements including the gate insulating layers corresponding to Examples 4-1 and 4-4 and Comparative Example 4-1, respectively), the performances were evaluated. As a result, the same results as those of Examples 4-1 to 4-4 and Comparative Example 4-1 were obtained. That is, in a case where the surface free energy of the surface Os of the gate insulating layer was higher than 50 mN/m, the $V_{th}$ shift was large, power consumption was high, and the evaluation of hysteresis was also poor.

[Examples 5-1 to 5-3 and Comparative Examples 5-1 and 5-2] Manufacturing of Bottom Gate-Top Contact Type Organic Semiconductor Transistor

A bottom gate-top contact type organic semiconductor transistor 300 shown in Fig. 3 was manufactured as follows.

<Gate Electrode and Gate Insulating Layer>

Aluminum for forming a gate electrode was vapor-deposited on a glass substrate (EAGLE XG: manufactured by Corning Inc.) (thickness: 50 nm). As a material for forming the gate insulating layer, a silsesquioxane derivative (trade name: OX-SQ, manufactured by Toagosei Co., Ltd.) was applied to the aluminum using a spin coating method, was pre-baked at 110°C for 5 minutes, and was exposed (365 nm, 20000 mJ/$cm^2$). As a result, a gate insulating layer having a thickness of 500 nm was formed. In the surface Os of the gate insulating layer, the surface roughness Ra was 0.5 nm, and the surface free energy was 40 mN/m.

In addition, the surface Os of the gate insulating layer was rubbed or treated with ultraviolet light and ozone such that the surface Os was adjusted to have characteristics shown in the following table.

<Organic Semiconductor Layer>

By vacuum-depositing the compound 1 on the gate insulating layer, an organic semiconductor layer (thickness: 30 nm) was formed on the gate insulating layer.

<Source Electrode and Drain Electrode>

7,7,8,8-tetracyanoquinodimethane (manufactured by Tokyo Chemical Industry Co., Ltd.) and a gold electrode were vapor-deposited on the semiconductor layer through a mask to form a source electrode (thickness: 1.5 nm) and a drain electrode (thickness: 50 nm), respectively.

The performance of the obtained organic semiconductor transistor was evaluated. The results are shown in the table below.

[Table 70]

| | Compound of Organic Semiconductor Layer | Surface Characteristics of Gate Insulating Layer | | Organic Component Elution Amount | Average Mobility | Variation in Mobility | Yield | $V_{th}$ Shift | Hysteresis |
|---|---|---|---|---|---|---|---|---|---|
| | | Surface Free Energy (mN/N) | Ra (nm) | | | | | | |
| Example 5-1 | Compound 1 | 40 | 0.5 | B | B | A | A | A | A |
| Example 5-2 | Compound 1 | 40 | 1.1 | B | B | A | B | B | B |
| Example 5-3 | Compound 1 | 40 | 1.7 | B | B | B | C | C | C |
| Comparative Example 5-1 | Compound 1 | 40 | 2.8 | B | D | D | D | B | E |
| Comparative Example 5-2 | Compound 1 | 60 | 0.6 | A | C | D | D | D | C |

As shown in the table, in a case where Ra of the surface Os of the gate insulating layer was higher than the range defined by the present invention, all the evaluation results regarding the average mobility, the variation in mobility, the yield, and the hysteresis were poor (Comparative Example 5-1). In addition, even in a case where Ra of the surface Os was in the range defined by the present invention, when the surface free energy of the surface Os was higher than the range defined by the present invention, the results were poor in the evaluation of the variation in mobility, the yield, and the $V_{th}$ shift (Comparative Example 5-2).

On the other hand, in the elements according to Examples 5-1 to 5-3 as the organic semiconductor transistors according to the embodiment of the present invention, the results were excellent in all the evaluations of the carrier mobility, the variation in carrier mobility, the yield, the $V_{th}$ shift, and the hysteresis.

Explanation of References

| | |
|---|---|
| 10: | substrate |
| 20: | gate electrode |
| 30: | gate insulating layer (film) |
| 40: | source electrode |
| 42: | drain electrode |
| 50: | organic semiconductor layer (film) |
| 60: | sealing layer |
| 100, 200: | organic semiconductor transistor |
| 21: | silicon substrate (gate electrode) |
| 31: | thermal oxide film (gate insulating layer) |
| 41a: | source electrode |
| 41b: | drain electrode |
| 51: | organic semiconductor layer |
| 61: | sealing layer |
| 300, 400: | organic semiconductor transistor |

The present invention has been described using the embodiments. However, unless specified otherwise, any of the details of the above description is not intended to limit the present invention and can be construed in a broad sense within a range not departing from the concept and scope of the present invention disclosed in the accompanying claims.

The present application claims priority based on JP2016-191914 filed on September 29, 2016, the entire content of which is incorporated herein by reference.

## Claims

**1.** A bottom gate type organic semiconductor transistor comprising:

a gate insulating layer; and
an organic semiconductor layer that is disposed adjacent to the gate insulating layer,
wherein a surface free energy of a surface of the gate insulating layer on the organic semiconductor layer side is 20 to 50 mN/m,
an average roughness Ra of the surface of the gate insulating layer on the organic semiconductor layer side is 2 nm or lower, and
the organic semiconductor layer includes a compound represented by the following Formula (1) that has a molecular weight of 3000 or lower,

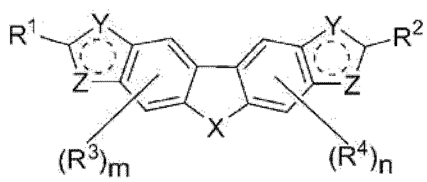

Formula (1)

in Formula (1),

X represents an oxygen atom, a sulfur atom, a selenium atom, a tellurium atom, or $NR^5$,
Y and Z each independently represent $CR^6$, an oxygen atom, a sulfur atom, a selenium atom, a nitrogen atom, or $NR^7$,
a 5-membered ring including Y and Z is an aromatic heterocycle,
$R^1$ and $R^2$ in Formula (1) are bonded to a ring-constituting atom of the 5-membered ring including Y and Z directly or indirectly through a divalent group A,
$R^3$ and $R^4$ in Formula (1) are bonded to a ring-constituting atom of a benzene ring directly or indirectly through the divalent group A,
the divalent group A is a group selected from -O-, -S-, $-NR^8-$, -CO-, -SO-, or $-SO_2-$ or is a group in which two or more selected from -O-, -S-, $-NR^8-$, -CO-, -SO-, or $-SO_2-$ are linked to each other,
$R^1$, $R^2$, $R^5$, $R^6$, $R^7$, and $R^8$ each independently represent a hydrogen atom, an alkyl group, an alkenyl group, an alkynyl group, an aryl group, or a heteroaryl group,
$R^3$ and $R^4$ each independently represent a halogen atom, an alkyl group, an alkenyl group, an alkynyl group, an aryl group, or a heteroaryl group,
m and n each independently represent an integer of 0 to 2, and
a configuration in which X represents an oxygen atom or a sulfur atom and the 5-membered ring including Y and Z is an imidazole ring and a configuration in which X represents a sulfur atom, Y represents CH, Z represents a sulfur atom, both $R^1$ and $R^2$ represent a hydrogen atom, and both m and n represent 0 are excluded from the compound represented by Formula (1).

**2.** The bottom gate type organic semiconductor transistor according to claim 1,
wherein the 5-membered ring including Y and Z is a ring selected from a thiophene ring, a furan ring, a selenophene ring, a pyrrole ring, a thiazole ring, or an oxazole ring.

**3.** The bottom gate type organic semiconductor transistor according to claim 1 or 2,
wherein the number of carbon atoms in each of $R^1$, $R^2$, $R^3$, and $R^4$ is 30 or less.

**4.** The bottom gate type organic semiconductor transistor according to any one of claims 1 to 3,
wherein $R^1$ and $R^2$ each independently represent an alkyl group having 20 or less carbon atoms, an aryl group having 20 or less carbon atoms, or a heteroaryl group having 20 or less carbon atoms.

**5.** The bottom gate type organic semiconductor transistor according to any one of claims 1 to 4,

wherein $R^1$ and $R^2$ are the same as each other,
$R^3$ and $R^4$ are the same as each other, and
m and n are the same as each other.

**6.** The bottom gate type organic semiconductor transistor according to any one of claims 1 to 5,
wherein both m and n represent 0.

**7.** The bottom gate type organic semiconductor transistor according to claim 1,
wherein the compound represented by the following Formula (1) that has a molecular weight of 3000 or lower is represented by the following Formula (2) or (3),

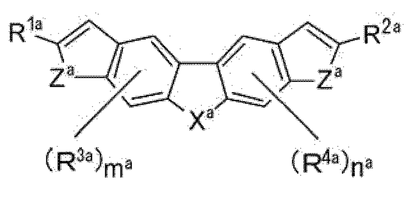

Formula (2)

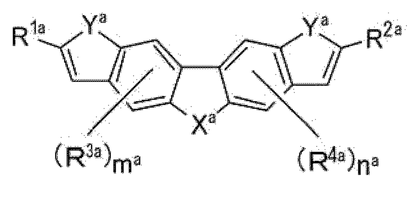

Formula (3)

in Formulae (2) and (3),

$X^a$ represents an oxygen atom, a sulfur atom, or a selenium atom,
$Y^a$ and $Z^a$ each independently represent an oxygen atom, a sulfur atom, a selenium atom, or $NR^{7a}$,
$R^{7a}$ has the same definition as $R^7$ in Formula (1),
$R^{1a}$, $R^{2a}$, $R^{3a}$, $R^{4a}$, $m^a$, and $n^a$ have the same definitions as $R^1$, $R^2$, $R^3$, $R^4$, m, and n in Formula (1), respectively, binding forms of $R^{1a}$, $R^{2a}$, $R^{3a}$, and $R^{4a}$ to a ring-constituting atom are also the same as binding forms of $R^1$, $R^2$, $R^3$, and $R^4$ in Formula (1) to a ring-constituting atom, respectively, and
a configuration in which $X^a$ represents a sulfur atom, $Z^a$ represents a sulfur atom, both $R^{1a}$ and $R^{2a}$ represent a hydrogen atom, and both $m^a$ and $n^a$ represent 0 is excluded from the compound represented by Formula (2).

**8.** The bottom gate type organic semiconductor transistor according to claim 7,
wherein the number of carbon atoms in each of $R^{1a}$, $R^{2a}$, $R^{3a}$, and $R^{4a}$ is 30 or less.

**9.** The bottom gate type organic semiconductor transistor according to claim 7 or 8,
wherein $R^{1a}$ and $R^{2a}$ each independently represent an alkyl group having 20 or less carbon atoms, an aryl group having 20 or less carbon atoms, or a heteroaryl group having 20 or less carbon atoms.

**10.** The bottom gate type organic semiconductor transistor according to any one of claims 7 to 9,

wherein $R^{1a}$ and $R^{2a}$ are the same as each other,
$R^{3a}$ and $R^{4a}$ are the same as each other, and
$m^a$ and $n^a$ are the same as each other.

**11.** The bottom gate type organic semiconductor transistor according to claim 7,

wherein the compound represented by Formula (2) that has a molecular weight of 3000 or lower is represented by the following Formula (4), and
the compound represented by Formula (3) that has a molecular weight of 3000 or lower is represented by the following Formula (5),

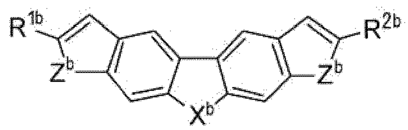

Formula (4)

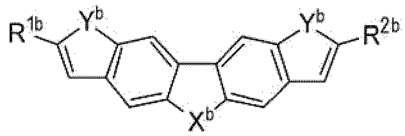

Formula (5)

in Formulae (4) and (5),

$X^b$, $Y^b$, and $Z^b$ each independently represent an oxygen atom, a sulfur atom, or a selenium atom,
$R^{1b}$ and $R^{2b}$ have the same definitions as $R^{1a}$ and $R^{2a}$ in Formula (2), respectively,
binding forms of $R^{1b}$ and $R^{2b}$ to a ring-constituting atom are also the same as binding forms of $R^{1a}$ and $R^{2a}$ in Formula (2) to a ring-constituting atom, respectively, and
a configuration in which $X^b$ represents a sulfur atom, $Z^b$ represents a sulfur atom, and both $R^{1b}$ and $R^{2b}$ represent a hydrogen atom is excluded from the compound represented by Formula (4).

**12.** The bottom gate type organic semiconductor transistor according to claim 11,
wherein the number of carbon atoms in each of $R^{1b}$ and $R^{2b}$ is 30 or less.

**13.** The bottom gate type organic semiconductor transistor according to claim 11 or 12,
wherein $R^{1b}$ and $R^{2b}$ each independently represent an alkyl group having 20 or less carbon atoms, an aryl group having 20 or less carbon atoms, or a heteroaryl group having 20 or less carbon atoms.

**14.** The bottom gate type organic semiconductor transistor according to any one of claims 11 to 13,
wherein $R^{1b}$ and $R^{2b}$ have an aliphatic hydrocarbon group.

**15.** The bottom gate type organic semiconductor transistor according to claim 14, wherein $R^{1b}$ and $R^{2b}$ each independently represent an aryl group having a linear aliphatic hydrocarbon group or a heteroaryl group having a linear aliphatic hydrocarbon group.

**16.** The bottom gate type organic semiconductor transistor according to any one of claims 1 to 15, wherein the gate insulating layer includes an organic component.

**17.** The bottom gate type organic semiconductor transistor according to any one of claims 1 to 16, wherein an elution amount of an organic component having a molecular weight of 1000 or lower in the gate insulating layer is lower than 10 ppm.

FIG. 1

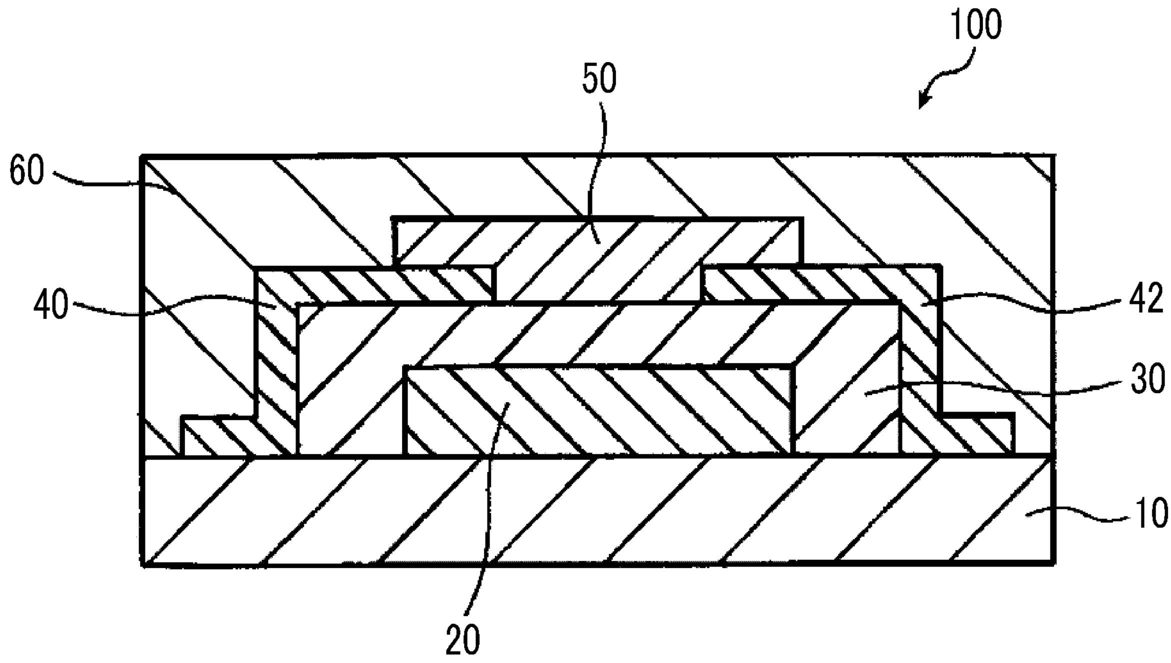


FIG. 2

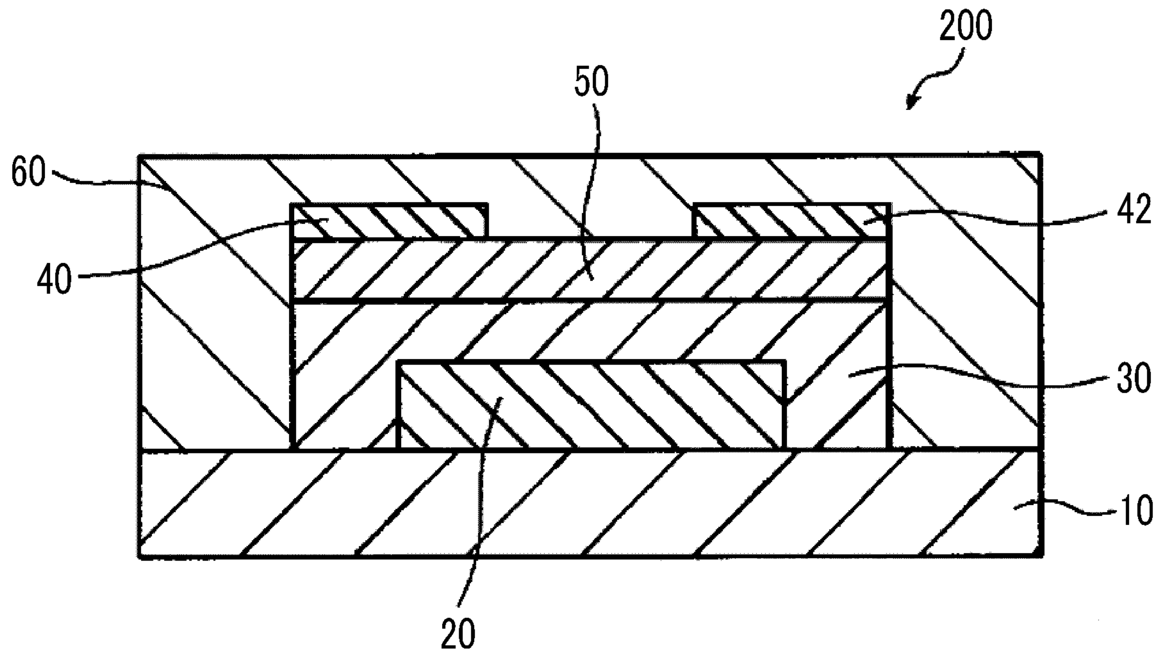

FIG. 3

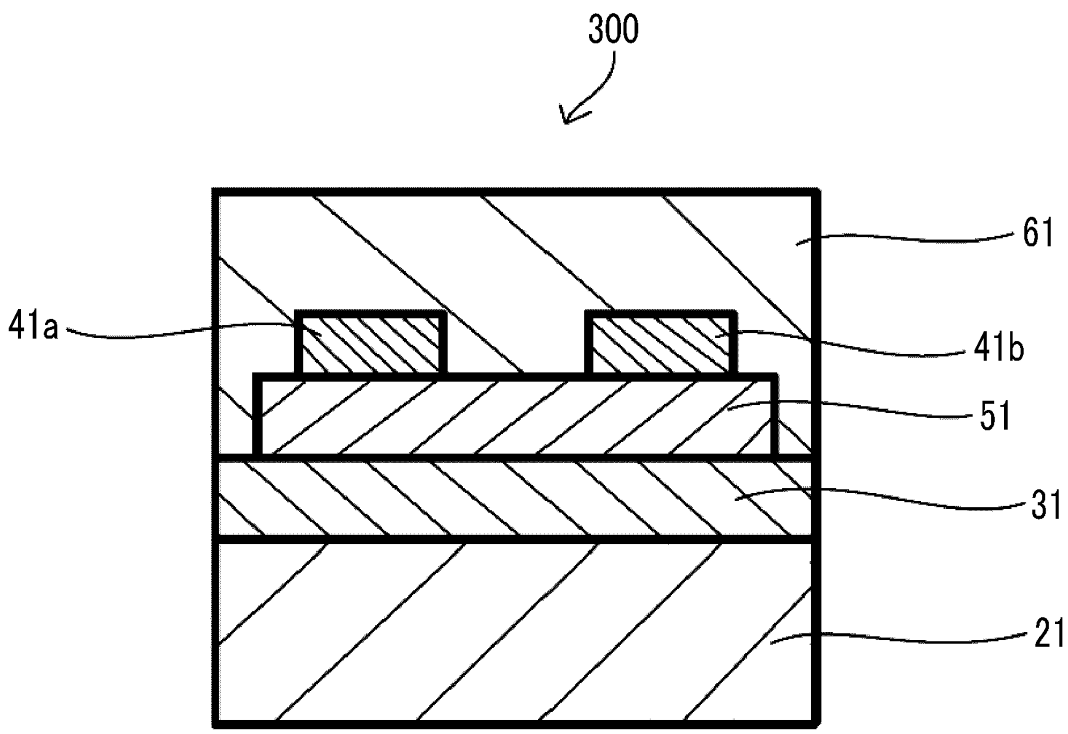


FIG. 4

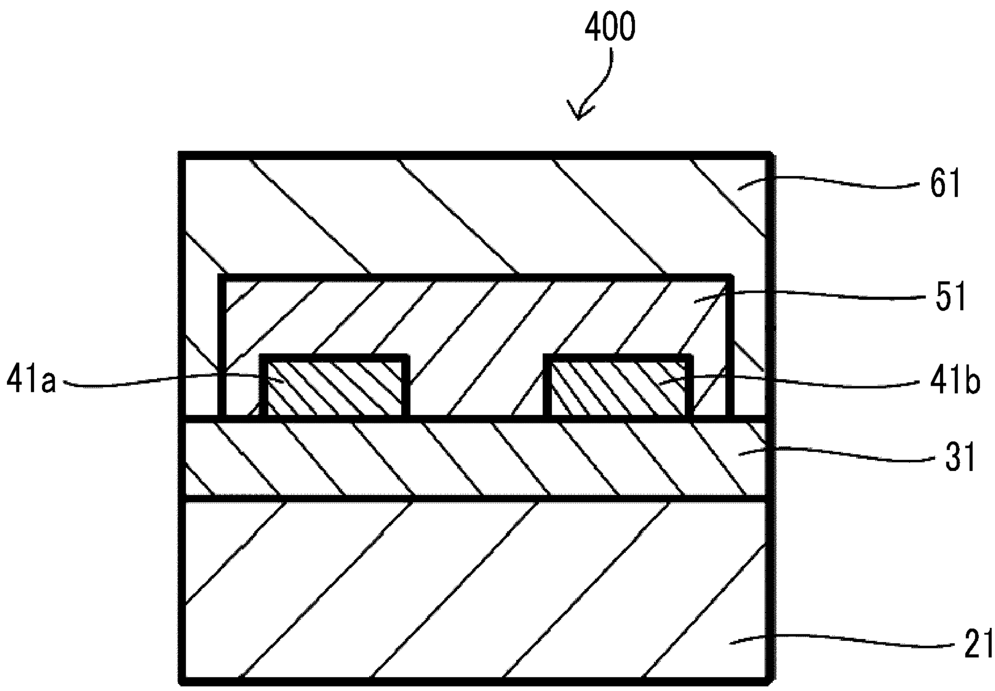

**INTERNATIONAL SEARCH REPORT**

International application No.
PCT/JP2017/033408

A. CLASSIFICATION OF SUBJECT MATTER
*H01L51/30*(2006.01)i, *H01L29/786*(2006.01)i, *H01L51/05*(2006.01)i

According to International Patent Classification (IPC) or to both national classification and IPC

B. FIELDS SEARCHED

Minimum documentation searched (classification system followed by classification symbols)
H01L51/30, H01L29/786, H01L51/05

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2012-129396 A (Ricoh Co., Ltd.), 05 July 2012 (05.07.2012), paragraphs [0012] to [0051]; fig. 1 to 3 (Family: none) | 1-17 |
| Y | JP 2015-195362 A (Fujifilm Corp.), 05 November 2015 (05.11.2015), paragraphs [0014] to [0145] & US 2017/0018724 A1 paragraphs [0126] to [0436] & WO 2015/147129 A1 & EP 3125322 A1 & TW 201542566 A & KR 10-2016-0126040 A & CN 106104833 A | 1-17 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 November 2017 (09.11.17) | 21 November 2017 (21.11.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/033408

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-141203 A (Ricoh Co., Ltd.), 25 June 2009 (25.06.2009), paragraphs [0030] to [0073]; fig. 1 & US 2010/0224865 A1 paragraphs [0039] to [0087]; fig. 1 & WO 2009/072401 A1 & KR 10-2010-0038215 A & CN 101765907 A | 1-17 |
| A | JP 2013-38194 A (Tokyo Electron Ltd.), 21 February 2013 (21.02.2013), paragraphs [0019] to [0051]; fig. 1 to 7 & WO 2013/021760 A1 | 1-17 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2015195361 A
- JP 2015195362 A
- JP 2013214649 A
- JP 2011186069 A
- JP 2010285518 A
- JP 2012163946 A
- JP 2005354012 A
- JP 2006303465 A
- JP 2016191914 A